# EUROPEAN PATENT SPECIFICATION

(11) **EP 0 510 344 B1**
(45) Date of publication and mention of the grant of the patent: **02.02.2000**
(21) Application number: 92104326.1
(22) Date of filing: 12.03.1992
(51) Int. Cl.: H01L 27/11, H01L 21/82

(54) **Semiconductor memory device having thin film transistor and method of producing the same**
Halbleiterspeicheranordnung mit einem Dünnschichttransistor und Herstellungsmethode für selben
Dispositif de mémoire semi-conductrice ayant un transistor à couche mince et procédé de fabrication associé

(30) Priority: 20.03.1991 JP 8042091; 20.03.1991 JP 8042191; 20.03.1991 JP 8042291; 18.06.1991 JP 14594091
(43) Date of publication of application: 28.10.1992
(73) Proprietor: FUJITSU LIMITED, Kawasaki-shi, Kanagawa 211 (JP)
(72) Inventor: Ema, Taiji, c/o Fujitsu Limited, Kawasaki-shi, Kanagawa, 211 (JP); Itabashi, Kazuo, c/o Fujitsu Limited, Kawasaki-shi, Kanagawa, 211 (JP)
(74) Representative: Seeger, Wolfgang, Dipl.-Phys.

(56) References cited:
- US-A- 4 764 801
- US-A- 4 805 147
- US-A- 4 853 894
- INTERNATIONAL ELECTRON DEVICES MEETING December 1988, SAN FRANCISCO, CA, USA pages 48 - 51; T. YAMANAKA ET AL.: 'A 25 um2 NEW POLY-SI PMOS LOAD (PPL) SRAM CELL HAVING EXCELLENT SOFT ERROR IMMUNITY'
- IEEE JOURNAL OF SOLID-STATE CIRCUITS vol. 25, no. 1, February 1990, NEW YORK, USA pages 55 - 60; K. ISHIBASHI ET AL.: 'AN a-IMMUNE, 2-V SUPPLY VOLTAGE SRAM USING A POLYSILICON PMOS LOAD CELL'
- SYMPOSIUM ON VLSI TECHNOLOGY June 1990, HONOLULU, JAPAN pages 19 - 20; A. O. ADAN ET AL.: 'A HALF-MICRON SRAM CELL USING A DOUBLE-GATED SELF-ALIGNED POLYSILICON PMOS THIN FILM TRANSISTOR (TFT) LOAD'

## Description

### BACKGROUND OF THE INVENTION

The present invention generally relates to semiconductor memory devices and methods of producing the same, and more particularly to a thin film transistor (TFT) load type static random access memory (SRAM) and a method of producing such a TFT load type SRAM.

Up to now, the high resistance load type SRAM was popularly used. However, as the integration density improves and the number of memory cells increases, the current consumption increases and various problems are generated. In order to avoid such problems and the help of the progress in the semiconductor technology, the SRAM having the TFT load has been realized. However, new problems are generated due to the use of the TFT load, and it is necessary to eliminate these new problems.

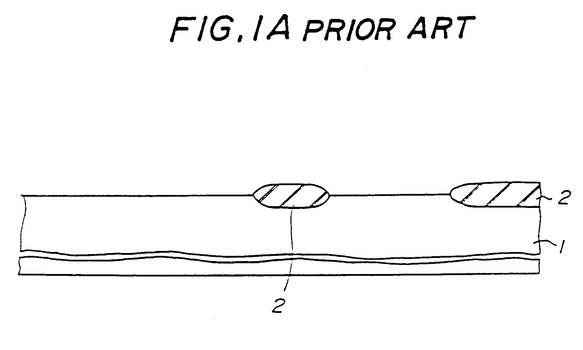

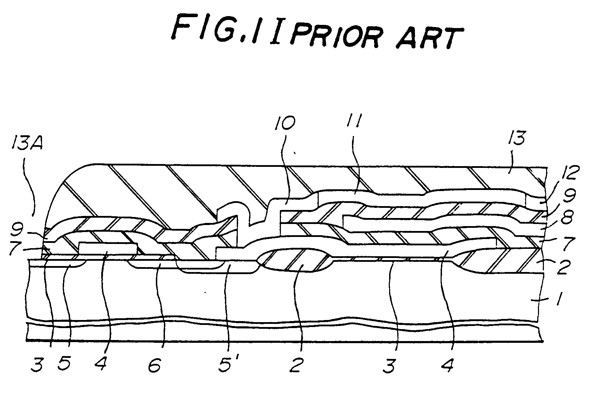

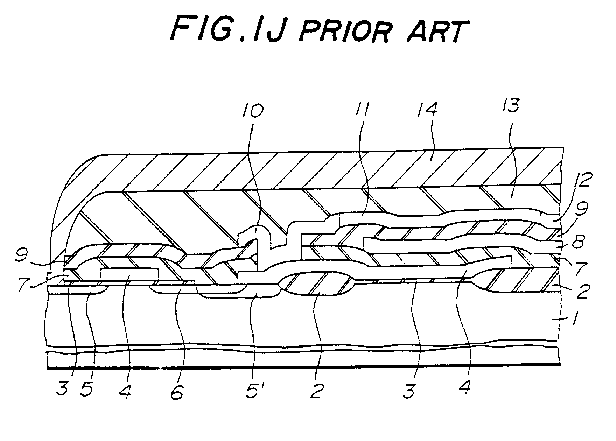

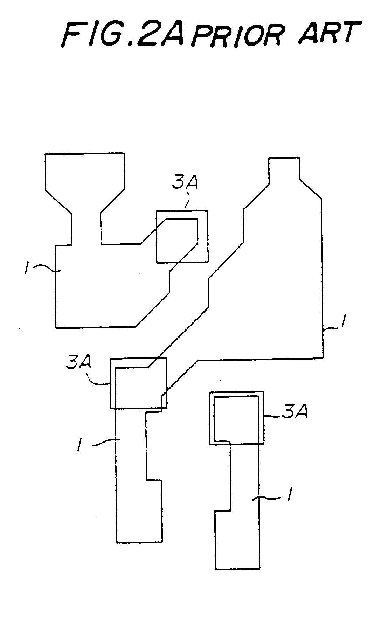

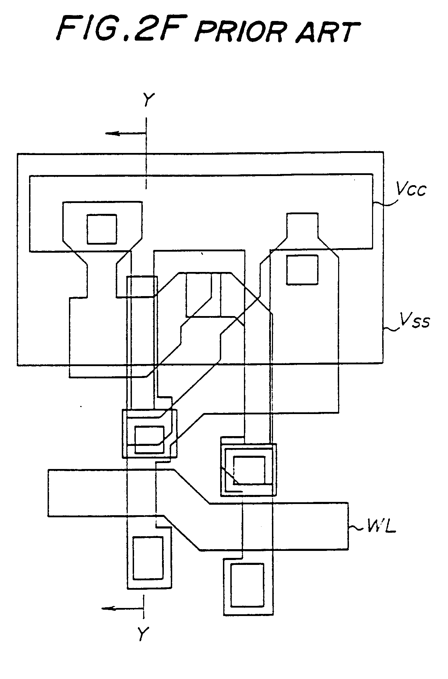

An example of a conventional method of producing the high resistance load type SRAM will be described with reference to FIGS.1A through 1J and FIGS.2A through 2F. FIGS.1A through 1J are side views in cross section showing essential parts of the high resistance load type SRAM at essential stages of the conventional method of producing the high resistance load type SRAM. FIGS.2A through 2F are plan views of the high resistance load type SRAM at essential stages of the conventional method of producing the high resistance load type SRAM. FIGS.1A through 1J respectively are cross sections taken along a line which corresponds to a line Y-Y in the plan view of FIG.2F.

In FIG.1A, a silicon dioxide (SiO₂) layer is used as a pad layer, for example, and a silicon nitride (Si₃N₄) layer which is formed on the SiO₂ layer is used as an oxidation resistant mask layer when carrying out a selective thermal oxidation (for example, a local oxidation of silicon (LOCOS)) so as to form a field insulator layer 2 on a silicon (Si) semiconductor substrate 1. This field insulator layer 2 is made of SiO₂ and has a thickness of 4000 Å, for example.

Then, the Si₃N₄ layer and the SiO₂ layer which are used when carrying out the selective thermal oxidation are removed to expose an active region of the Si semiconductor substrate 1.

In FIG.1B, a thermal oxidation is carried out to form a gate insulator layer 3 which is made of SiO₂ and has a thickness of 100 Å, for example.

By carrying out a resist process of the photolithography technique and a wet etching using hydrofluoric acid as the etchant, the gate insulator layer 3 is selectively etched to form a contact hole 3A.

In FIGS.1C and 2A, a chemical vapor deposition (CVD) is carried out to form a first polysilicon layer having a thickness of 1500 Å, for example.

Then, a vapor phase diffusion is carried out to introduce phosphorus (P) of 1 x 10²⁰ cm⁻³, for example, so as to form an n⁺-type impurity region 5'.

In FIG.2A, the illustration of the first polysilicon layer is omitted for the sake of convenience.

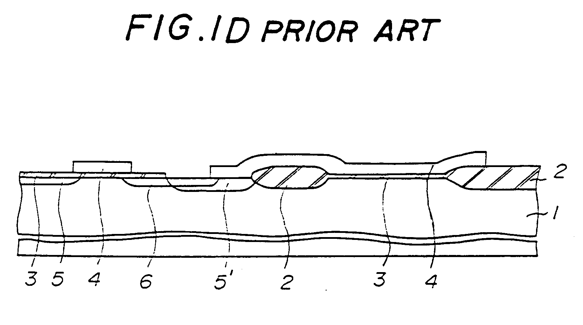

In FIG.1D, a resist process of the photolithography technique and a reactive ion etching (RIE) using CCl₄/O₂ as the etching gas are carried out to pattern the first polysilicon layer and form a gate electrode 4. The gate electrode 4 becomes the gate electrode of a word line and a driver transistor.

An ion implantation is carried out to inject As ions with a dosage of 3 x 10¹⁵ cm⁻² and an acceleration energy of 40 keV, so as to form a source region 5 and a drain region 6.

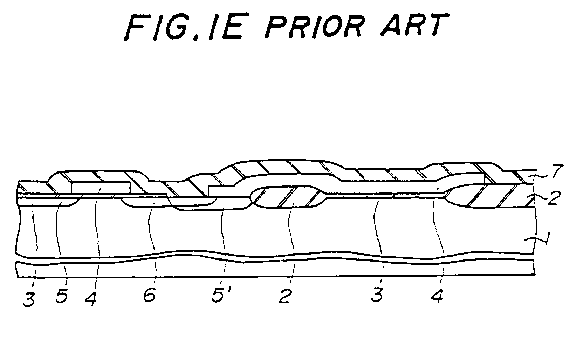

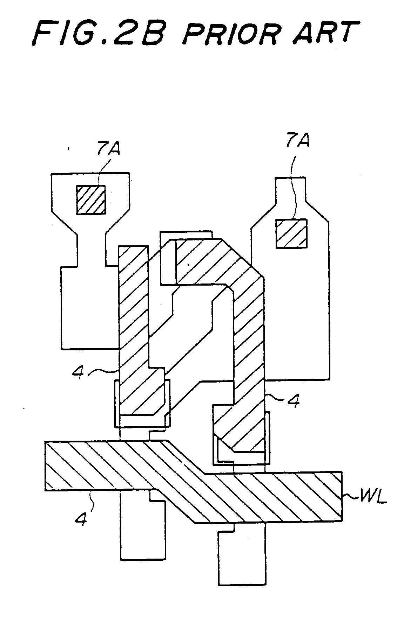

In FIGS.1E and 2B, a CVD is carried out to form an insulator layer 7 which is made of SiO₂ and has a thickness of 1000 Å, for example.

By carrying out a resist process of the photolithography technique and a RIE using CHF₃/He as the etching gas, a ground line contact hole 7A is formed. This ground line contact hole 7A cannot be seen in FIG.1E.

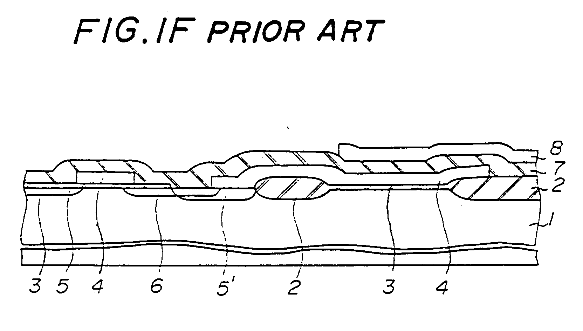

In FIG.1F, a CVD is carried out to form a second polysilicon layer having a thickness of 1500 Å, for example.

Then, an ion implantation is carried out to inject P ions into the second polysilicon layer with a dosage of 4 x 10¹⁵ cm⁻² and an acceleration energy of 30 keV, and an annealing is carried out to reduce the resistance.

A resist process of the photolithography technique and a RIE using CCl₄/O₂ as the etching gas are carried out to pattern the second polysilicon layer and form a ground line 8.

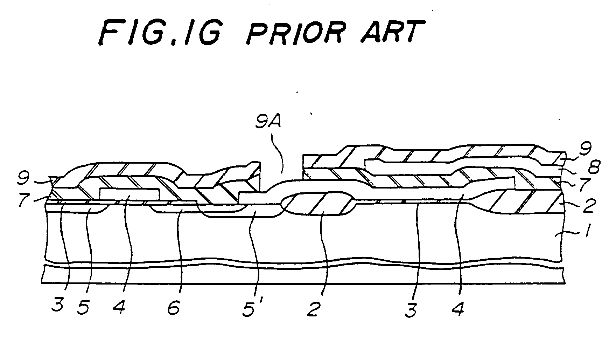

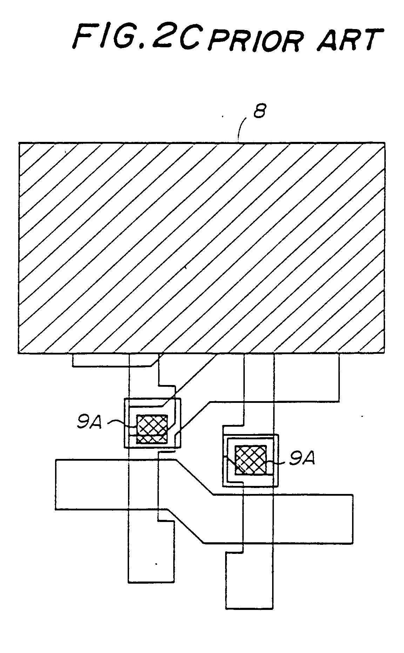

In FIGS.1G and 2C, a CVD is carried out to form an insulator layer 9 which is made of SiO₂ and has a thickness of 1000 Å, for example.

A resist process of the photolithography technique and a RIE using CHF₃/He as the etching gas are carried out to selectively etch the insulator layers 9 and 7 and form a load resistor contact hole 9A.

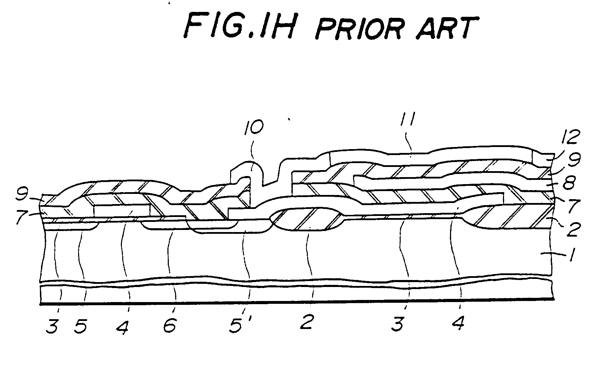

In FIG.1H, a CVD is carried out to form a third polysilicon layer having a thickness of 1500 Å, for example.

A resist process of the photolithography technique and an ion implantation with a dosage of 1 x 10¹⁵ cm⁻² and an acceleration energy of 30 keV are carried out to inject As ions into a part where a supply line of a positive power source voltage Vcc is formed and a part where the high resistance load makes contact with the gate electrode 4.

By carrying out a resist process of the photolithography technique and a RIE using CCl₄/O₂ as the etching gas, the third polysilicon layer is patterned to form a contact part 10, a high resistance load 11 and a Vcc supply line 12.

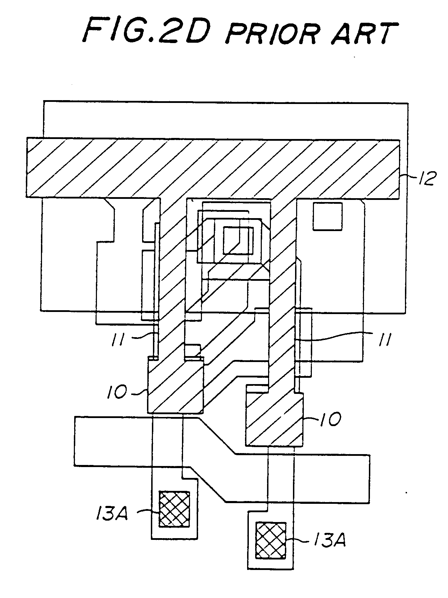

In FIGS.1I and 2D, a CVD is carried out to form an insulator layer which is made of SiO₂ and has a thickness of 1000 Å, for example, and an insulator layer which is made of phosphosilicate glass (PSG) and has a thickness of 5000 Å, for example. In FIG.1I, these insulator layers are referred to as an insulator layer 13.

A thermal process is thereafter carried out to reflow and planarize the insulator layer 13.

Next, a resist process of the photolithography technique and a RIE using CHF₃/He as the etching gas are carried out to selectively etch the insulator layer 13 and the like and to form a bit line contact hole 13A.

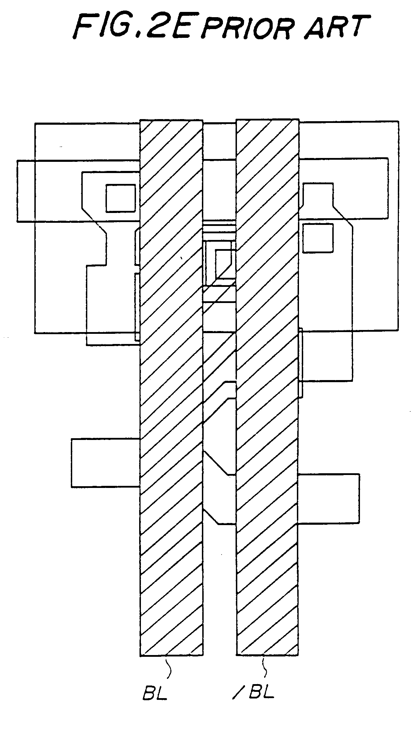

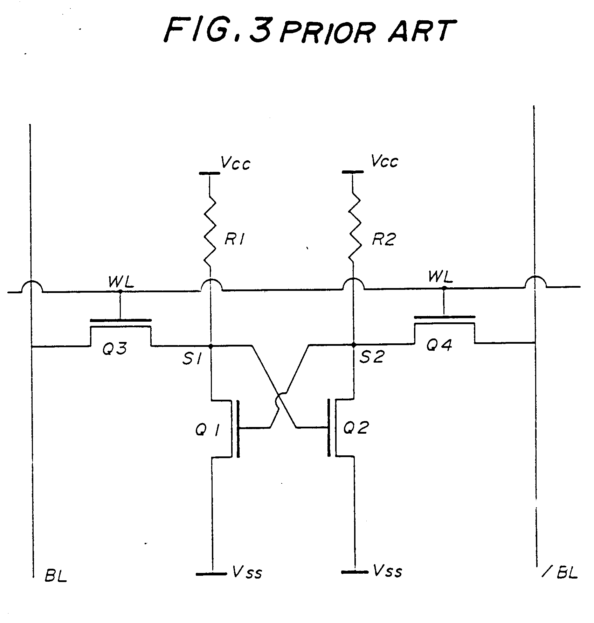

In FIGS.1J and 2E, a sputtering is carried out to form an aluminum (Al) layer having a thickness of 1 µm, for example. This Al layer is patterned using the normal photolithography technique so as to form a bit line 14. Those elements which are shown in FIGS.1J and 2E but not yet described, such as "BL", will be readily understood from the description given later in conjunction with FIG.3.

FIG.2F shows the plan view of the essential part of the high resistance load type SRAM which is completed by the above described processes. In FIG.2F, those parts which are the same as those corresponding parts in FIGS.1A through 1J and FIGS.2A through 2E are designated by the same reference numerals. However, for the sake of convenience, the illustration of the Al bit line 14 shown in FIGS.1J and 2E is omitted in FIG.2F.

FIG.3 shows an equivalent circuit diagram of the essential part of the high resistance load type SRAM described above in conjunction with FIGS.1A through 1J and 2A through 2F.

FIG.3 shows driver transistors Q1 and Q2, transfer gate transistors Q3 and Q4, high resistance loads R1 and R2, a word line WL, bit lines BL and /BL, nodes S1 and S2, the positive power source voltage Vcc, and a negative power source voltage Vss.

The operation of this high resistance load type SRAM, the storage operation in particular, is carried out as follows.

If it is assumed that the positive power source voltage Vcc is 5 V, the negative power source voltage Vss is 0 V, the node S1 is 5 V and the node S2 is 0V, the transistor Q2 is ON and the transistor Q1 is OFF. The potential at the node S1 is maintained to 5 V if the transistor Q1 is OFF and the resistance is sufficiently high compared to the high resistance load R1. The potential at the node S2 is maintained to 0 V if the transistor Q2 is ON and the resistance is sufficiently low compared to the high resistance load R2.

However, under the above described condition, a D.C. current flows from the positive power source voltage Vcc supply line to the negative power source voltage Vss supply line via the node S2, and the current value is inversely proportional to the value of the high resistance load R2.

When the integration density of the above described high resistance load type SRAM increases, the number of memory cells per chip increases and the current consumption of the entire chip would become very large if the current consumption per memory is not reduced. Hence, the D.C. current described above must be reduced, but in order to reduce this D.C. current, the values of the high resistance loads R1 and R2 must be set large. However, when the values of the high resistance loads R1 and R2 are set large, it becomes difficult to stably maintain the potential at the node having the driver transistor which is OFF, that is, the potential at the node S1 in FIG.3.

Because of the above described background, the TFT load type SRAM which uses the TFT as the load in place of the high resistance load has been developed.

Next, a description will be given of the TFT load type SRAM. Similarly to the description given above in respect of the high resistance load type SRAM, a description will first be given of the method of producing the TFT load type SRAM.

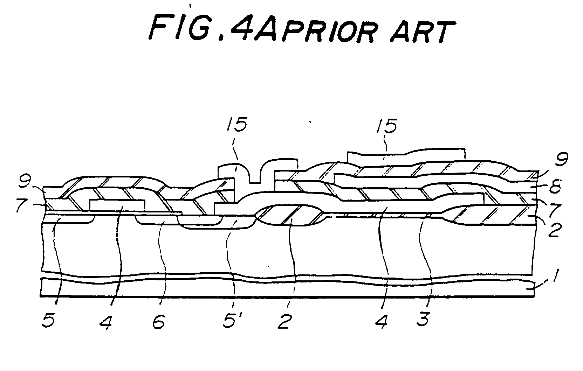

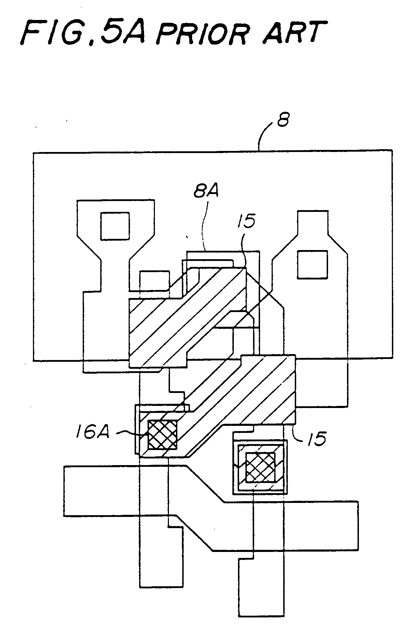

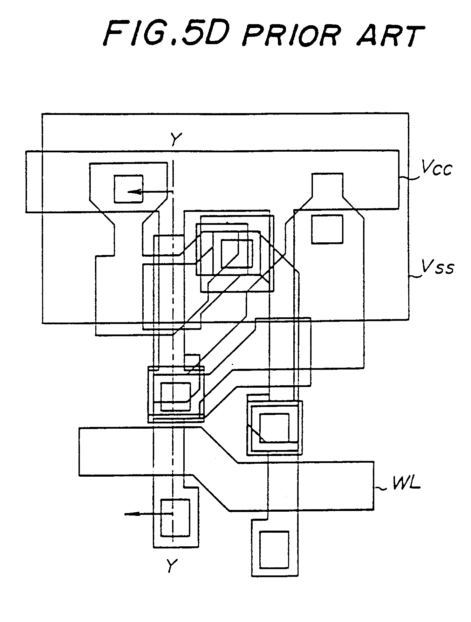

An example of a conventional method of producing the TFT load type SRAM will be described with reference to FIGS.4A through 4D and FIGS.5A through 5D. FIGS.4A through 4D are side views in cross section showing essential parts of the TFT load type SRAM at essential stages of the conventional method of producing the high resistance load type SRAM. FIGS.5A through 5D are plan views of the TFT load type SRAM at essential stages of the conventional method of producing the TFT load type SRAM. FIGS.4A through 4D respectively are cross sections taken along a line which corresponds to a line Y-Y in the plan view of FIG.5D.

The processes of producing the TFT load type SRAM at the beginning are basically the same as the processes described in conjunction with FIGS.1A through 1G up to the process of forming the load resistor contact hole 9A of the high resistance load type SRAM, and a description thereof will be omitted. The only difference is that a contact hole 8A shown in FIG.5A is formed with respect to the ground line 8 which is made of the second polysilicon layer, so that a gate electrode of a TFT which is formed by a third polysilicon layer can make contact with an active region and the gate electrode 4 which is formed by the first polysilicon layer. Hence, a description will only be given from the processes thereafter. In FIGS.4A through 4D and 5A through 5D, those parts which are the same as those corresponding parts in FIGS.1A through 1J and 2A through 2F are designated by the same reference numerals.

In FIGS.4A and 5A, a CVD is carried out to form a third polysilicon layer having a thickness of 1500 Å, for example.

Then, an ion implantation is carried out to inject P ions with a dosage of 4 x 10¹⁵ cm⁻² and an acceleration energy of 30 keV.

Further, a resist process of the photolithography technique and a RIE using CCl₄/O₂ as the etching gas are carried out to pattern the third polysilicon layer and form a gate electrode 15 of the TFT.

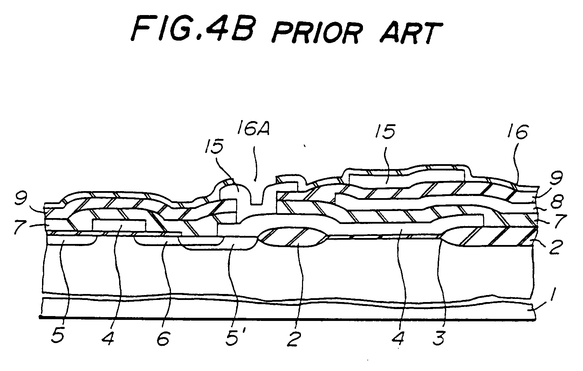

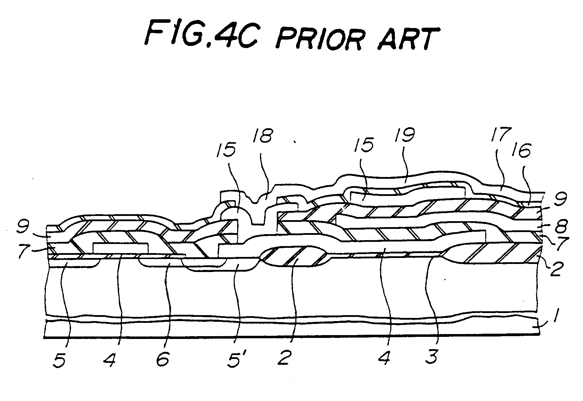

In FIG.4B, a CVD is carried out to form a gate insulator layer 16 of the TFT, which is made of SiO₂ and has a thickness of 300 Å, for example.

A resist process of the photolithography technique and a wet etching using hydrofluoric acid as the etchant are carried out to selectively etch the gate insulator layer 16 and form a drain contact hole 16A.

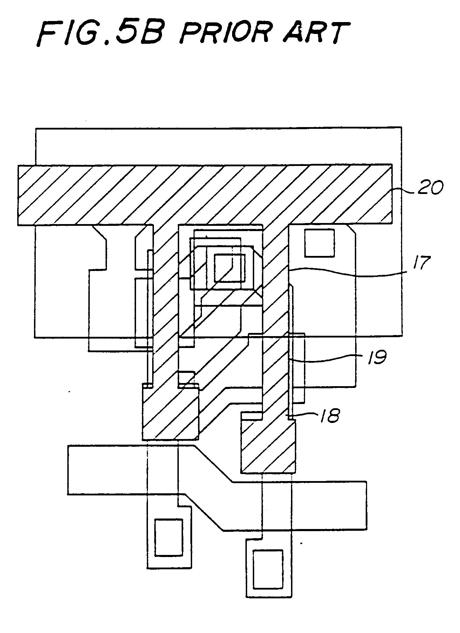

In FIGS.4C and 5B, a CVD is carried out to form a fourth polysilicon layer having a thickness of 500 Å, for example. In addition, a resist process of the photolithography technique and an ion implantation are carried out to inject impurities into the fourth polysilicon layer to form a source and a drain of the TFT.

A resist process of the photolithography technique and a RIE using CCl₄/O₂ as the etching gas are carried out to pattern the fourth polysilicon layer and form a source region 17, a drain region 18 and a channel region 19 of the TFT and also form a Vcc supply line 20.

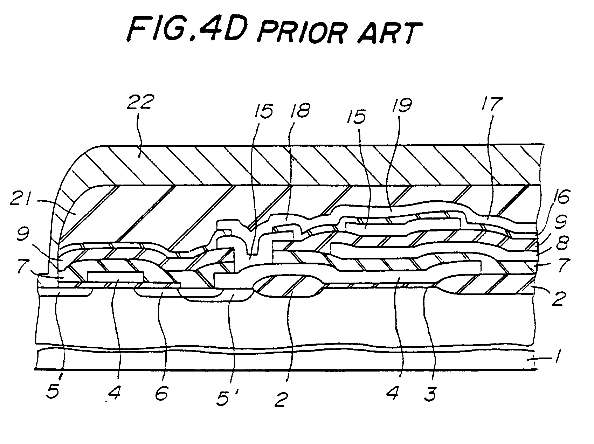

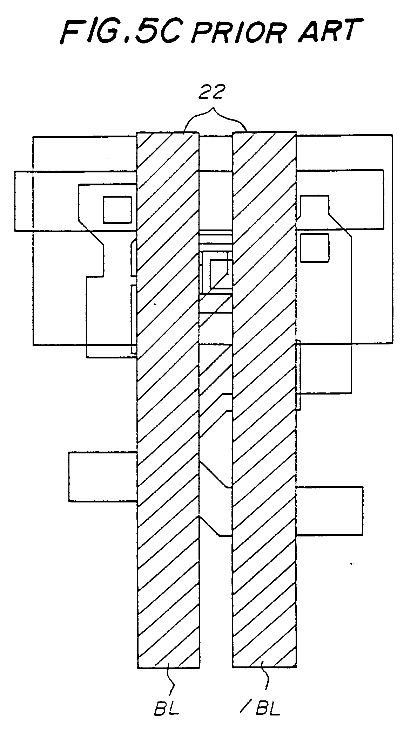

In FIGS.4D and 5C, a CVD is carried out to form an insulator layer made of SiO₂ and having a thickness of 1000 Å, for example, and an insulator layer made of PSG and having a thickness of 5000 Å, for example. In FIG.4D, these two insulator layers are shown as one insulator layer 21, similarly as in the case of FIGS.1I and 1J.

Then, a thermal process is carried out to reflow and planarize the insulator layer 21.

Next, a resist process of the photolithography technique and a RIE using CHF₃/He as the etching gas are carried out to selectively etch the insulator layer 21 and the like and to form a bit line contact hole.

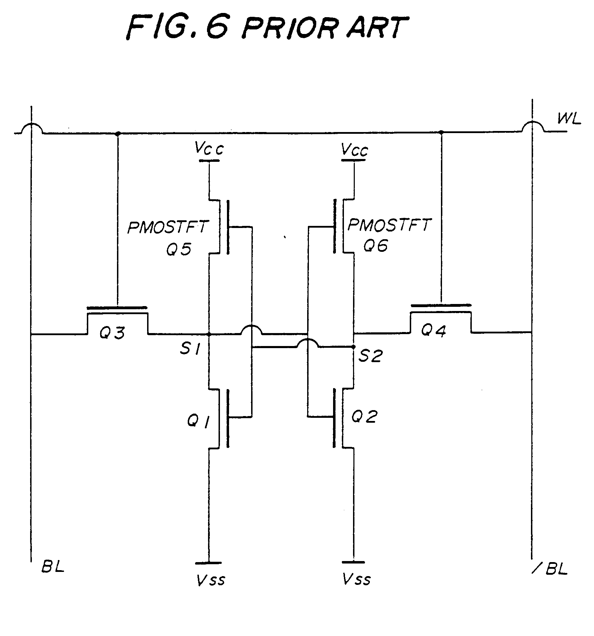

A sputtering is carried out thereafter to form an Al layer having a thickness of 1 µm, for example, and this Al layer is patterned by the normal photolithography technique to form a bit line 22. Those elements which are shown in FIGS.4D and 5C but not yet described, such as "BL", will be readily understood from the description given later in conjunction with FIG.6.

FIG.5D shows the plan view of the essential part of the TFT load type SRAM which is completed by the above described processes. In FIG.5D, those parts which are the same as those corresponding parts in FIGS.4A through 4D and FIGS.5A through 5D are designated by the same reference numerals. However, for the sake of convenience, the illustration of the Al bit line 22 shown in FIGS.4D and 5C is omitted in FIG.5D.

FIG.6 shows an equivalent circuit diagram of an essential part of the TFT load type SRAM described in conjunction with FIGS.4A through 4D and 5A through 5D. In FIG.6, those parts which are the same as those corresponding parts in FIGS.4A through 4D and 5A through 5D are designated by the same reference numerals.

FIG.6 shows transistors Q5 and Q6 which are load TFTs used in place of the high resistance loads R1 and R2 shown in FIG.3.

Next, a description will be given of the operation of the TFT load type SRAM, and the storing operation in particular.

If it is assumed that the positive power source voltage Vcc is 5 V, the negative power source voltage Yss is 0 V, the node S1 is 5 V and the node S2 is 0 V, the transistor Q6 is OFF when the transistor Q2 is ON and the transistor Q5 is ON when the transistor Q1 is OFF. The potential at the node S1 is maintained to 5 V if the transistor Q1 is OFF and the resistance is sufficiently high compared to the transistor Q5 which is ON. The potential at the node S2 is maintained to 0 V if the transistor Q2 is ON and the resistance is sufficiently small compared to the transistor Q6 which is OFF.

Under the above described condition, the resistance of the load transistor Q5 or Q6 changes depending on the stored information, and thus, the problems of the high resistance load type SRAM is eliminated. That is, it is possible to carry out a stable information storage operation. The channels of the transistors Q5 and Q6, that is, the channels of the load TFTs, are made of polysilicon. The crystal state of the polysilicon which forms the channels is considerably poor compared to the single crystal, and a current easily leaks even when the transistor is OFF. Such a leak current increases the current consumption of the chip, and it is desirable to make the channel as small as possible.

On the other hand, as may be readily seen from FIG.4D, the bit line 22 which is made of the Al layer is provided at the top layer of the TFT load type SRAM. In addition, the channel of the load TFT exists immediately under the bit line 22 via the insulator layer 21 which is made of PSG or the like.

But according to this construction, the bit line 22 which is made of the Al layer can be regarded as a gate electrode of a transistor, and the underlying insulator layer 21 can be regarded as a gate insulator layer of this transistor. In addition, the potential of the bit line 22 which is regarded as the gate electrode varies between 0 v (Vss) and 5 V (Vcc). As a result, the TFT which should be OFF, that is, the transistor Q6 becomes nearly ON, and the leak current increases and the parasitic effect becomes notable.

Accordingly, a double gate structure TFT load type SRAM was developed in order to eliminate the above described problems of the TFT load type SRAM.

According to the double gate structure TFT load type SRAM, the above described problems of the TFT load type SRAM are eliminated by interposing the third polysilicon layer of the TFT load type SRAM described in conjunction with FIGS.4 through 6 between the fourth polysilicon layer and the bit line 22 which is made of Al. Particularly, a fifth polysilicon layer forming a second gate electrode which has the same pattern as the gate electrode 15 of the TFT is interposed between the Al bit line 22 and the fourth polysilicon layer which forms the source region 17, the drain region 18, the channel region 19, the Vcc supply line 20 and the like.

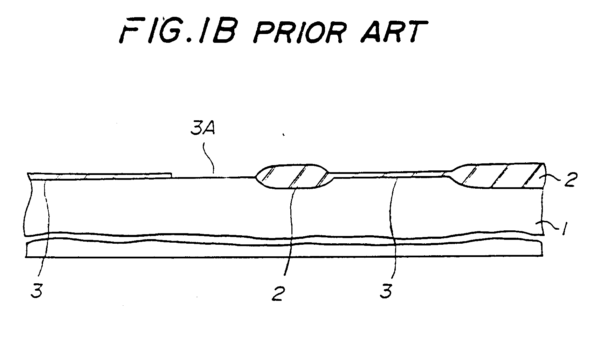

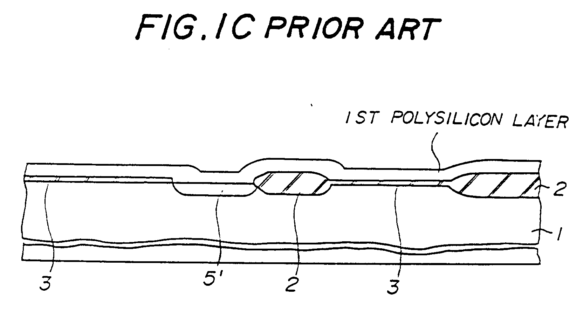

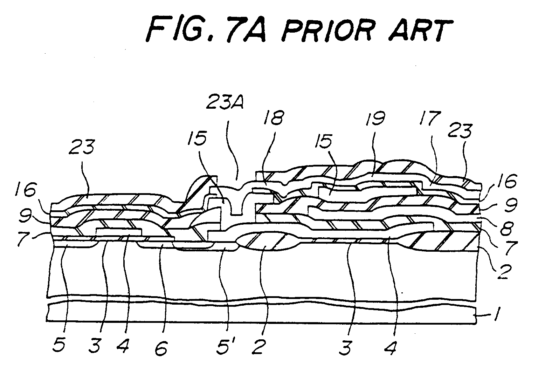

FIGS.7A through 7C are side views in cross section showing essential parts of the double gate structure TFT load type SRAM at essential stages of the conventional method of producing the double gate structure TFT load type SRAM. The processes of producing the double gate structure TFT load type SRAM at the beginning are basically the same as the processes described in conjunction with FIGS.4A through 4C up to the process of forming the source region 17, the drain region 18, the channel region 19 and the Vcc supply line 20 of the TFT load type SRAM, and a description thereof will be omitted. Hence, a description will only be given from the processes thereafter. In FIGS.7A through 7C, those parts which are the same as those corresponding parts in FIGS.1 through 6 are designated by the same reference numerals.

In FIG.7A, a CVD is carried out to form an insulator layer 23 which is made of SiO₂ and has a thickness of 500 Å, for example.

A resist process of the photolithography technique and a RIE using CHF₃+He as the etching gas are carried out to selectively etch the insulator layer 23 and to form a contact hole 23A with respect to the drain electrode 18 of the TFT.

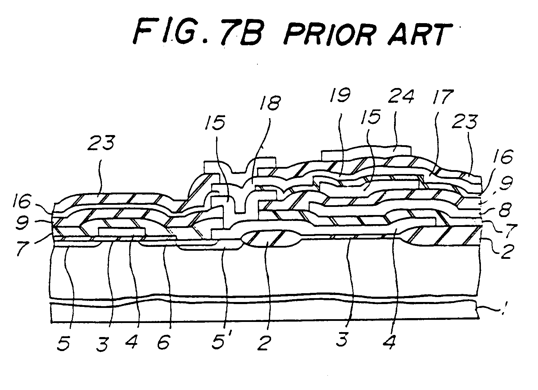

In FIG.7B, a CVD is carried out to form a fifth polysilicon layer having a thickness of 1000 Å, for example.

Then, an ion implantation is carried out to inject P ions into the fifth polysilicon layer with a dosage of 4 x 10¹⁵ cm⁻², for example.

A resist process of the photolithography technique and a RIE using CCl₄/O₂ as the etching gas are carried out to pattern the fifth polysilicon layer and to form a second gate electrode 24 of the TFT.

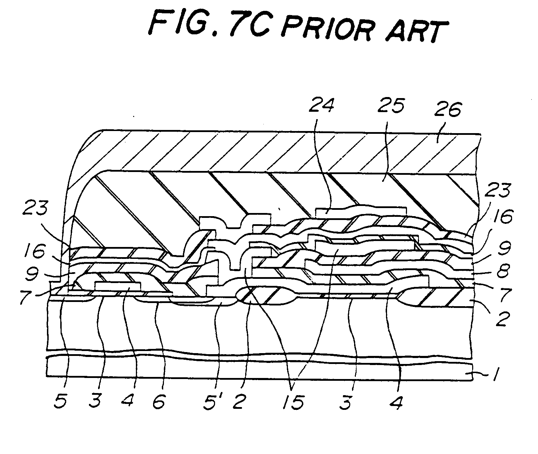

In FIG.7C, a CVD is carried out to form an insulator layer which is made of SiO₂ and has a thickness of 1000 Å, for example, and an insulator layer which is made of PSG and has a thickness of 5000 Å, for example. As in the case shown in FIG.4D, these two insulator layers are shown as one insulator layer 25 in FIG.7C.

Thereafter, a thermal process is carried out to reflow and planarize the insulator layer 25.

Next, a resist process of the photolithography technique and a RIE using CHF₃/He as the etching gas are carried out to selectively etch the insulator layer 25 and the like, and to form a bit line contact hole.

In addition, a sputtering is carried out to form an Al layer having a thickness of 1 µm, for example, and this Al layer is patterned by the normal photolithography technique so as to form a bit line 26.

As described heretofore, the SRAM started from the high resistance load type, evolved to the TFT load type, and further evolved to the double gate structure TFT load type. However, as may be seen by comparing FIGS.1A through 1J with FIGS.7A through 7C, and FIGS.1J and 7C in particular, the number of polysilicon layers has increased by two from the high resistance load type SRAM to the double gate structure TFT load type SRAM, and the number of mask processes have increased by four.

In not only the SRAMs described above but for the semiconductor memory devices in general, the highest proposition is to improve the integration density. The SRAMs which have been proposed recently have an even larger integration density compared to those of the existing SRAMs, and this tendency of further increased integration density has introduced new problems.

Generally, the SRAM also requires a memory capacitor, as is well known. Normally, a node between the driver transistor and the load and the stray capacitance in the vicinity of this node are used as the memory capacitor. Accordingly, the capacitance of the memory capacitor is smallest for the high resistance load type SRAM, slightly larger for the TFT load type SRAM, and largest for the double gate structure TFT load

type SRAM. However, even in the case of the double gate structure TFT load type SRAM, the capacitance of the memory capacitor becomes insufficient as the integration density further increases.

Therefore, instead of relying on the stray capacitance, it becomes necessary to intentionally and independently for the memory capacitance. But the number of mask processes is already relatively large as described above. For this reason, it is essential to minimize the number of processes required to form the memory capacitor.

US-A-4 805 147 discloses an SRAM cell having high resistivity loads. IEEE J. Solid-State Circuits, vol 25, no 1, Feb. 1990, pp 55 to 60 discloses that TFT loads as such are known.

### SUMMARY OF THE INVENTION

Accordingly, it is a general object of the present invention to provide a novel and useful thin film transistor (TFT) load type static random access memory (SRAM) in which the problems described above are eliminated.

This object is achieved by the features of claim 1.

A method to produce a semiconductor according to the present invention is achieved by the features of claim 16.

Further features and advantages are disclosed in the dependent claims.

### BRIEF DESCRIPTION OF THE DRAWINGS

FIGS.1A through 1J are side views in cross section showing essential parts of a high resistance load type SRAM at essential stages of a conventional method of producing the high resistance load type SRAM;
FIGS.2A through 2F are plan views of the high resistance load type SRAM at essential stages of the conventional method of producing the high resistance load type SRAM;
FIG.3 shows an equivalent circuit diagram of the essential part of the high resistance load type SRAM described in conjunction with FIGS.1A through 1J and 2A through 2F;
FIGS.4A through 4D are side views in cross section showing essential parts of a TFT load type SRAM at essential stages of a conventional method of producing the high resistance load type SRAM;
FIGS.5A through 5D are plan views of the TFT load type SRAM at essential stages of the conventional method of producing the TFT load type SRAM;
FIG.6 shows an equivalent circuit diagram of an essential part of the TFT load type SRAM described in conjunction with FIGS.4A through 4D and 5A through 5D;
FIGS.7A through 7C are side views in cross section showing essential parts of a double gate structure TFT load type SRAM at essential stages of a conventional method of producing the double gate structure TFT load type SRAM;

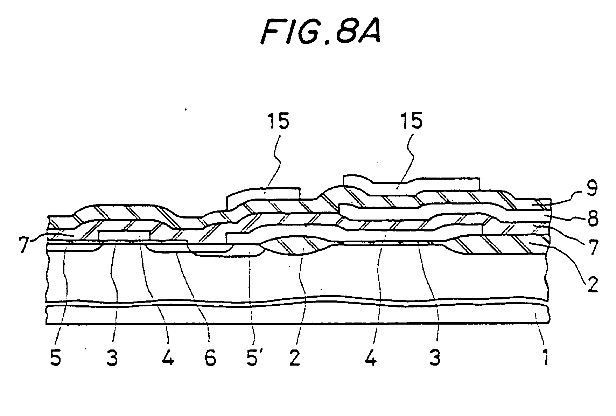

FIGS.8A through 8F are side views in cross section showing an essential part of a first embodiment of a semiconductor memory device according to the present invention at essential stages of a first embodiment of a method of producing the semiconductor memory device according to the present invention;

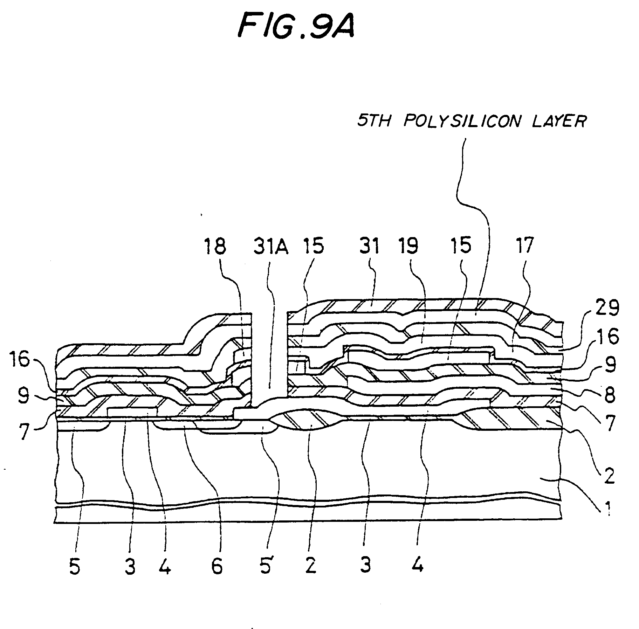

FIGS.9A through 9E are side views in cross section showing an essential part of a second embodiment of the semiconductor memory device according to the present invention at essential stages of a second embodiment of the method of producing the semiconductor memory device according to the present invention;

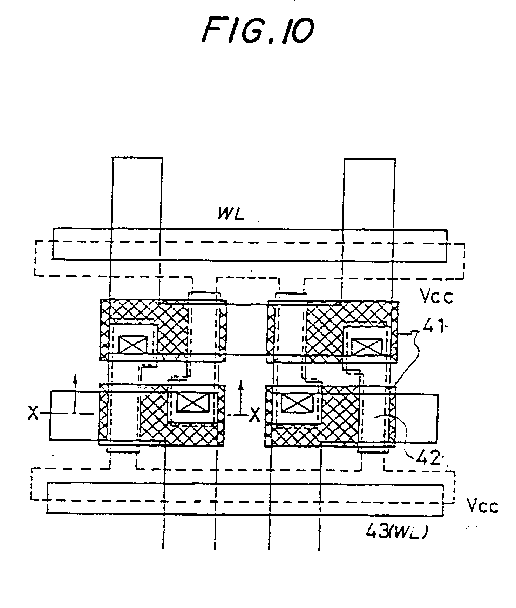

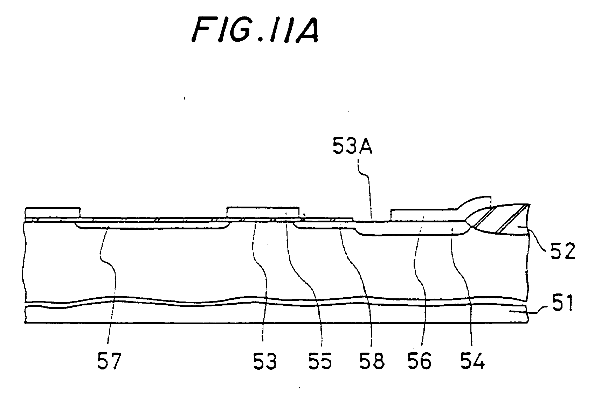

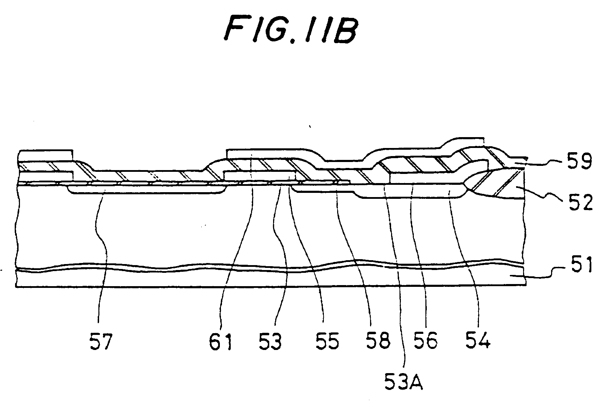

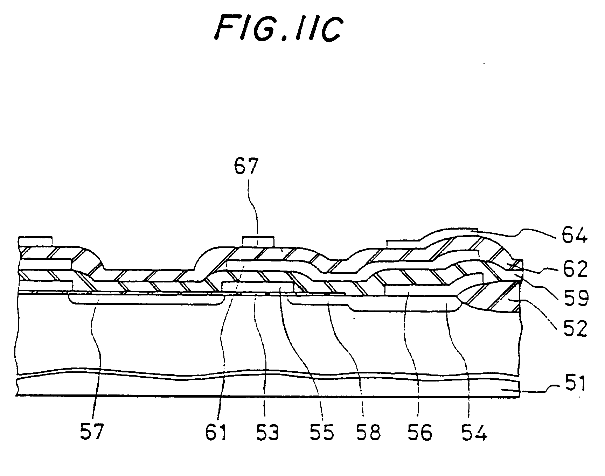

FIG.10 is a plan view generally showing an essential part of a TFT load type SRAM;

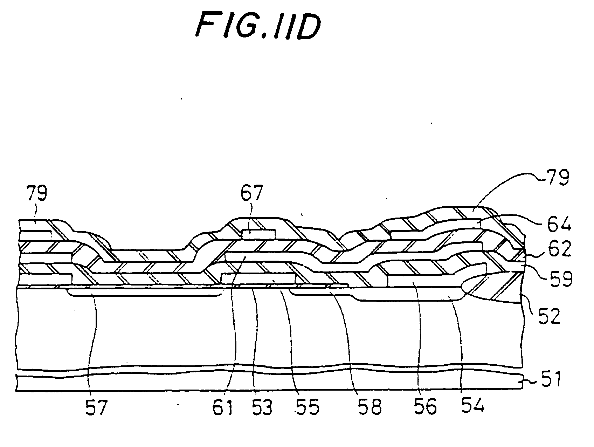

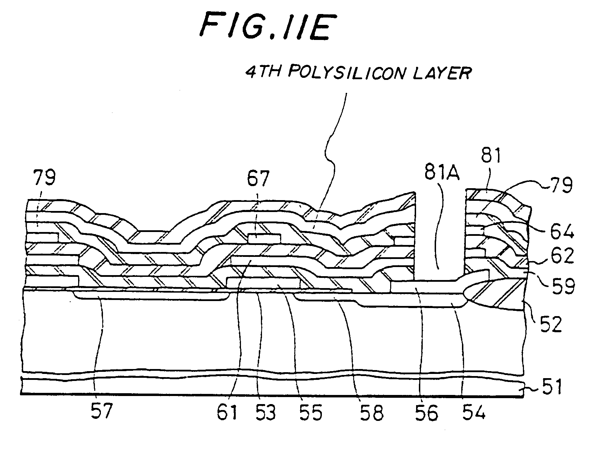

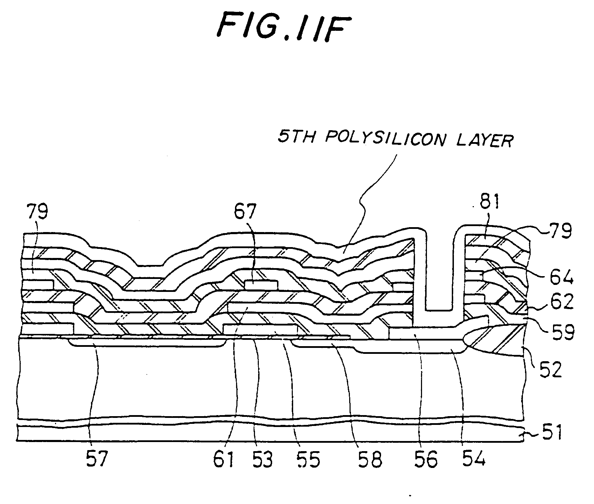

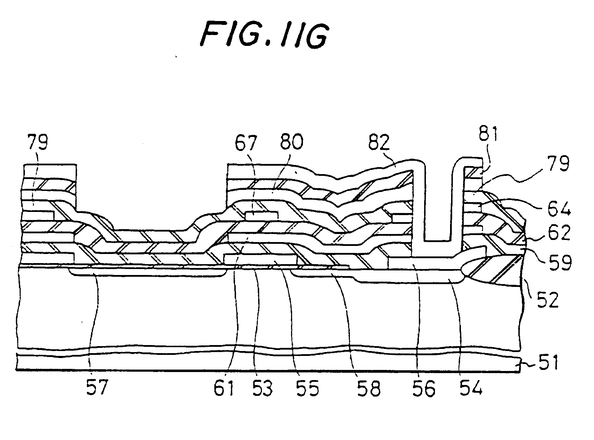

FIGS.11A through 11J are side views in cross section showing an essential part of a third embodiment of the semiconductor memory device according to the present invention at essential stages of a third embodiment of the method of producing the semiconductor memory device according to the present invention;

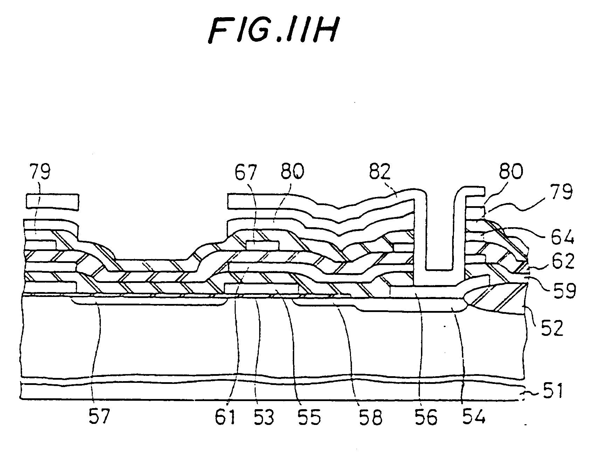

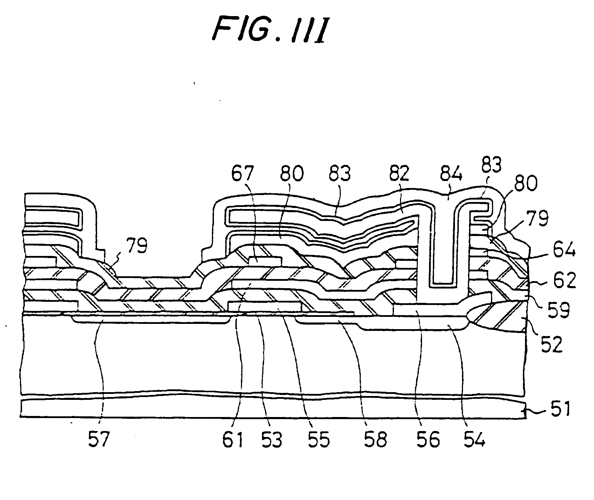

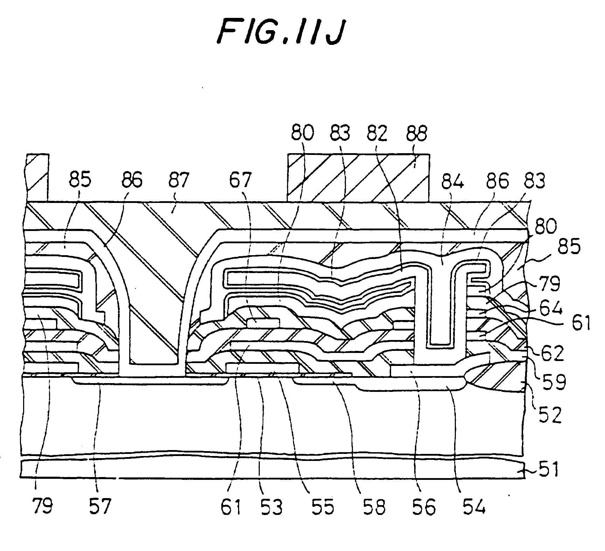

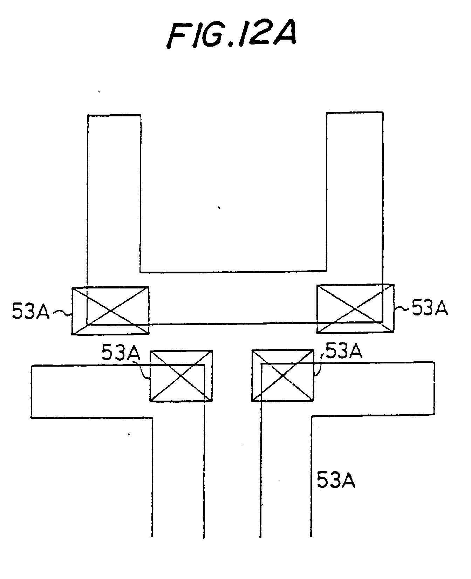

FIGS.12A through 12G are plan views of the semiconductor memory device at essential stages of the third embodiment of the method shown in FIGS.11A through 11J;

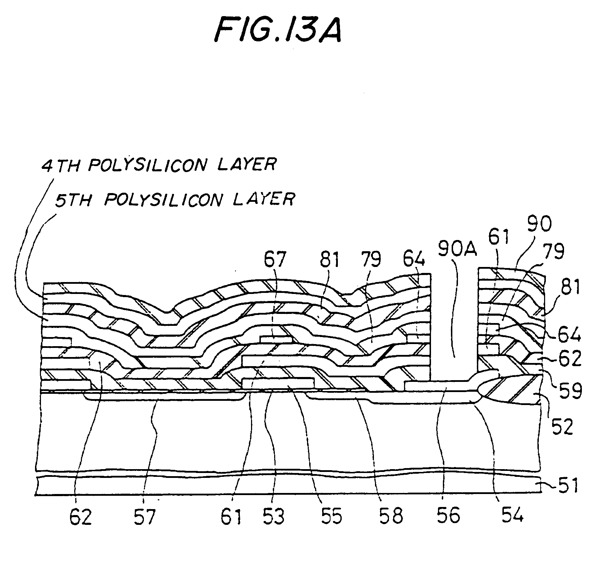

FIGS.13A through 13C are side views in cross section showing an essential part of a fourth embodiment of the semiconductor memory device according to the present invention at essential stages of a fourth embodiment of the method of producing the semiconductor memory device according to the present invention;

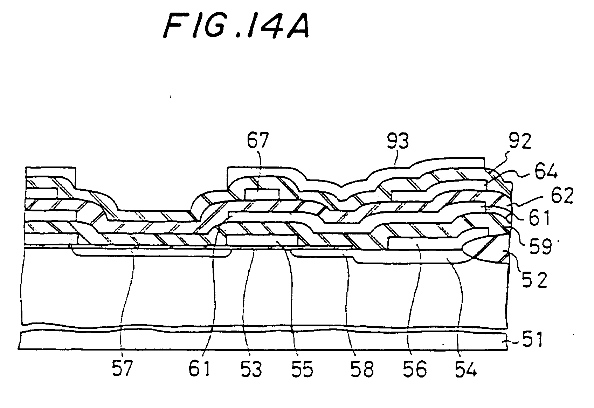

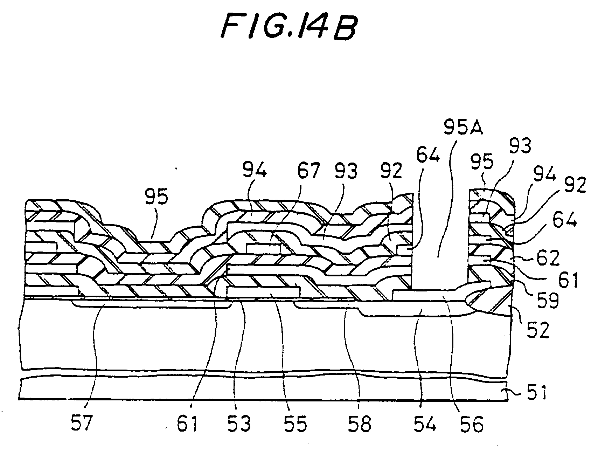

FIGS.14A through 14D are side views in cross section showing an essential part of a fifth embodiment of the semiconductor memory device according to the present invention at essential stages of a fifth embodiment of the method of producing the semiconductor memory device according to the present invention;

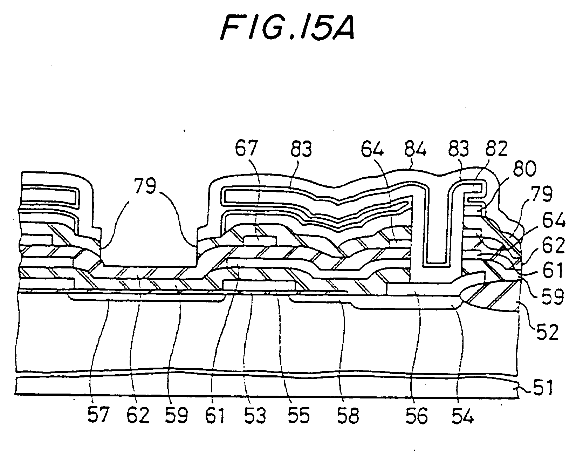

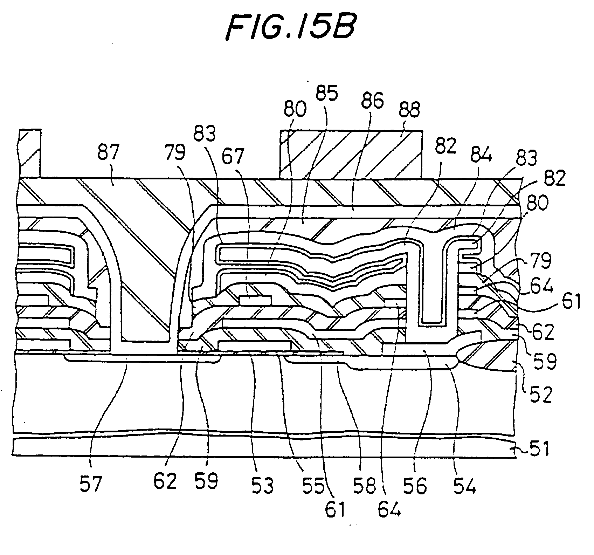

FIGS.15A and 15B are side views in cross section showing an essential part of a sixth embodiment of the semiconductor memory device according to the present invention at essential stages of a sixth embodiment of the method of producing the semiconductor memory device according to the present invention;

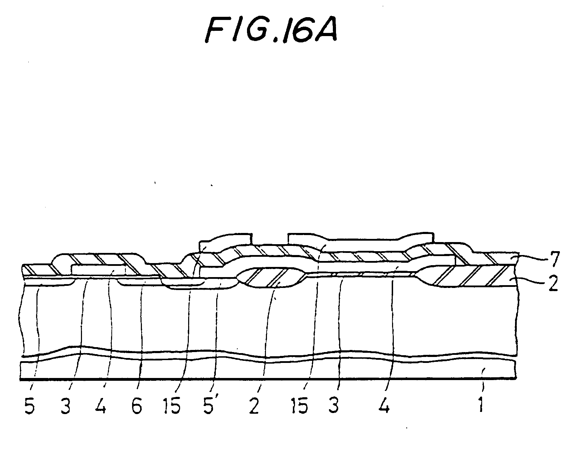

FIGS.16A through 16H are side views in cross section showing an essential part of a seventh embodiment of the semiconductor memory device according to the present invention at essential stages of a seventh embodiment of the method of producing the semiconductor memory device according to the present invention;

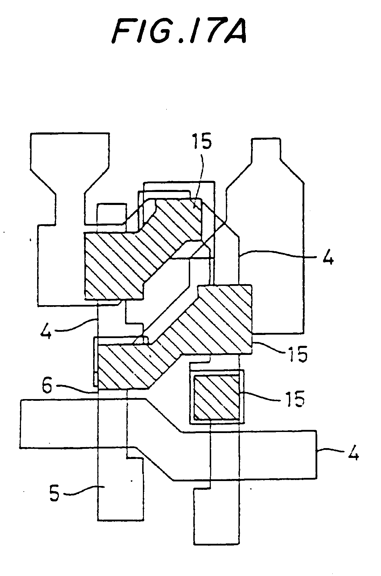

FIGS.17A through 17F are plan views of the semiconductor memory device at essential stages of the seventh embodiment of the method shown in FIGS.16A through 16H;

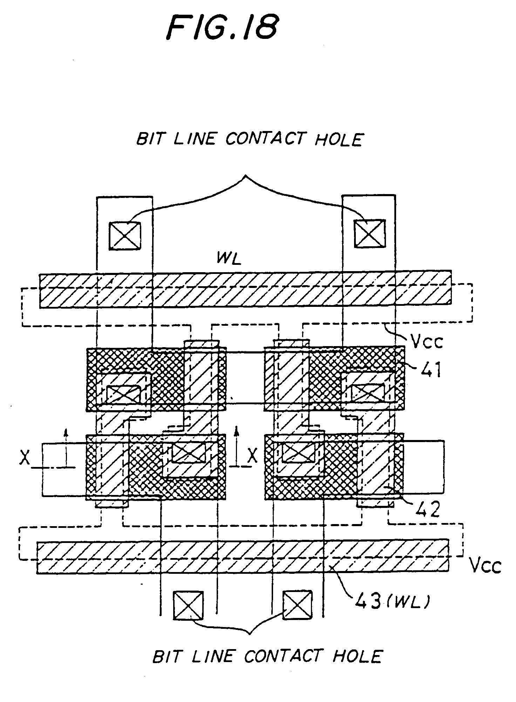

FIG.18 is a plan view generally showing an essential part of a TFT load type SRAM;

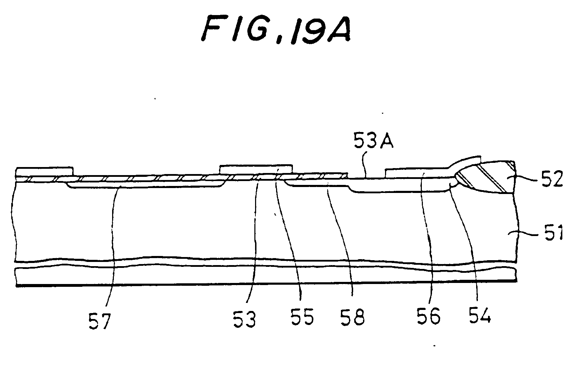

FIGS.19A through 19J are side views in cross section showing an essential part of an eighth embodiment of the semiconductor memory device according to the present invention at essential stages of an eighth embodiment of the method of producing the semiconductor memory device according to the present invention;

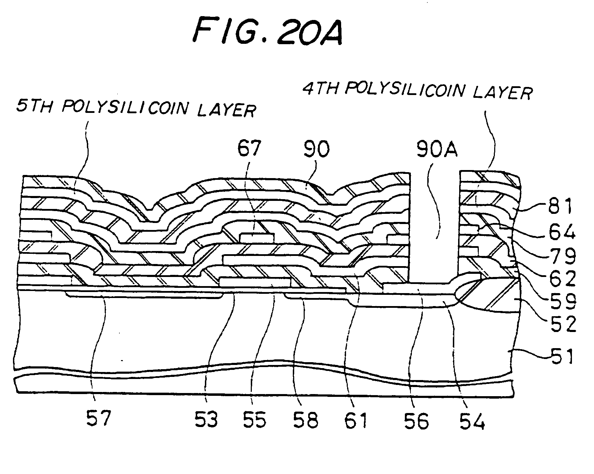

FIGS.20A through 20C are side views in cross section showing an essential part of a ninth embodiment of the semiconductor memory device according to the present invention at essential stages of a ninth embodiment of the method of producing the semiconductor memory device according to the present invention;

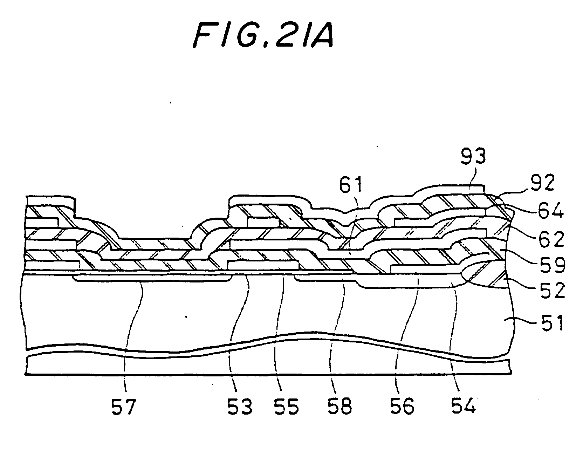

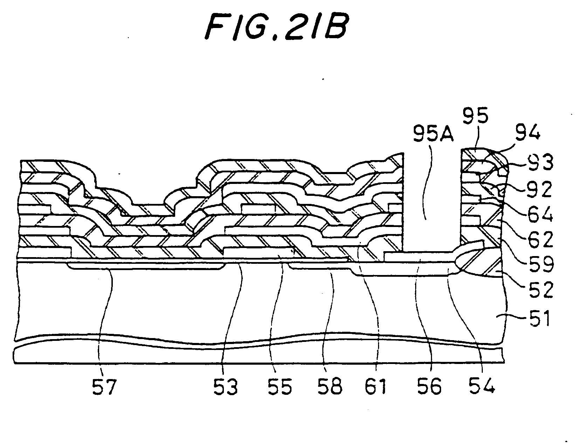

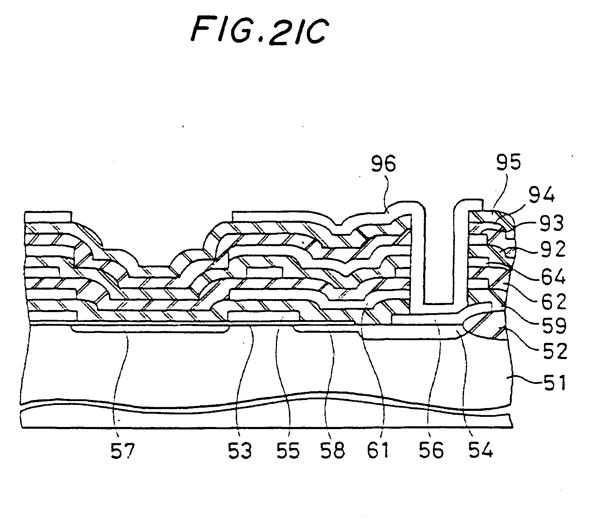

FIGS.21A through 21D are side views in cross section showing an essential part of a tenth embodiment of the semiconductor memory device according to the present invention at essential stages of a tenth embodiment of the method of producing the semiconductor memory device according to the present invention;

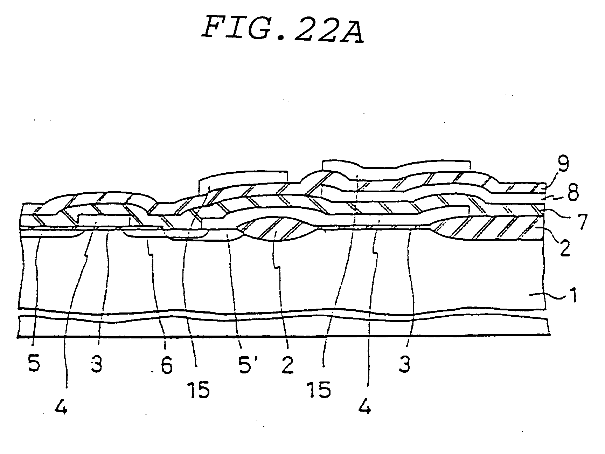

FIGS.22A through 22G are side views in cross section showing an essential part of a twelfth embodiment of the semiconductor memory device according to the present invention at essential stages of a twelfth embodiment of the method of producing the semiconductor memory device according to the present invention;

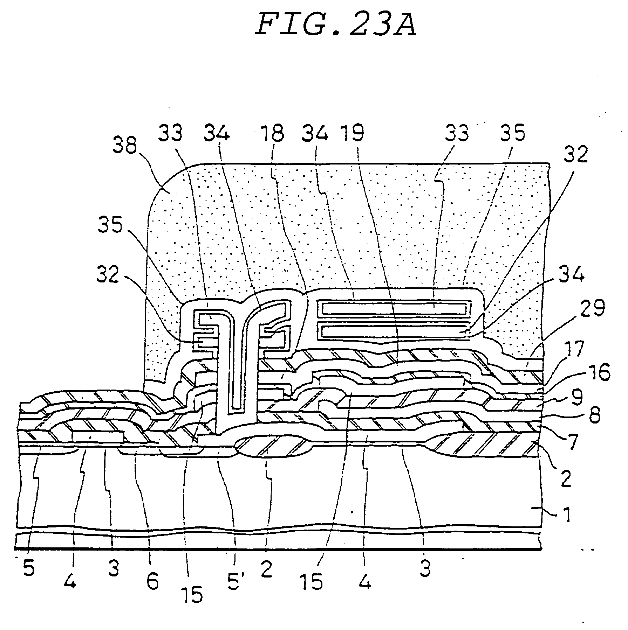

FIGS.23A through 23C are side views in cross section showing an essential part of a thirteenth embodiment of the semiconductor memory device according to the present invention at essential stages of a thirteenth embodiment of the method of producing the semiconductor memory device according to the present invention;

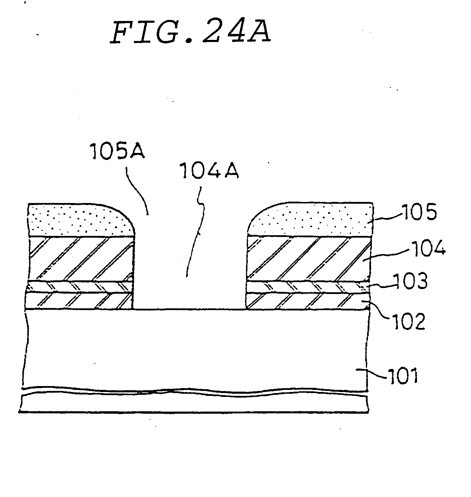

FIGS.24A through 24D are side views in cross section showing an essential part of the thirteenth embodiment of the semiconductor memory device according to the present invention at essential stages of the production thereof, for explaining the effects of the thirteenth embodiment;

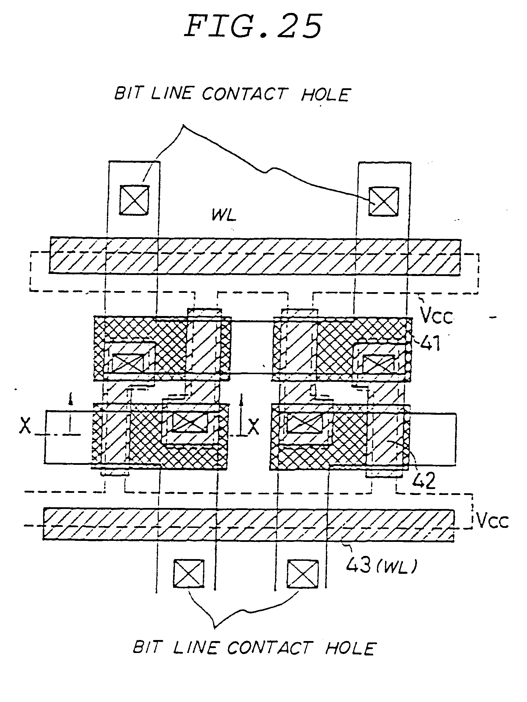

FIG.25 is a plan view generally showing an essential part of a TFT load type SRAM;

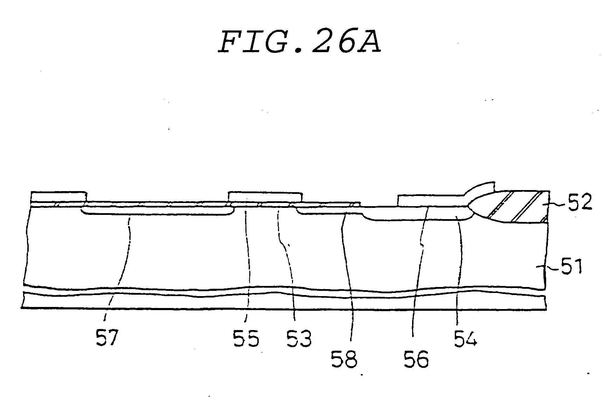

FIGS.26A through 26J are side views in cross section showing an essential part of a fourteenth embodiment of the semiconductor memory device according to the present invention at essential stages of a fourteenth embodiment of the method of producing the semiconductor memory device according to the present invention;

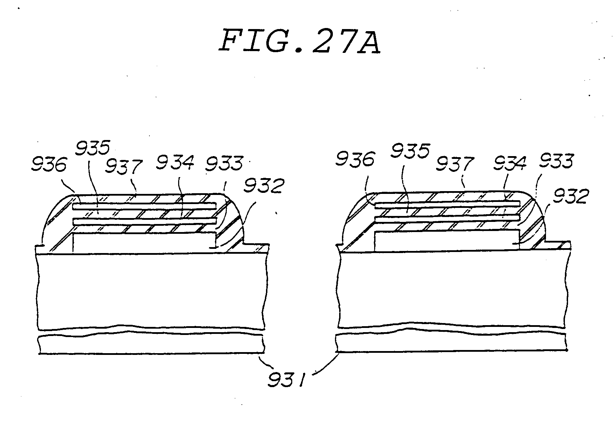

FIGS.27A through 27F are side views in cross section showing essential parts of a semiconductor memory device at essential stages of the production, for explaining the process of forming a contact hole which penetrates a stacked structure;

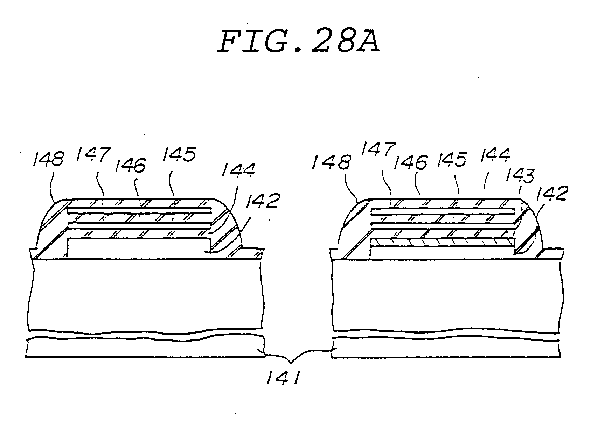

FIGS.28A through 28F are side views in cross section showing an essential part of a fifteenth embodiment of the semiconductor memory device according to the present invention at essential stages of a fifteenth embodiment of the method of producing the semiconductor memory device according to the present invention, for explaining the operating principle of the fifteenth embodiment.

### DESCRIPTION OF THE PREFERRED EMBODIMENTS

First, a description will be given of a first embodiment of a semiconductor memory device according to the present invention which is produced by a first embodiment of a method of producing the semiconductor memory device according to the present invention. FIGS.8A through 8F are side views in cross section showing an essential part of the first embodiment of the semiconductor memory device according to the present invention at essential stages of the first embodiment of the method of producing the semiconductor memory device according to the present invention. In FIGS.8A through 8F, those parts which are the same as those corresponding parts in FIGS.1A through 1J are designated by the same reference numerals.

In this embodiment of the method, the processes are the same as those of the prior art up to the processes shown in FIGS.1A through 1F, that is, until the ground line 8 is formed from the second polysilicon layer. Hence, a description will only be given of the processes carried out thereafter.

In FIG.8A, the double gate structure TFT load type SRAM already has on the Si semiconductor substrate 1 the field insulator layer 2, the gate insulator layer 3, the gate electrode 4 of the driver transistor formed from the first polysilicon layer, the n⁺-type impurity region 5', the n⁺-type source region 5, the n⁺-type drain region 6, the insulator layer 7, and the ground line 8 formed from the second polysilicon layer.

A CVD is carried out to form on the entire surface an insulator layer 9 which is made of SiO₂ and has a thickness of 1000 Å (10Å = 1nm), for example.

Then, a CVD is carried out to form a third polysilicon layer having a thickness of 500 Å, for example.

An ion implantation is carried out to inject P ions into the third polysilicon layer with a dosage of 1 x 10¹⁵ cm⁻² and an acceleration energy of 10 keV.

In addition, a resist process of the photolithography technique and a RIE using CCl₄/O₂ as the etching gas are carried out to pattern the third polysilicon layer and to form a lower gate electrode 15 of the TFT load.

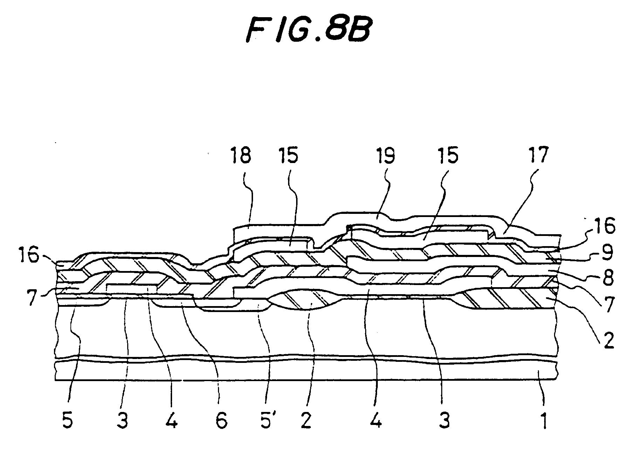

In FIG.8B, a CVD is carried out to form a lower gate insulator layer 16 of the TFT load which is made of SiO₂ and has a thickness of 200 Å, for example.

A CVD is then carried out to form a fourth polysilicon layer having a thickness of 200 Å, for example.

A resist process of the photolithography technique and an ion implantation are carried out to inject B ions with a dosage of 1 x 10¹⁴ cm⁻² and an acceleration energy of 5 keV, for example, into parts of the fourth polysilicon layer where source and drain regions of the TFT load are formed.

Next, a resist process of the photolithography technique and a RIE using CCl₄/O₂ as the etching gas are carried out to pattern the fourth polysilicon layer and to form a source region 17, a drain region 18 and a channel region 19 of the TFT load, a Vcc supply line and the like. The Vcc supply line cannot be seen in FIG.8B.

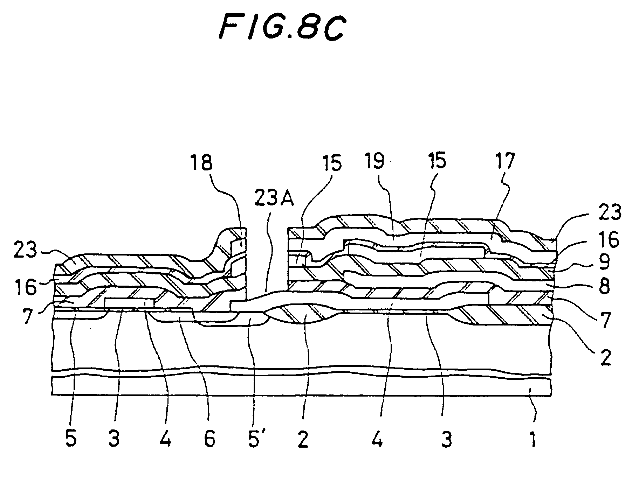

In FIG.8C, a CVD is carried out to form an insulator layer 23 which is made of SiO₂ and has a thickness of 500 Å, for example.

A resist process of the photolithography technique and RIEs using CHF₃/He and CCl₄/O₂ as the etching gases for respectively etching SiO₂ and polysilicon are carried out selectively etch the insulator layer 23, the drain region 18 of the TFT load formed from the fourth polysilicon layer, the gate insulator layer 16, the gate electrode 15 formed from the third polysilicon layer, the insulator layer 9 and the insulator layer 7 and to form a contact hole 23A. This contact hole 23A extends from the top surface of the insulator layer 23 to the top surface of the gate electrode 4 of the driver transistor formed from the first polysilicon layer. This process forms an essential part of this embodiment of the method.

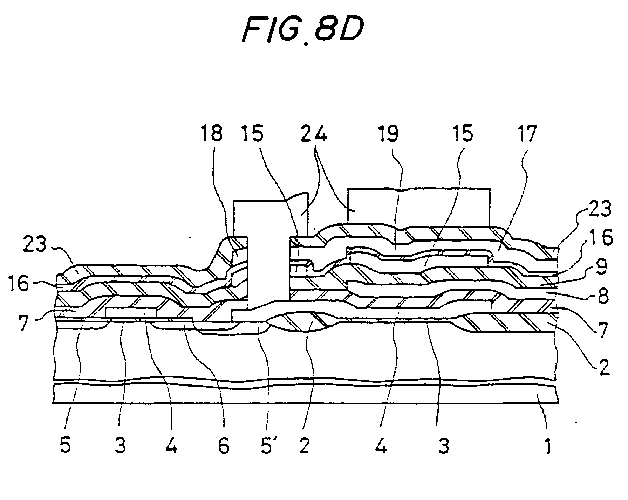

In FIG.8D, a CVD is carried out to form a fifth polysilicon layer having a thickness of 2000 Å, for example.

A thermal diffusion process is carried out to diffuse P in the fifth polysilicon layer with an impurity concentration of 1 x 10²¹ cm⁻³, for example.

A resist process of the photolithography technique and a RIE using CCl₄/O₂ as the etching gas are carried out to pattern the fifth polysilicon layer and to form an electrode 24. This electrode 24 is used in common as an upper gate electrode of the TFT load and the storage electrode of a memory capacitor. This storage electrode forms the characterizing part of this embodiment, because the storage electrode is thick and the side surface area thereof is positively used to realize a large capacitance.

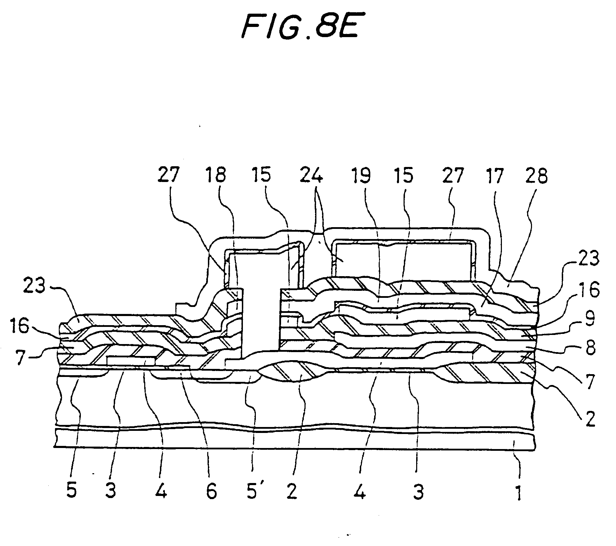

In FIG.8E, A CVD is carried out to form on the electrode 24 a dielectric layer 27 which is made of Si₃N₄ and has a thickness of 100 Å, for example.

Then, a CVD is carried out to form a sixth polysilicon layer having a thickness of 1000 Å, for example.

A thermal diffusion process is carried out to diffuse P in the sixth polysilicon layer with an impurity concentration of 1 x 10²¹ cm⁻³, for example.

A resist process of the photolithography technique and a RIE using CCl₄/O₂ as the etching gas are carried out to pattern the sixth polysilicon layer and to form an opposing electrode 28 of the memory capacitor. This process of forming the opposing electrode 28 also forms an essential part of this embodiment of the method.

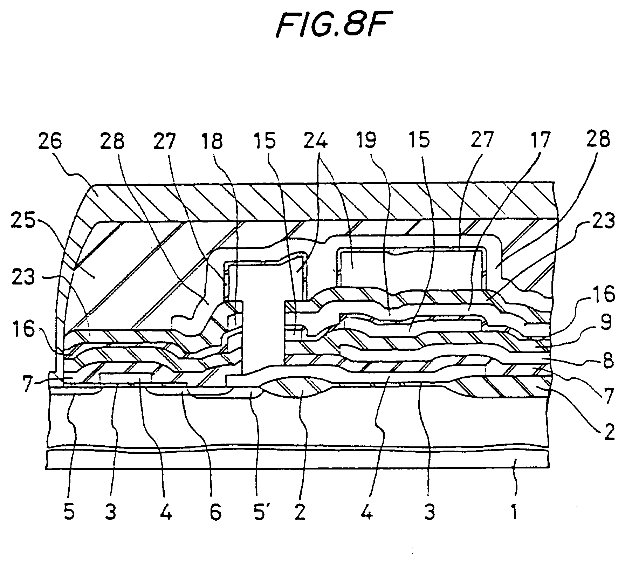

In FIG.8F, A CVD is carried out to form an insulator layer which is made of SiO₂ and has a thickness of 1000 Å, for example, and an insulator layer which is made of PSG and has a thickness of 5000 Å, for example. In FIG.8F, these two insulator layers are shown as an insulator layer 25.

Next, a thermal process is carried out to reflow and planarize the insulator layer 25.

A resist process of the photolithography technique and a RIE using CHF₃/He as the etching gas are carried out to selectively etch the insulator layer 25 and the like and to form a bit line contact hole.

A sputtering is carried out to form an Al layer having a thickness of 1 µm, for example, and this Al layer is patterned into a bit line 26 using the normal photolithography technique.

According to this embodiment, one additional mask process is necessary to form the opposing electrode 28. However, as described above in conjunction with the process related to FIG.8C, the contact hole 23A for connecting the TFT load and the driver transistor is formed in one mask process, and the number of mask processes in this respect is reduced by two compared to the prior art described above in conjunction with FIGS.7A through 7C. Therefore, when the entire production process of this embodiment is compared to that of the prior art of FIGS.7A through 7C, the number of mask processes is reduced by one.

Next, a description will be given of a second embodiment of the semiconductor memory device according to the present invention which is produced by a second embodiment of the method of producing the semiconductor memory device according to the present invention. FIGS.9A through 9E are side views in cross section showing an essential part of the second embodiment of the semiconductor memory device according to the present invention at essential stages of the second embodiment of the method of producing the semiconductor memory device according to the present invention. In FIGS.9A through 9E, those parts which are the same as those corresponding parts in FIGS.8A through 8F are designated by the same reference numerals, and a description thereof will be omitted.

In this embodiment of the method, the processes are the same as those of the first embodiment up to the processes shown in FIGS.8A and 8B, that is, until the source region 17, the drain region 18 and the channel region 19 of the TFT load are formed from the fourth polysilicon layer. Hence, a description will only be given of the processes carried out thereafter.

In FIG.9A, the double gate structure TFT load type SRAM already has on the Si semiconductor substrate 1 the field insulator layer 2, the gate insulator layer 3, the gate electrode 4 of the driver transistor formed from the first polysilicon layer, the n⁺-type impurity region 5', the n⁺-type source region 5, the n⁺-type drain region 6, the insulator layer 7, the ground line 8 formed from the second polysilicon layer, the gate electrode 15 of the TFT load formed from the third polysilicon layer, the gate insulator layer 16 of the TFT load, the source region 17 of the TFT load formed from the fourth polysilicon layer, the drain region 18, and the channel region 19.

A CVD is carried out to form on the entire surface an insulator layer 19 which is made of Si₃N₄ and has a thickness of 500 Å, for example.

Then, a CVD is carried out to form a fifth polysilicon layer having a thickness of 500 Å, for example.

An ion implantation is carried out to inject P ions into the fifth polysilicon layer with a dosage of 1 x 10¹⁵ cm⁻² and an acceleration energy of 10 keV.

A CVD is carried out to form on the entire surface an insulator layer 31 which is made of SiO₂ and has a thickness of 500 Å, for example. This insulator layer 31 acts as a spacer.

A resist process of the photolithography technique and RIEs using CHF₃/He and CCl₄/O₂ as etching gases for respectively etching SiO₂ and polysilicon are carried out to selectively etch the insulator layer 31, the fifth polysilicon layer, the insulator layer 29, the drain region 18 of the TFT load formed from the fourth polysilicon layer, the gate insulator layer 16, the gate electrode 15 formed from the third polysilicon layer, the insulator layer 9 and the insulator layer 7, and to form a contact hole 31A. This contact hole 31A extends from the top surface of the insulator layer 31 to the top surface of the gate electrode 4 of the driver transistor formed from the first polysilicon layer.

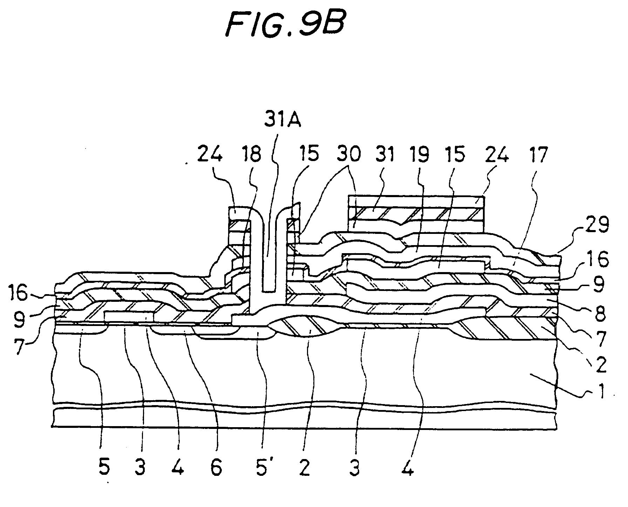

In FIG.9B, a CVD is carried out to form a sixth polysilicon layer having a thickness of 500 Å, for example.

A thermal diffusion process is carried out to diffuse P in the sixth polysilicon layer with an impurity concentration of 1 x 10²¹ cm⁻³, for example.

A resist process of the photolithography technique and RIEs using CCl₄/O₂ and CHF₃/He as the etching gases for respectively etching polysilicon and SiO₂ are carried out to pattern the sixth polysilicon layer, the insulator layer 31 and the fifth polysilicon layer, and to form a storage capacitor 24 of the memory capacitor and a fin 30 of the memory capacitor. This fin 30 is used in common as an upper gate electrode of the TFT load.

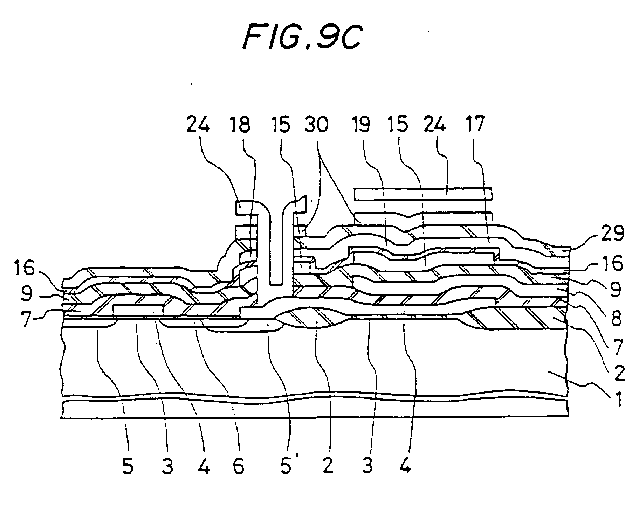

In FIG.9C, the above described structure is submerged in a HF solution to remove the SiO₂ insulator layer 31.

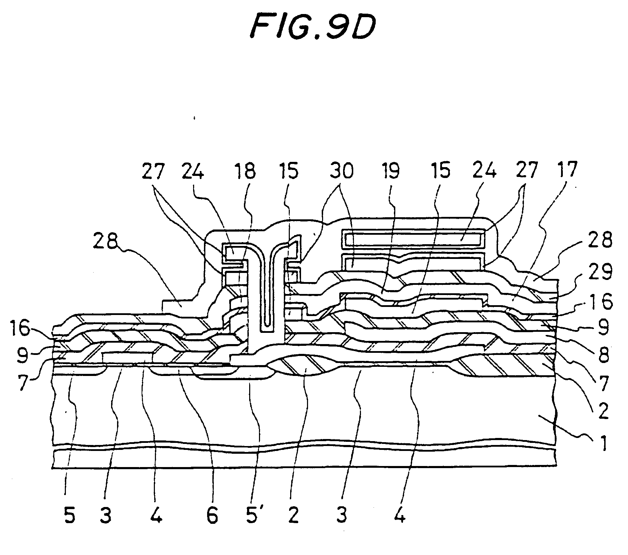

In FIG.9D, a CVD is carried out to form a dielectric layer 27 on the storage electrode 24 of the memory capacitor and on the surface of the fin 30 of the memory capacitor. For example, this dielectric layer 27 is made of Si₃N₄ and has a thickness of 100 Å.

Then, a CVD is carried out to form a seventh polysilicon layer having a thickness of 500 Å, for example.

A thermal diffusion process is carried out to diffuse P in the seventh polysilicon layer with an impurity concentration of 1 x 10²¹ cm⁻³, for example.

A resist process of the photolithography technique and a RIE using CCl₄/O₂ as the etching gas are carried out to pattern the seventh polysilicon layer and to form an opposing electrode 28 of the memory capacitor.

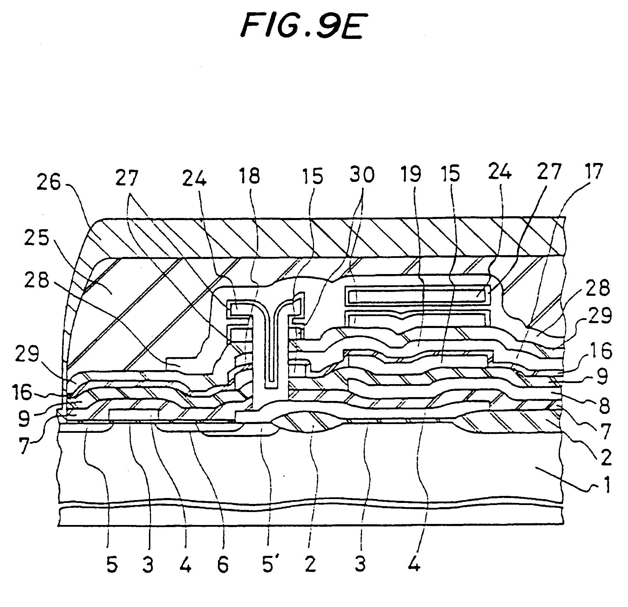

In FIG.9E, a CVD is carried out to form an insulator layer which is made of SiO₂ and has a thickness of 1000 Å, for example, and an insulator layer which is made of PSG and has a thickness of 5000 Å, for example. In FIG.9E, these two insulator layers are shown as an insulator layer 25.

Then, a thermal process is carried out to reflow and planarize the insulator layer 25.

A resist process of the photolithography technique and a RIE using CHF₃/He as the etching gas are carried out to selectively etch the insulator layer 25 and the like and to form a bit line contact hole.

A sputtering is carried out to form an Al layer having a thickness of 1 µm, for example, and this Al layer is patterned to form a bit line 26 using the normal photolithography technique.

This embodiment has two fins in total because the fin 30 which is also used as the upper gate electrode of the double gate structure TFT load is added to the storage electrode 24 of the memory capacitor. As a result, the capacitance of the memory capacitor is increased compared to that of the first embodiment. An arbitrary number of fins 30 may be added, and the mask process described in conjunction with FIGS.8A through 8F may be used regardless of the number of fins 30. In addition, the voltage which is applied to the opposing electrode 28 of the memory capacitor may be any number of volts within the range of the positive power source voltage Vcc. But if the voltage applied to the opposing electrode 28 is set to Vcc/2, the voltage applied to the dielectric layer becomes small, the dielectric layer can be made thin, and a large capacitance can be obtained.

FIG.10 is a plan view generally showing an essential part of a TFT load type SRAM. FIG.10 shows a gate 41 of the TFT load, a channel 42 of the TFT load, a word line 43 (WL), and a power source voltage supply line Vcc for supplying the positive power source voltage Vcc.

According to the SRAM shown in FIG.10, the driver transistors and the TFT loads are arranged in a symmetrical manner, thereby making it possible to design the layout with ease. Hence, a description will hereunder be given of a third embodiment of the semiconductor memory device according to the present invention which is applied to the TFT load type SRAM shown in FIG.10.

Next, a description will be given of a third embodiment of the semiconductor memory device according to the present invention which is produced by a third embodiment of the method of producing the semiconductor memory device according to the present invention. FIGS.11A through 11J are side views in cross section showing an essential part of the third embodiment of the semiconductor memory device according to the present invention at essential stages of the third embodiment of the method of producing the semiconductor memory device according to the present invention. FIGS.12A through 12G are plan views of the semiconductor memory device at essential stages of the third embodiment of the method shown in FIGS.11A through 11J. FIGS.11A through 11J respectively are cross sections taken along a line X-X in FIG.10.

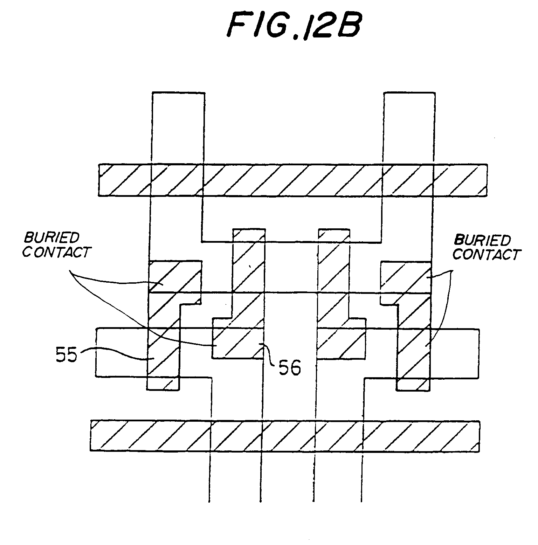

In FIGS.11A, 12A and 12B, a pad layer made of SiO₂ covering an active region of a Si semiconductor substrate 51 and an oxidation resistant mask layer made of Si₃N₄ formed on the pad layer are used to carry out a selective thermal oxidation to form a field insulator layer 52 which is made of SiO₂ and has a thickness of 4000 Å, for example.

After exposing the active region by removing the oxidation resistant mask layer and the pad layer, a thermal oxidation is carried out to form a gate insulator layer 53 which is made of SiO₂ and has a thickness of 100 Å, for example.

A resist process of the photolithography technique and a wet etching using hydrofluoric acid as the etchant are carried out to selective etch the gate insulator layer 53 and to form a contact hole 53A which is also used when diffusing impurities.

A CVD is carried out to form a first polysilicon layer having a thickness of 1000 Å, for example.

Then, a vapor phase diffusion is carried out to introduce P with an impurity concentration of 1 x 10²⁰ cm⁻³, for example, so as to form an n⁺-type impurity region 54.

A resist process of the photolithography technique and a RIE using CCl₄/O₂ as the etching gas are carried out to pattern the first polysilicon layer and to form gate electrodes 55 and 56.

An ion implantation is carried out to inject As ions into the first polysilicon layer with a dosage of 1 x 10¹⁵ cm⁻² and an acceleration energy of 30 keV, for example, so as to form an n⁺-type source region 57 and an n⁺-type drain region 58.

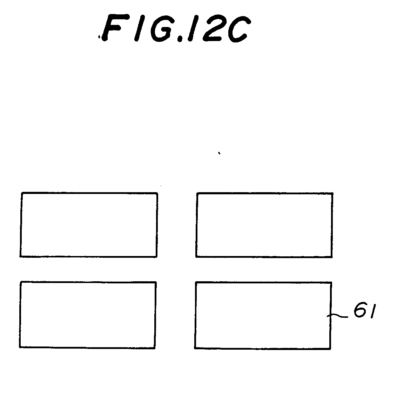

In FIGS.11B and 12C, a CVD is carried out to form an insulator layer 59 which is made of SiO₂ and has a thickness of 1000 Å, for example.

Then, a CVD is carried out to form a second polysilicon layer having a thickness of 1000 Å, for example.

A vapor phase diffusion is carried out to introduce P into the second polysilicon layer with an impurity concentration of 1 x 10²⁰ cm⁻³, for example.

Next, a resist process of the photolithography technique and a RIE using CCl₄/O₂ as the etching gas are carried out to pattern the second polysilicon layer and to form a lower gate electrode 61 of the TFT load and the like.

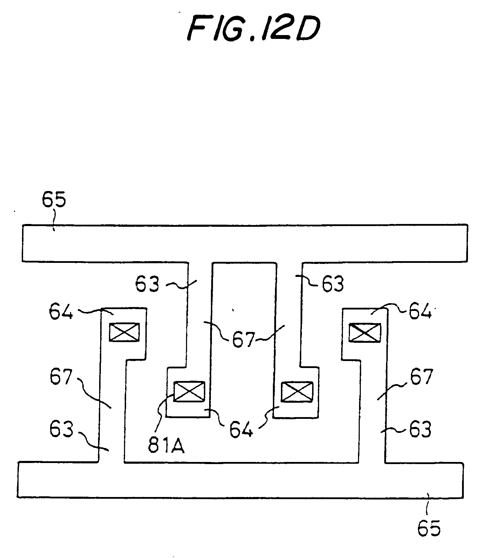

In FIGS.11C and 12D, a CVD is carried out to form an insulator layer 62 which is made of SiO₂ and has a thickness of 200 Å, for example.

Then, a CVD is carried out to form a third polysilicon layer having a thickness of 200 Å, for example.

A resist process of the photolithography technique and an ion implantation are carried out to inject B ions with a dosage of 1 x 10¹⁴ cm⁻² and an acceleration energy of 5 keV, for example, into parts of the third polysilicon layer where source and drain regions of the TFT load and a Vcc supply line are formed.

A resist process of the photolithography technique and a RIE using CCl₄/O₂ as the etching gas are carried out to pattern the third polysilicon layer and to form a contact part, a drain region, a source region and a channel region of each TFT load, and the Vcc supply line. In FIG.11C, only a contact part 64 and a channel region 67 can be seen.

In FIGS.11D and 12D, a CVD is carried out to form an insulator layer 79 which is made of Si₃N₄ and has a thickness of 500 Å, for example.

In FIGS.11E and 12D, a CVD is carried out to form a fourth polysilicon layer having a thickness of 500 Å, for example.

Then, a vapor phase diffusion is carried out to introduce P into the fourth polysilicon layer with an impurity concentration of 1 x 10²⁰ cm⁻³, for example.

A CVD is carried out to form an insulator layer 81 which is made of SiO₂ and has a thickness of 500 Å, for example.

A resist process of the photolithography technique and RIEs using CHF₃/He and CCl₄/O₂ as the etching gases are carried out to selectively etch the insulator layer 81, the fourth polysilicon layer, the insulator layer 79, the third polysilicon layer, the insulator layer 62, the second polysilicon layer and the insulator layer 59, and to form a contact hole 81A. The CHF₃/He etching gas is used to etch the SiO₂ and the Si₃N₄, while the CCl₄/O₂ etching gas is used to etch the polysilicon. The contact hole 81A extends from the top surface of the insulator layer 81 and reaches the top surface of the gate electrode 56 of the driver transistor formed from the first polysilicon layer.

In FIG.11F, a CVD is carried out to form a fifth polysilicon layer having a thickness of 500 Å, for example.

Then, a thermal diffusion process is carried out to diffuse P in the fifth polysilicon layer with an impurity concentration of 1 x 10²¹ cm⁻³.

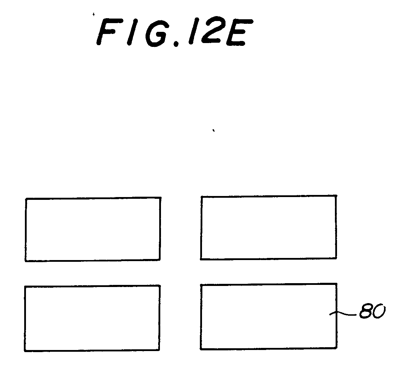

In FIGS.11G and 12E, a resist process of the photolithography technique and RIEs using CCl₄/O₂ and CHF₃/He as the etching gases are carried out to pattern the fifth polysilicon layer, the insulator layer 81 and the fourth polysilicon layer, and to form a storage electrode 82 of the memory capacitor and a fin 80 of the memory capacitor. The CCl₄/O₂ etching gas is used to etch the polysilicon, while the CHF₃/He etching gas is used to etch the SiO₂. The fin 80 is used in common as an upper electrode of the double gate structure TFT load.

In FIG.11H, the structure described above is submerged in a HF solution to remove the SiO₂ insulator layer 81.

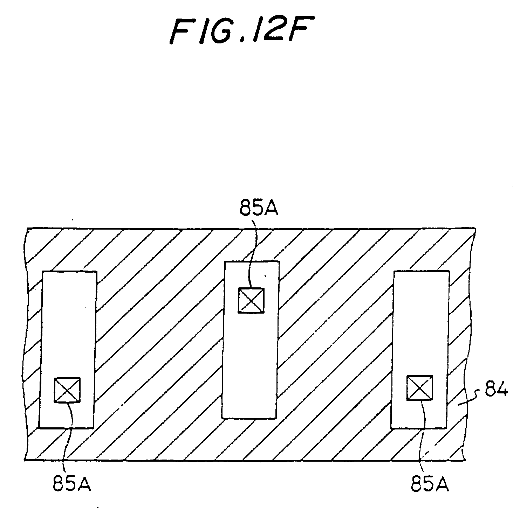

In FIGS.11I and 12F, a CVD is carried out to form a dielectric layer 83 which is made of Si₃N₄ and has a thickness of 100 Å, for example, on the electrode 82 and the surface of the fin 80.

Then, a CVD is carried out to form a sixth polysilicon layer having a thickness of 1000 Å, for example.

A thermal diffusion process is carried out to diffuse P in the sixth polysilicon layer with an impurity concentration of 1 x 10²¹ cm⁻³, for example.

A resist process of the photolithography technique and a RIE using CCl₄/O₂ as the etching gas are carried out to pattern the sixth polysilicon layer and to form an opposing electrode 84 of the memory capacitor.

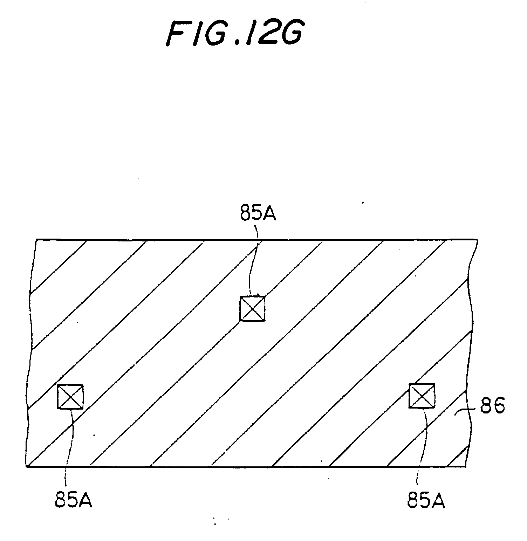

In FIGS.11J, 12F and 12G, a CVD is carried out to form an insulator layer 85 which is made of SiO₂ and has a thickness of 1000 Å, for example.

Then, a resist process of the photolithography technique and a RIE using CHF₃/He as the etching gas are carried out to selectively etch the insulator layer 85 and the like and to form a ground line contact hole 85A.

A CVD is carried out to form a seventh polysilicon layer having a thickness of 1000 Å, for example.

A thermal diffusion process is carried out to diffuse P in the seventh polysilicon layer with an impurity concentration of 1 x 10²¹ cm⁻³, for example.

Next, a resist process of the photolithography technique and a RIE using CCl₄/O₂ as the etching gas are carried out to pattern the seventh polysilicon layer and to form a Vss supply line 86.

A CVD is carried out to form an insulator layer which is made of SiO₂ and has a thickness of 1000 Å, for example, and an insulator layer which is made of PSG and has a thickness of 5000 Å, for example. In FIG.11J, these two insulator layers are shown as an insulator layer 87.

A thermal process is carried out to reflow and planarize the insulator layer 87.

Thereafter, a resist process of the photolithography technique and a RIE using CHF₃/He or the like as the etching gas are carried out to selectively etch the insulator layer 87 and the like, and to form a bit line contact hole which cannot be seen in FIG.11J.

A sputtering is carried out to form an Al layer having a thickness of 1 µm, for example, and this Al layer is patterned using the normal photolithography technique to form a bit line 88.

Next, a description will be given of a fourth embodiment of the semiconductor memory device according to the present invention which is produced by a fourth embodiment of the method of producing the semiconductor memory device according to the present invention. FIGS.13A through 13C are side views in cross section showing an essential part of the fourth embodiment of the semiconductor memory device according to the present invention at essential stages of the fourth embodiment of the method of producing the semiconductor memory device according to the present invention. In FIGS.13A through 13C, those parts which are the same as those corresponding parts in FIGS.11A through 11J are designated by the same reference numerals, and a description thereof will be omitted.

In this embodiment of the method, the processes are the same as those of the third embodiment up to the processes shown in FIGS.11A through 11D, that is, until the insulator layer 79 is formed from Si₃N₄. Hence, a description will only be given of the processes carried out thereafter.

In FIG.13A, the double gate structure TFT load type SRAM already has on the Si semiconductor substrate 51 the field insulator layer 52, the gate insulator layer 53, the n⁺-type impurity region 54, the gate electrode 55 of the driver transistor formed from the first polysilicon layer, the n⁺-type source region 57, the n⁺-type drain region 58, the insulator layer 59, the gate electrode 61 of the TFT load formed from the second polysilicon layer, the gate insulator layer 62 of the TFT load, the source region, the drain contact region 64 and the channel region 67 of the TFT load formed from the third polysilicon layer, and the insulator layer 79 which is made of Si₃N₄. In FIG.13A, the source region of the TFT load cannot be seen.

A CVD is carried out to form a fourth polysilicon layer having a thickness of 500 Å, for example.

Then, a vapor phase diffusion is carried out to introduce P in the fourth polysilicon layer with an impurity concentration of 1 x 10²⁰ cm⁻³, for example.

A CVD is carried out to form an insulator layer 81 which is made of SiO₂ and has a thickness of 500 Å, for example.

A CVD is carried out to form a fifth polysilicon layer having a thickness of 500 Å, for example.

Thereafter, a vapor phase diffusion is carried out to introduce P in the fifth polysilicon layer with an impurity concentration of 1 x 10²⁰ cm⁻³, for example.

A CVD is carried out to form an insulator layer 90 which is made of SiO₂ and has a thickness of 500 Å, for example.

A resist process of the photolithography technique and RIEs using CHF₃/He and CCl₄/O₂ as the etching gases are carried out to selectively etch the insulator layer 90, the fifth polysilicon layer, the insulator layer 81, the fourth polysilicon layer, the insulator layer 79, the third polysilicon layer, the insulator layer 62, the second polysilicon layer and the insulator layer 59, and to form a contact hole 90A. The CHF₃/He etching gas is used to etch the SiO₂ and the Si₃N₄, while the CCl₄/O₂ etching gas is used to etch the polysilicon. The contact hole 90A extends from the top surface of the insulator layer 90 and reaches the top surface of the gate electrode 56 of the driver transistor formed from the first polysilicon layer.

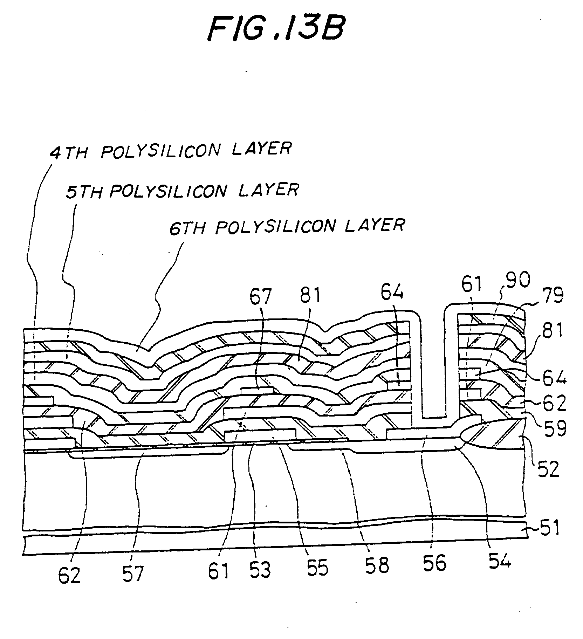

In FIG.13B, a CVD is carried out to form a sixth polysilicon layer having a thickness of 500 Å, for example.

Then, a thermal diffusion process is carried out to diffuse P in the sixth polysilicon layer with an impurity concentration of 1 x 10²¹ cm⁻³, for example.

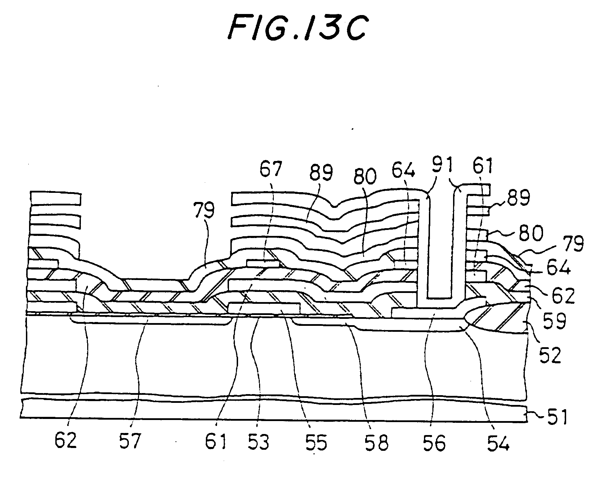

In FIG.13C, a resist process of the photolithography technique and RIEs using CCl₄/O₂ and CHF₃/He as the etching gases are carried out pattern the sixth polysilicon layer, the insulator layer 90, the fifth polysilicon layer, the insulator layer 81 and the fourth polysilicon layer, and to form a fin 91 of the memory capacitor, a fin 89 of the memory capacitor, and a fin 80 of the memory capacitor. The fin 80 of the memory capacitor is used in common as an upper gate electrode of the double gate structure TFT load, and the fin 91 of the memory capacitor is used as the storage electrode of the memory capacitor.

The above described structure is submerged in a HF solution to remove the SiO₂ insulator layers 90 and 81.

Thereafter, processes similar to those described above in conjunction with FIGS.11I and 11J of the third embodiment are carried out to form a dielectric layer of the memory capacitor and the like.

According to this embodiment, substantially three fins can be integrally formed on the storage electrode of the memory capacitor, without increasing the number of mask processes. Hence, the capacitance of the memory capacitor can be increased considerably compared to that of the third embodiment. The number of fins which directly affects the capacitance of the memory capacitor can be increased arbitrarily without increasing the number of mask processes.

Next, a description will be given of a fifth embodiment of the semiconductor memory device according to the present invention which is produced by a fifth embodiment of the method of producing the semiconductor memory device according to the present invention. FIGS.14A through 14D are side views in cross section showing an essential part of the fifth embodiment of the semiconductor memory device according to the present invention at essential stages of the fifth embodiment of the method of producing the semiconductor memory device according to the present invention. In FIGS.14A through 14D, those parts which are the same as those corresponding parts in FIGS.11A through 11J are designated by the same reference numerals, and a description thereof will be omitted.

In this embodiment of the method, the processes are the same as those of the third embodiment up to the processes shown in FIGS.11A through 11C, that is, until the third polysilicon layer is patterned to form the contact part, the drain, source and channel regions of the TFT load and the Vcc line. Hence, a description will only be given of the processes carried out thereafter.

In FIG.14A, the double gate structure TFT load type SRAM already has on the Si semiconductor substrate 51 the field insulator layer 52, the gate insulator layer 53, the n⁺-type impurity region 54, the gate electrode 55 of the driver transistor formed from the first polysilicon layer, the n⁺-type source region 57, the n⁺-type drain region 58, the insulator layer 59, the gate electrode 61 of the TFT load formed from the second polysilicon layer, the gate insulator layer 62 of the TFT load, the source, drain and channel regions of the TFT load formed from the third polysilicon layer, and the Vcc supply line.

A CVD is carried out to form an insulator layer 92 which is made of SiO₂ and has a thickness of 500 Å.

Then, a CVD is carried out to form a fourth polysilicon layer having a thickness of 500 Å, for example.

A vapor phase diffusion is carried out to introduce P in the fourth polysilicon layer with an impurity concentration of 1 x 10²⁰ cm⁻³, for example.

A resist process of the photolithography technique and a RIE using CCl₄/O₂ as the etching gas are carried out to pattern the fourth polysilicon layer and to form a fin 93. This fin 93 is used in common as an upper gate electrode of the double gate structure TFT load.

In FIG.14B, a CVD is carried out to form an insulator layer 94 which is made of Si₃N₄ and has a thickness of 500 Å, for example, and an insulator layer 95 which is made of SiO₂ and has a thickness of 500 Å, for example.

Then, a resist process of the photolithography technique and RIEs using CHF₃/He and CCl₄/O₂ as the etching gases are carried out to selectively etch the insulator layers 95 and 94, the fourth polysilicon layer, the insulator layer 92, the third polysilicon layer, the insulator layer 62, the second polysilicon layer and the insulator layer 59, and to form a contact hole 95A. The CHF₃/He etching gas is used to etch the SiO₂ and the Si₃N₄, while the CCl₄/O₂ etching gas is used to etch the polysilicon. The contact hole 95A extends from the top surface of the insulator layer 95 and reaches the top surface of the gate electrode 56 of the driver transistor formed from the first polysilicon.

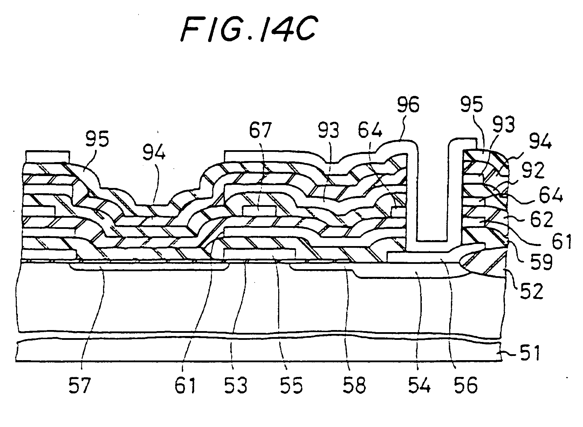

In FIG.14C, a CVD is carried out to form a fifth polysilicon layer having a thickness of 500 Å, for example.

Then, a thermal diffusion process is carried out to diffuse P in the fifth polysilicon layer with an impurity concentration of 1 x 10²¹ cm⁻³, for example.

A resist process of the photolithography technique and a RIE using CCl₄/O₂ as the etching gas are carried out to pattern the fifth polysilicon layer and to form a storage electrode 96 of the memory capacitor.

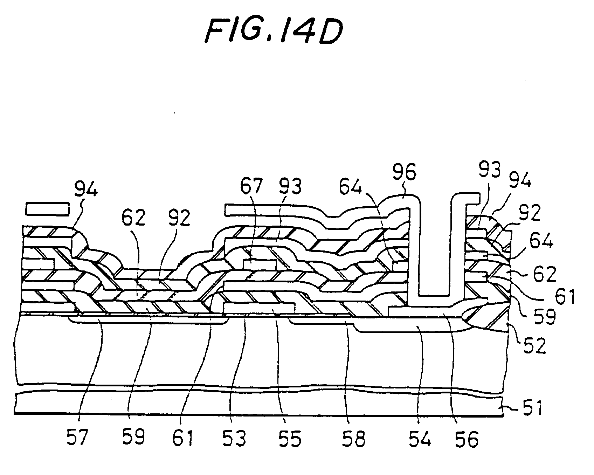

In FIG.14D, the structure described above is submerged into a HF solution to remove the SiO₂ insulator layer 95.

Thereafter, processes similar to those described above in conjunction with FIGS.11I and 11J of the third embodiment are carried out to form a dielectric layer of the memory capacitor and the like.

According to this embodiment, the fin of the memory capacitor which is also used in common as the upper gate electrode of the double gate structure TFT load and the storage electrode of the memory capacitor have a modified construction compared to the third embodiment.

Normally, when etching the polysilicon, the underlying layer is suited as an etching stopper if this underlying layer is made of SiO₂ rather than Si₃N₄. Hence, this embodiment has an advantage in that the formation of the storage electrode of the memory capacitor is facilitated compared to the third embodiment. On the other hand, the number of mask processes increases by one when the the upper gate electrode of the double gate structure TFT load and the storage electrode of the memory capacitor are patterned independently, but since the mutual connection can be realized in one process, the number of mask processes as a whole does not change compared to that of the prior art shown in FIGS.7A through 7C.

Next, a description will be given of a sixth embodiment of the semiconductor memory device according to the present invention which is produced by a sixth embodiment of the method of producing the semiconductor memory device according to the present invention. FIGS.15A and 15B are side views in cross section showing an essential part of the sixth embodiment of the semiconductor memory device according to the present invention at essential stages of the sixth embodiment of the method of producing the semiconductor memory device according to the present invention. In FIGS.15A and 15B, those parts which are the same as those corresponding parts in FIGS.11A through 11J are designated by the same reference numerals, and a description thereof will be omitted.

In this embodiment of the method, the processes are the same as those of the third embodiment up to the processes shown in FIGS.11A through 11H, that is, until the insulator layer 81 is removed Hence, a description will only be given of the processes carried out thereafter.

In FIG.15A, the double gate structure TFT load type SRAM already has on the Si semiconductor substrate 51 the field insulator layer 52, the gate insulator layer 53, the n⁺-type impurity region 54, the gate electrode 55 of the driver transistor formed from the first polysilicon layer, the n⁺-type source region 57, the n⁺-type drain region 58, the insulator layer 59, the gate electrode 61 of the TFT load formed from the second polysilicon layer, the gate insulator layer 62 of the TFT load, the source, drain and channel regions of the TFT load formed from the third polysilicon layer, the Vcc supply line, the insulator layer 79 which is made of Si₃N₄ and acts as an etching stopper, the fin 80 of the memory capacitor also used in common as the upper gate electrode of the TFT load, and the storage electrode 82 of the memory capacitor. The insulator layer 81 is already removed.

A CVD is carried out to form a dielectric layer 83 which is made of Si₃N₄ and has a thickness of 100 Å, for example, on the storage electrode 82 of the memory capacitor and the surface of the fin 80 of the memory capacitor. This fin 80 is used in common as the upper gate electrode of the double gate structure TFT load.

Then, a CVD is carried out to form a sixth polysilicon layer having a thickness of 1000 Å, for example.

A thermal diffusion process is carried out to diffuse P in the sixth polysilicon layer with an impurity concentration of 1 x 10²¹ cm⁻³, for example.

A resist process of the photolithography technique and RIEs using CCl₄/O₂ and CHF₃/He as the etching gases to pattern the sixth polysilicon layer, form an opposing electrode 84 of the memory capacitor, and selectively remove the Si₃N₄ insulator layer 79 which acts as the etching stopper at the stage of FIG.11H, by use of the same mask. The CCl₄/O₂ etching gas is used to etch the polysilicon, while the CHF₃/He etching gas is used to remove the Si₃N₄.

In FIG.15B, a CVD is carried out to form an insulator layer which is made of SiO₂ and has a thickness of 1000 Å, for example, and an insulator layer which is made of PSG and has a thickness of 5000 Å, for example. In FIG.15B, these two insulator layers are shown as an insulator layer 85.

Then, a thermal process is carried out to reflow and planarize the insulator layer 85.

A resist process of the photolithography technique and a RIE using CHF₃/He as the etching gas are carried out to selectively etch the insulator layer 85 and the like and to form a ground line contact hole.

A CVD is carried out to form a seventh polysilicon layer having a thickness of 1000 Å, for example.

A thermal diffusion process is carried out to diffuse P in the seventh polysilicon layer with an impurity concentration of 1 x 10²¹ cm⁻³, for example.

A resist process of the photolithography technique and a RIE using CCl₄/O₂ as the etching gas are carried out to pattern the seventh polysilicon layer and to form a Vss supply line 86.

A CVD is carried out to form an insulator layer 87 which is made of borophosphosilicate glass (BPSG) and has a thickness of 5000 Å, for example.

A thermal process is carried out to reflow and planarize the insulator layer 87.

A resist process of the photolithography technique and a RIE using CCl₄/O₂ or the like as the etching gas are carried out to selectively etch the insulator layer 87 and the like, and to form a bit line contact hole. This bit line contact hole cannot be seen in FIG.15B.

Thereafter, a sputtering is carried out to form an Al layer having a thickness of 1 µm, for example, and this Al layer is patterned to form a bit line 88 by use of the normal photolithography technique.

According to this embodiment, it is possible to obtain a very good result when contacting the Al bit line 88 to the source region (not shown) of the transfer transistor.

In other words, as described in conjunction with FIG.15B, the bit line contact hole is formed at a part which cannot be seen in FIG.15B, but in this case, the stacked part which is etched has the PSG layer on top of the Si₃N₄ insulator layer 79 and the SiO₂ layer on the bottom of the Si₃N₄ insulator layer 79. Hence, the resist mask must be removed by oxygen plasma or the like. However, a natural oxide layer is formed at the bottom of the bit line contact hole, and this natural oxide layer must be removed by a hydrofluoric acid process before forming the Al bit line 88. The Si₃N₄ insulator layer 79 is virtually unaffected by such a hydrofluoric acid process, but the PSG layer and the SiO₂ layer are etched and the hole diameter increases at these parts. Accordingly, only the Si₃N₄ insulator layer 79 projects within the bit line contact hole, and a disconnection easily occurs when the Al layer is formed thereon.

But according to the sixth embodiment, the Si₃N₄ insulator layer 79 is patterned at the stage where the opposing electrode 84 of the memory capacitor is formed, and the above described problems will not occur. In addition, since the Si₃N₄ insulator layer 79 is removed using the same mask as the opposing electrode 84, and the number of mask processes will not increase.

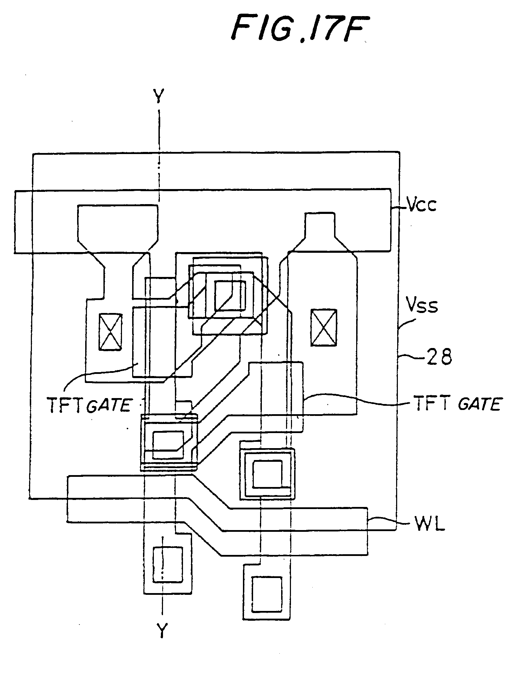

Next, a description will be given of a seventh embodiment of the semiconductor memory device according to the present invention which is produced by a seventh embodiment of the method of producing the semiconductor memory device according to the present invention. FIGS.16A through 16H are side views in cross section and FIGS.17A through 17F are plan views respectively showing an essential part of the seventh embodiment of the semiconductor memory device according to the present invention at essential stages of the seventh embodiment of the method of producing the semiconductor memory device according to the present invention. In FIGS.16A through 16H and FIGS.17A through 17F, those parts which are the same as those corresponding parts in FIGS.1A through 1J are designated by the same reference numerals, and a description thereof will be omitted. FIGS.16A through 16H respectively are cross sections taken along a line which corresponds to a line Y-Y in the plan view of FIG.17F.

In this embodiment of the method, the processes are the same as those of the prior art up to the processes shown in FIGS.1A and 1D, that is, until the source region 5 and the drain region 6 are formed. Hence, a description will only be given of the processes carried out thereafter.

In FIGS.16A and 17A, the double gate structure TFT load type SRAM already has on the Si semiconductor substrate 1 the field insulator layer 2, the gate insulator layer 3, the gate electrode 4 of the driver transistor formed from the first polysilicon layer, the n⁺-type impurity region 5', the n⁺-type source region 5, and the n⁺-type drain region 6.

A CVD is carried out to form an insulator layer 7 which is made of SiO₂ and has a thickness of 1000 Å, for example.

Then, a CVD is carried out to form a second polysilicon layer having a thickness of 500 Å, for example.

An ion implantation is carried out to inject P ions into the second polysilicon layer with a dosage of 1 x 10¹⁵ cm⁻² and an acceleration energy of 10 keV.

A resist process of the photolithography technique and a RIE using CCl₄/O₂ as the etching gas are carried out to pattern the second polysilicon layer and to form a lower gate electrode 15 of the TFT load.

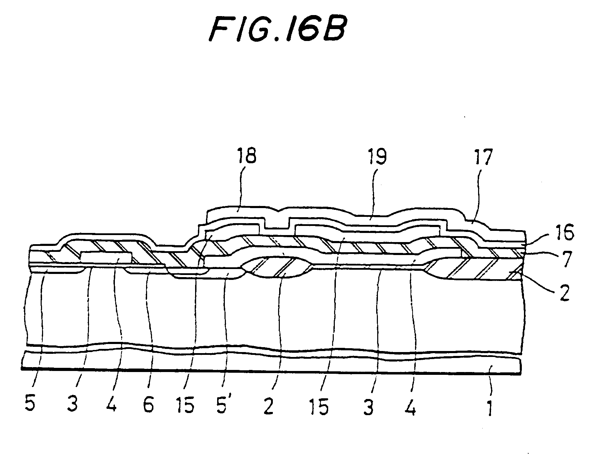

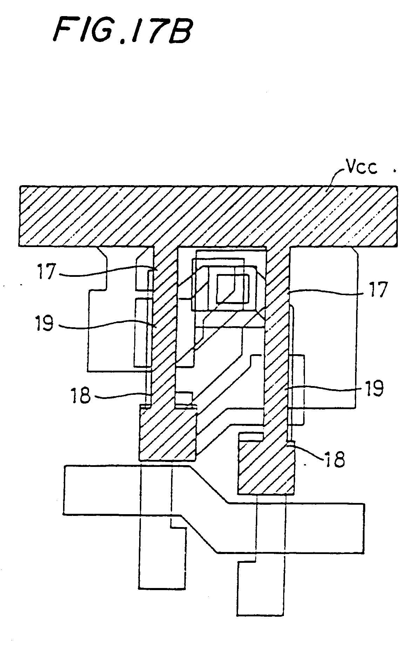

In FIGS.16B and 17B, a CVD is carried out to form a lower gate insulator layer 16 of the TFT load, which is made of SiO₂ and has a thickness of 200 Å, for example.

Then, a CVD is carried out to form a third polysilicon layer having a thickness of 200 Å, for example.

A resist process of the photolithography technique and an ion implantation are carried out to inject B ions with a dosage of 1 x 10¹⁴ cm⁻² and an acceleration energy of 5 keV, for example, into parts of the third polysilicon layer where the source and drain regions of the TFT load are formed.

A resist process of the photolithography technique and a RIE using CCl₄/O₂ as the etching gas are carried out to pattern the third polysilicon layer and to form a source region 17, a drain region 18 and a channel region 19 of the TFT load, a Vcc supply line and the like. The Vcc supply line cannot be seen in FIG.16B but is shown in FIG.17B.

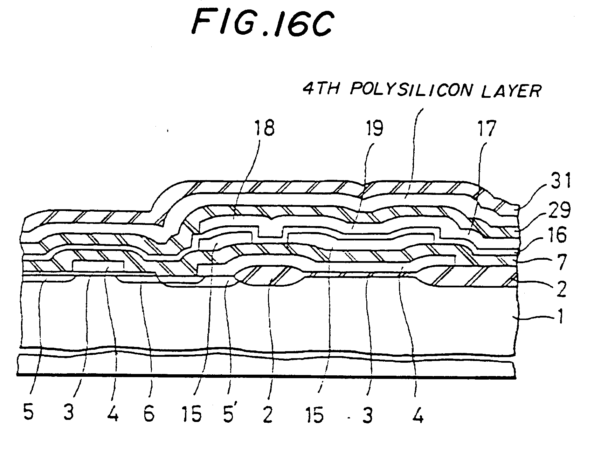

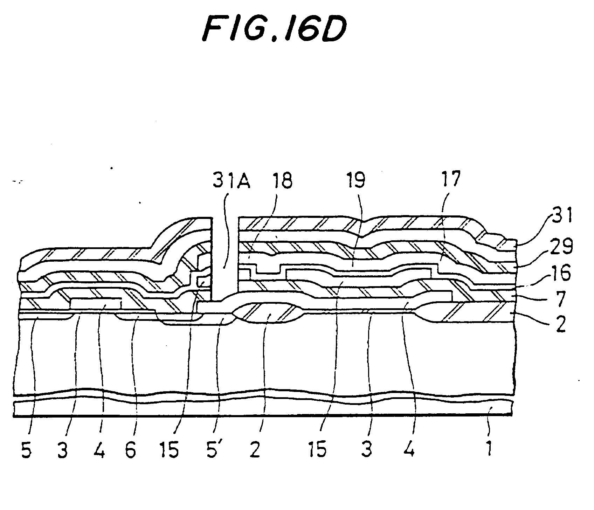

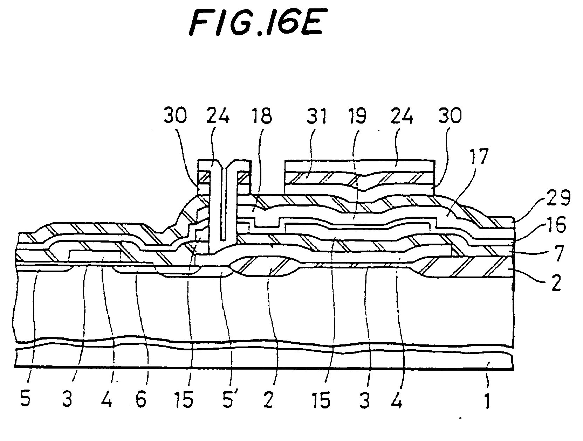

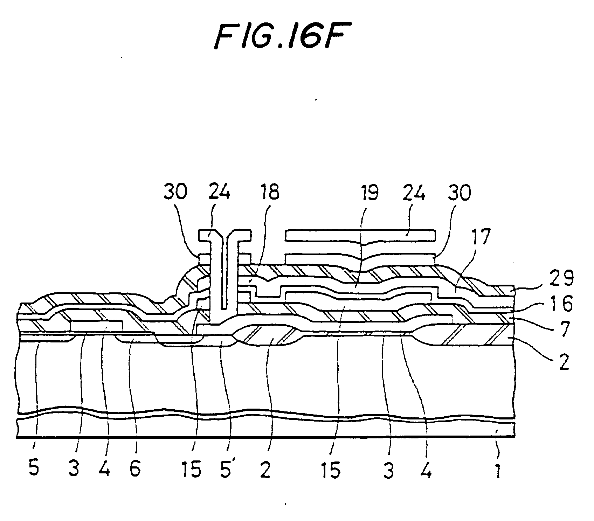

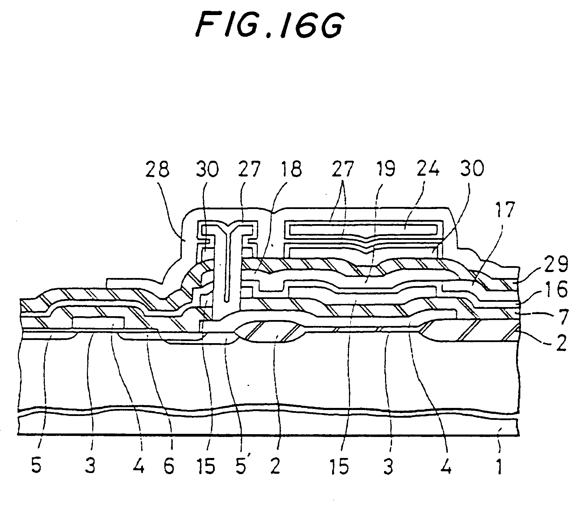

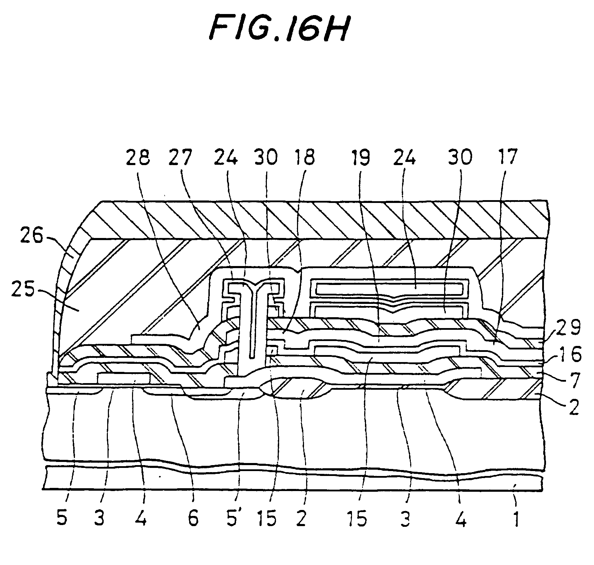

In FIG.16C, a CVD is carried out to form on the entire surface an upper gate insulator layer 29 of the TFT load, which also acts as an etching stopper. The upper gate insulator layer 29 is made of Si₃N₄ and has a thickness of 500 Å, for example.

Then, a CVD is carried out to form a fourth polysilicon layer having a thickness of 500 Å, for example.

An ion implantation is carried out to inject P ions into the fourth polysilicon layer with a dosage of 1 x 10¹⁵ cm⁻² and an acceleration energy of 10 keV, for example.

A CVD is carried out to form on the entire surface an insulator layer 31 which acts as a spacer. This insulator layer 31 is made of SiO₂ and has a thickness of 500 Å, for example.

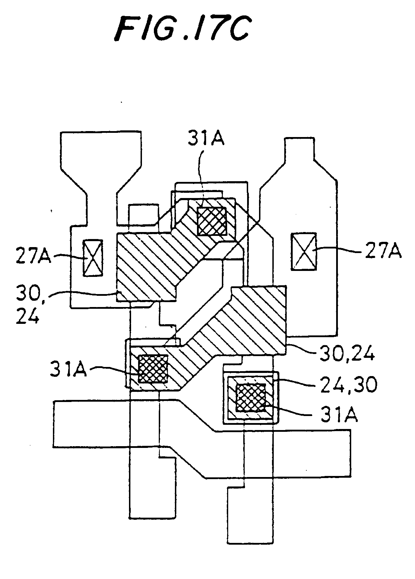

In FIGS.16D and 17C, a resist process of the photolithography technique and RIEs using CHF₃/He and CCl₄/O₂ as etching gases are carried out to selectively etch the insulator layer 31, the fourth polysilicon layer, the upper gate insulator layer 29 of the TFT load, the drain region 18 of the TFT load formed from the third polysilicon layer, the lower gate insulator layer 16, the lower gate electrode 15 formed from the second polysilicon layer, and the insulator layer 7, and to form a contact hole 31A. The CHF₃/He etching gas is used to etch the SiO₂ and the Si₃N₄, while the CCl₄/O₂ etching gas is used to etch the polysilicon. The contact hole 31A extends from the top surface of the insulator layer 31 and reaches the top surface of the gate electrode 4 of the driver transistor formed from the first polysilicon.

In FIGS.16E and 17C, a CVD is carried out to form a fifth polysilicon layer having a thickness of 500 Å, for example.

Then, a thermal diffusion process is carried out to diffuse P in the fifth polysilicon layer with an impurity concentration of 1 x 10²¹ cm⁻³, for example.

A resist process of the photolithography technique and RIEs using CCl₄/O₂ and CHF₃/He as the etching gases are carried out to pattern the fifth polysilicon layer, the insulator layer 31 and the fourth polysilicon layer, and to form a storage electrode 24 of the memory capacitor and an upper gate electrode 30 of the TFT load. The CCl₄/O₂ etching gas is used to etch the polysilicon, while the CHF₃/He etching gas is used to etch the SiO₂. The upper gate electrode 30 is used in common as a fin of the memory capacitor.

In FIG.16F, the structure described above is submerged in a HF solution to remove the SiO₂ insulator layer 31.

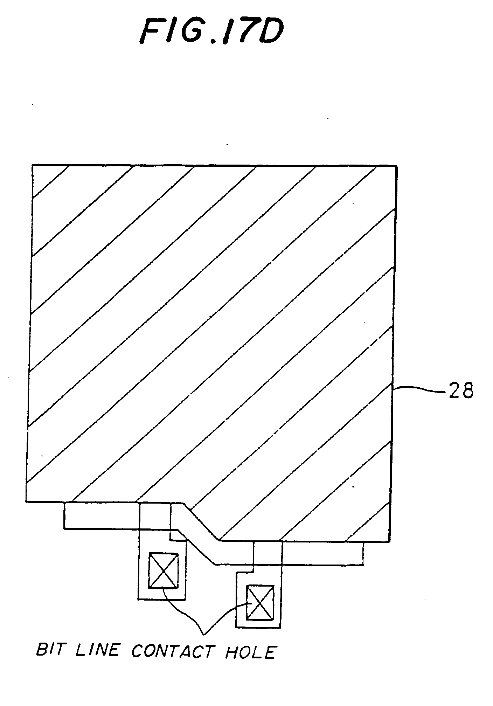

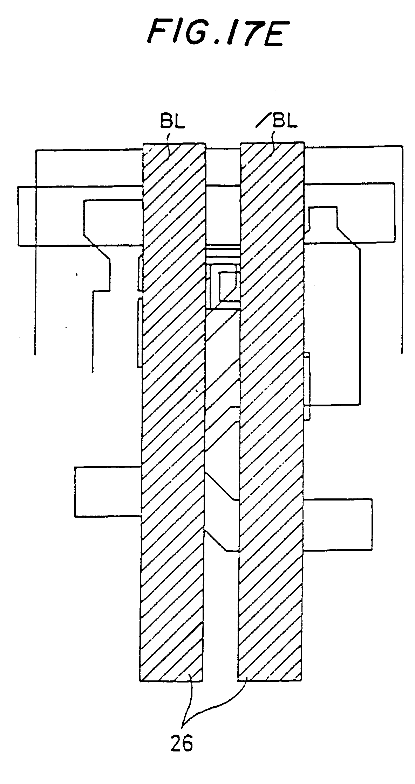

In FIGS.16G, 17C and 17D, a CVD is carried out to form a dielectric layer 27 which is made of Si₃N₄ and has a thickness of 200 Å, for example, on the storage electrode 24 of the memory capacitor and on the surface of the upper gate electrode 30.

A resist process of the photolithography technique and a RIE using CHF₃/He as the etching gas are carried out to selectively etch the upper gate insulator layer 29, the lower gate insulator layer 16, the insulator layer 7 and the gate insulator layer 3, and to form a ground line contact hole 27A shown in FIG.17C.

Then, a CVD is carried out to form a sixth polysilicon layer having a thickness of 1000 Å, for example.

A thermal diffusion process is carried out to diffuse P in the sixth polysilicon layer with an impurity concentration of 1 x 10²¹ cm⁻³, for example.

A resist process of the photolithography technique and a RIE using CCl₄/O₂ as the etching gas are carried out to pattern the sixth polysilicon layer and to form an opposing electrode 28 of the memory capacitor. This opposing electrode 28 is used in common as a ground line.

In FIGS.16H and 17E, a CVD is carried out to form an insulator layer which is made of SiO₂ and has a thickness of 1000 Å, for example, and an insulator layer which is made of PSG and has a thickness of 5000 Å, for example. These two insulator layers are shown as an insulator layer 25 in FIG.16H.

Then, a thermal process is carried out to reflow and planarize the insulator layer 25.

A resist process of the photolithography technique and a RIE using CHF₃/He as the etching gas are carried out to selectively etch the insulator layer 25 and the like, and to form a bit line contact hole.

Thereafter, a sputtering is carried out to form an Al layer having a thickness of 1 µm, for example, and this Al layer is patterned into a bit line 26 by using the normal photolithography technique.

FIG.17F is a plan view showing the essential part of the double gate structure TFT load type SRAM which is completed by the above described processes. In FIG.17F, the illustration of the Al bit line 26 shown in FIGS.16H and 17E is omitted for the sake of convenience, so as to simplify the drawing. From FIG.17F, it is possible to clearly see the mutual relationship of the pattern of the opposing electrode 28 of the memory capacitor, which also functions as the ground line, and the patterns at other regions of the SRAM.

Generally, if a memory capacitor is independently provided in the double gate structure TFT load type SRAM, one mask process is additionally required to form the opposing electrode. However, according to the seventh embodiment, the opposing electrode and the ground line are used in common. As a result, there is no increase in the number of mask processes as a whole. On the other hand, because the contact hole 31A for connecting the TFT load and the driver transistor is formed in one mask process as described in conjunction with FIG.16D, the number of mask processes decreases by two when compared to the prior art described in conjunction with FIGS.7A through 7C.

FIG.18 is a plan view generally showing an essential part of a TFT load type SRAM. FIG.18 shows a gate 41 of the TFT load, a channel 42 of the TFT load, a word line 43 (WL) and a supply line Vcc for supplying the positive power source voltage Vcc.

According to the SRAM shown in FIG.18, the driver transistors and the TFT loads are arranged in a symmetrical manner, thereby making it possible to design the layout with ease. Hence, a description will hereunder be given of an eighth embodiment of the semiconductor memory device according to the present invention which is applied to the TFT load type SRAM shown in FIG.18.

Next, a description will be given of an eighth embodiment of the semiconductor memory device according to the present invention which is produced by an eighth embodiment of the method of producing the semiconductor memory device according to the present invention. FIGS.19A through 19J are side views in cross section showing an essential part of the eighth embodiment of the semiconductor memory device according to the present invention at essential stages of the eighth embodiment of the method of producing the semiconductor memory device according to the present invention. FIGS.19A through 19J respectively are cross sections taken along a line X-X in FIG.18.

In FIG.19A, a pad layer made of SiO₂ covering an active region of a Si semiconductor substrate 51 and an oxidation resistant mask layer made of Si₃N₄ formed on the pad layer are used to carry out a selective thermal oxidation to form a field insulator layer 52 which is made of SiO₂ and has a thickness of 4000 Å, for example.

After exposing the active region by removing the oxidation resistant mask layer and the pad layer, a thermal oxidation is carried out to form a gate insulator layer 53 which is made of SiO₂ and has a thickness of 100 Å, for example.

A resist process of the photolithography technique and a wet etching using hydrofluoric acid as the etchant are carried out to selective etch the gate insulator layer 53 and to form a contact hole 53A which is also used when diffusing impurities.

A CVD is carried out to form a first polysilicon layer having a thickness of 1000 Å, for example.

Then, a vapor phase diffusion is carried out to introduce P with an impurity concentration of 1 x 10²⁰ cm⁻³, for example, so as to form an n⁺-type impurity region 54.

A resist process of the photolithography technique and a RIE using CCl₄/O₂ as the etching gas are carried out to pattern the first polysilicon layer and to form gate electrodes 55 and 56.

An ion implantation is carried out to inject As ions into the first polysilicon layer with a dosage of 1 x 10¹⁵ cm⁻² and an acceleration energy of 30 keV, for example, so as to form an n⁺-type source region 57 and an n⁺-type drain region 58.

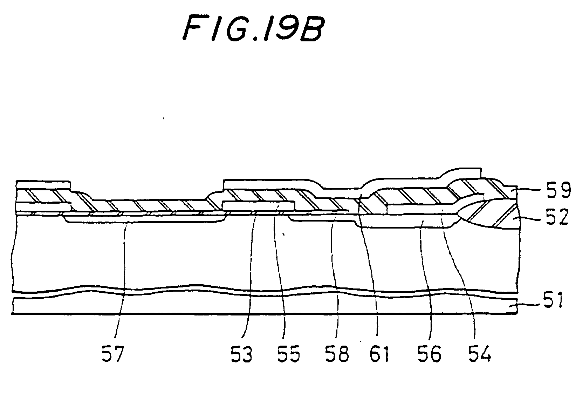

In FIG.19B, a CVD is carried out to form an insulator layer 59 which is made of SiO₂ and has a thickness of 1000 Å, for example.

Then, a CVD is carried out to form a second polysilicon layer having a thickness of 1000 Å, for example.

A vapor phase diffusion is carried out to introduce P into the second polysilicon layer with an impurity concentration of 1 x 10²⁰ cm⁻³, for example.

Next, a resist process of the photolithography technique and a RIE using CCl₄/O₂ as the etching gas are carried out to pattern the second polysilicon layer and to form a lower gate electrode 61 of the TFT load and the like.

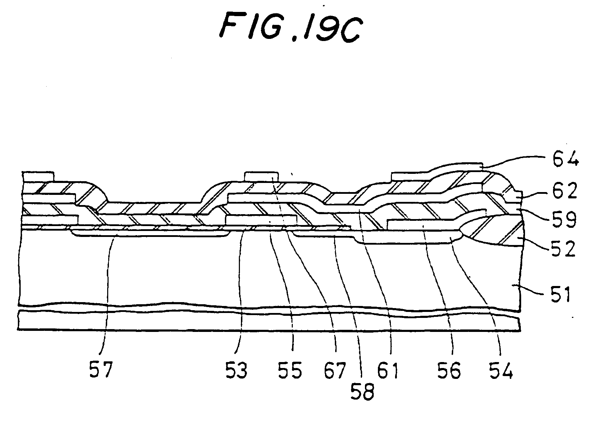

In FIG.19C, a CVD is carried out to form a lower gate insulator layer 62 of the TFT load, which is made of SiO₂ and has a thickness of 200 Å, for example.

Then, a CVD is carried out to form a third polysilicon layer having a thickness of 200 Å, for example.

A resist process of the photolithography technique and an ion implantation are carried out to inject B ions with a dosage of 1 x 10¹⁴ cm⁻² and an acceleration energy of 5 keV, for example, into parts of the third polysilicon layer where source and drain regions of the TFT load and a Vcc supply line are formed.

A resist process of the photolithography technique and a RIE using CCl₄/O₂ as the etching gas are carried out to pattern the third polysilicon layer and to form a contact part, a drain region, a source region and a channel region of each TFT load, and the Vcc supply line. In FIG.19C, only a contact part 64 which connects to a source region of a TFT load and a channel region 67 of an adjacent TFT load can be seen.

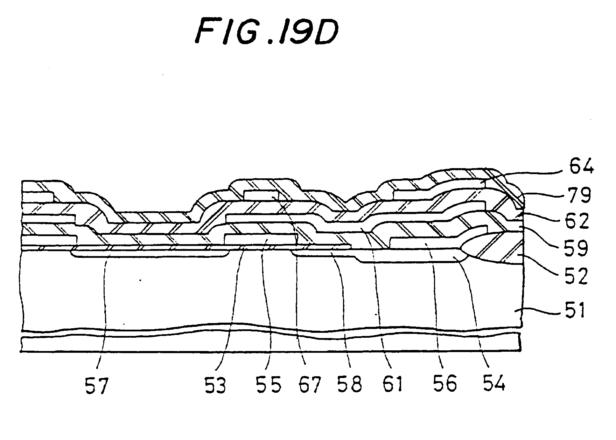

In FIG.19D, a CVD is carried out to form an upper gate insulator layer 79 which is made of Si₃N₄ and has a thickness of 500 Å, for example.

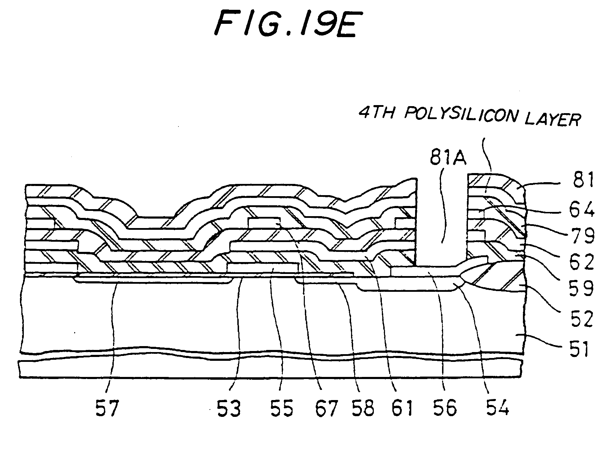

In FIG.19E, a CVD is carried out to form a fourth polysilicon layer having a thickness of 500 Å, for example.

Then, a vapor phase diffusion is carried out to introduce P into the fourth polysilicon layer with an impurity concentration of 1 x 10²⁰ cm⁻³, for example.

A CVD is carried out to form an insulator layer 81 which is made of SiO₂ and has a thickness of 500 Å, for example. This insulator layer 81 functions as a spacer.

A resist process of the photolithography technique and RIEs using CHF₃/He and CCl₄/O₂ as the etching gases are carried out to selectively etch the insulator layer 81, the fourth polysilicon layer, the upper gate insulator layer 79 of the TFT load, the contact part 64 formed from the third polysilicon layer, the lower gate insulator layer 62 of the TFT load, the lower gate electrode 61 of the TFT load formed from the second polysilicon layer and the insulator layer 59, and to form a contact hole 81A. The CHF₃/He etching gas is used to etch the SiO₂ and the Si₃N₄, while the CCl₄/O₂ etching gas is used to etch the polysilicon. The contact hole 81A extends from the top surface of the insulator layer 81 and reaches the top surface of the gate electrode 56 (or 55) of the driver transistor formed from the first polysilicon layer.

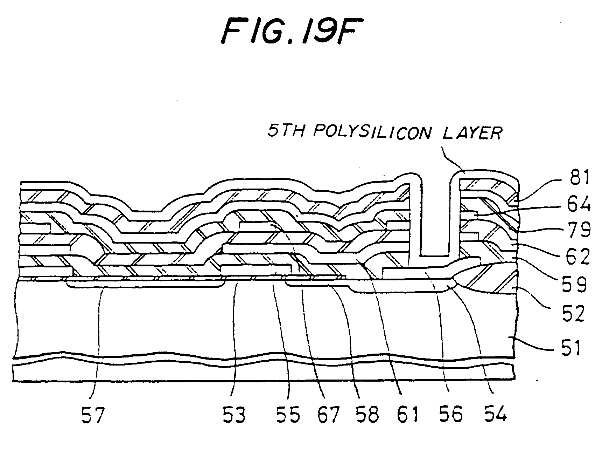

In FIG.19F, a CVD is carried out to form a fifth polysilicon layer having a thickness of 500 Å, for example.

Then, a thermal diffusion process is carried out to diffuse P in the fifth polysilicon layer with an impurity concentration of 1 x 10²¹ cm⁻³.

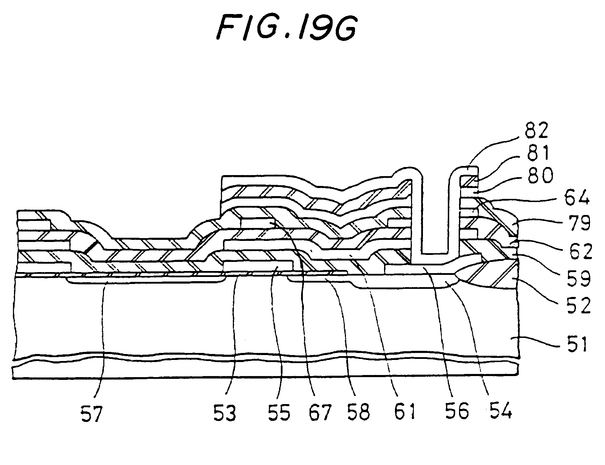

In FIG.19G, a resist process of the photolithography technique and RIEs using CCl₄/O₂ and CHF₃/He as the etching gases are carried out to pattern the fifth polysilicon layer, the insulator layer 81 and the fourth polysilicon layer, and to form a storage electrode 82 of the memory capacitor and an upper gate electrode 80 of the TFT load. The CCl₄/O₂ etching gas is used to etch the polysilicon, while the CHF₃/He etching gas is used to etch the SiO₂. The upper gate electrode 80 is used in common as a fin of the memory capacitor.

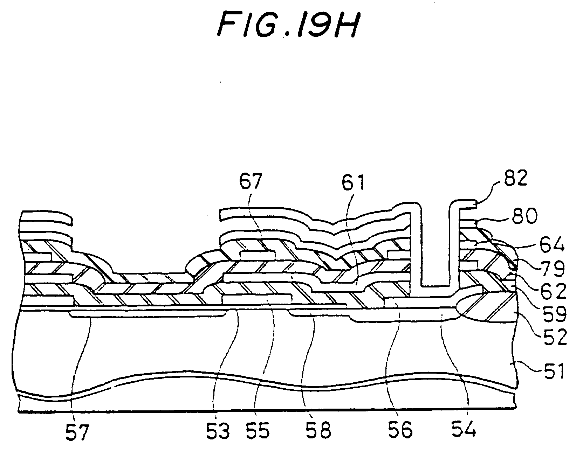

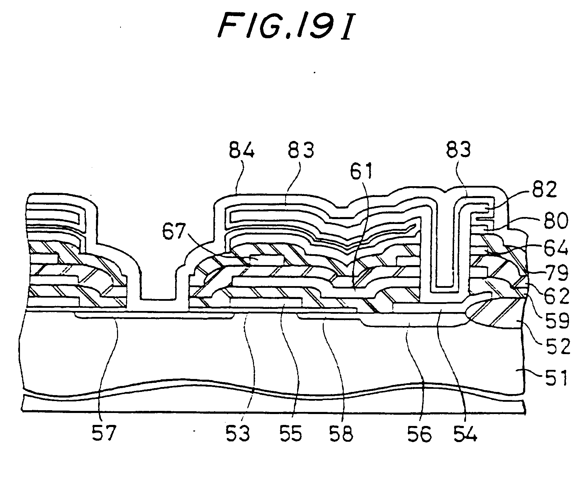

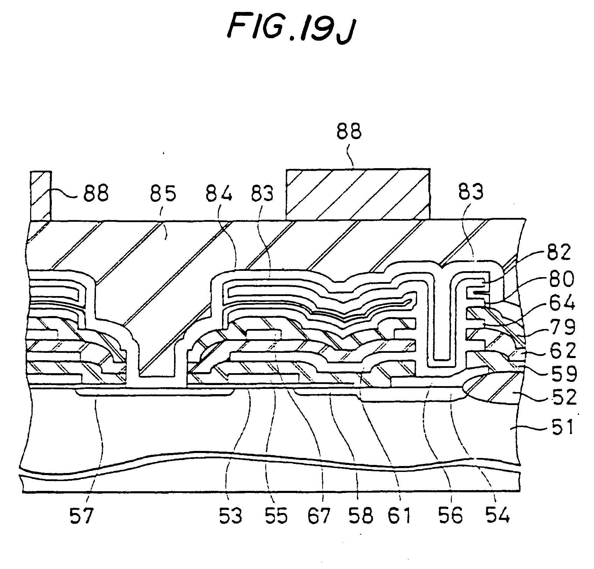

In FIG.19H, the structure described above is submerged in a HF solution to remove the SiO₂ insulator layer 81.

In FIGS.19I, a CVD is carried out to form a dielectric layer 83 which is made of Si₃N₄ and has a thickness of 200 Å, for example, on the storage electrode 82 and the surface of the upper gate electrode 80 of the TFT load.

Next, a resist process of the photolithography technique and a RIE using CHF₃/He as the etching gas are carried out to selectively etch the dielectric layer 83, the upper gate insulator layer 79 of the TFT load, the lower gate insulator layer 62 of the TFT load, the insulator layer 59 and the gate insulator layer 53 of the driver transistor, and to form a ground line contact hole.

Then, a CVD is carried out to form a sixth polysilicon layer having a thickness of 1000 Å, for example.

A thermal diffusion process is carried out to diffuse P in the sixth polysilicon layer with an impurity concentration of 1 x 10²¹ cm⁻³, for example.

A resist process of the photolithography technique and a RIE using CCl₄/O₂ as the etching gas are carried out to pattern the sixth polysilicon layer and to form an opposing electrode 84 of the memory capacitor. This opposing electrode 84 is used in common as a ground line.

In FIG.19J, a CVD is carried out to form an insulator layer which is made of SiO₂ and has a thickness of 1000 Å, for example, and an insulator layer which is made of PSG and has a thickness of 5000 Å, for example. In FIG.19J, these two insulator layers are shown as an insulator layer 85.

Then, a thermal process is carried out to reflow and planarize the insulator layer 85.

A resist process of the photolithography technique and a RIE using CHF₃/He as the etching gas are carried out to selectively etch the insulator layer 85 and the like, and to form a bit line contact hole which is shown in FIG.18.

A sputtering is carried out to form an Al layer having a thickness of 1 µm, for example, and this Al layer is patterned into a bit line 88 by using the normal photolithography technique.

According to this embodiment, the number of mask processes is reduced compared to that of the prior art, similarly as in the case of the seventh embodiment described with reference to FIGS.16A through 16H. In addition to those advantageous features of the seventh embodiment, this eighth embodiment has an additional advantage in that the driver transistor and the TFT load are arranged in a symmetrical manner, and the layout thereof is extremely easy to design.

In FIG.19I, the ground line contact hole is formed after forming the dielectric layer 83. However, it is possible to form a polysilicon layer after forming the dielectric layer 83 so as to protect the dielectric layer, and thereafter etch this polysilicon layer and the insulator layers 53, 59, 62 and 79 before forming the sixth polysilicon layer (84). According to this method, the dielectric layer 83 will not be subjected directly to the resist process or the like, and the insulator withstand voltage is improved.

Next, a description will be given of a ninth embodiment of the semiconductor memory device according to the present invention which is produced by a ninth embodiment of the method of producing the semiconductor memory device according to the present invention. FIGS.20A through 20C are side views in cross section showing an essential part of the ninth embodiment of the semiconductor memory device according to the present invention at essential stages of the ninth embodiment of the method of producing the semiconductor memory device according to the present invention. In FIGS.20A through 20C, those parts which are the same as those corresponding parts in FIGS.19A through 19J are designated by the same reference numerals, and a description thereof will be omitted.

In this embodiment of the method, the processes are the same as those of the eighth embodiment up to the processes shown in FIGS.19A through 19D, that is, until the insulator layer 79 is formed from Si₃N₄. Hence, a description will only be given of the processes carried out thereafter.

In FIG.20A, the double gate structure TFT load type SRAM already has on the Si semiconductor substrate 51 the field insulator layer 52, the gate insulator layer 53, the n⁺-type impurity region 54, the gate electrodes 55 and 56 of the driver transistors formed from the first polysilicon layer, the n⁺-type source region 57, the n⁺-type drain region 58, the insulator layer 59, the lower gate electrode 61 of the TFT load formed from the second polysilicon layer, the lower gate insulator layer 62 of the TFT load, the source region, the drain region and the channel region of the TFT load formed from the third polysilicon layer, and the upper gate insulator layer 79 which is made of Si₃N₄ and functions as an etching stopper.

A CVD is carried out to form a fourth polysilicon layer having a thickness of 500 Å, for example.

Then, a vapor phase diffusion is carried out to introduce P in the fourth polysilicon layer with an impurity concentration of 1 x 10²⁰ cm⁻³, for example.

A CVD is carried out to form an insulator layer 81 which is made of SiO₂ and has a thickness of 500 Å, for example. This insulator layer 81 functions as a spacer.

A CVD is carried out to form a fifth polysilicon layer having a thickness of 500 Å, for example.

Thereafter, a vapor phase diffusion is carried out to introduce P in the fifth polysilicon layer with an impurity concentration of 1 x 10²⁰ cm⁻³, for example.

A CVD is carried out to form an insulator layer 90 which is made of SiO₂ and has a thickness of 500 Å, for example. This insulator layer 90 functions as a spacer.

A resist process of the photolithography technique and RIEs using CHF₃/He and CCl₄/O₂ as the etching gases are carried out to selectively etch the insulator layer 90, the fifth polysilicon layer, the insulator layer 81, the fourth polysilicon layer, the upper gate insulator layer 79 of the TFT load, the third polysilicon layer, the lower gate insulator layer 62 of the TFT load, the lower gate electrode 61 of the TFT load formed from the second polysilicon layer and the insulator layer 59, and to form a contact hole 90A. The CHF₃/He etching gas is used to etch the SiO₂ and the Si₃N₄, while the CCl₄/O₂ etching gas is used to etch the polysilicon. The contact hole 90A extends from the top surface of the insulator layer 90 and reaches the top surface of the gate electrode 56 of the driver transistor formed from the first polysilicon layer.

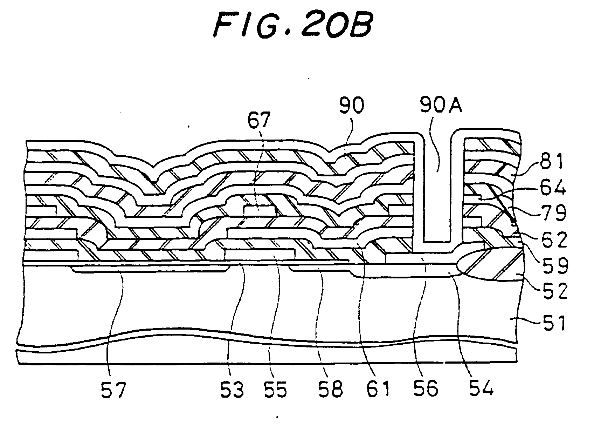

In FIG.20B, a CVD is carried out to form a sixth polysilicon layer having a thickness of 500 Å, for example.

Then, a thermal diffusion process is carried out to diffuse P in the sixth polysilicon layer with an impurity concentration of 1 x 10²¹ cm⁻³, for example.

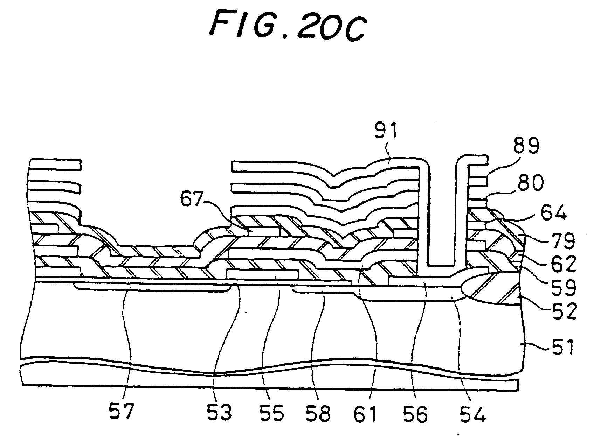

In FIG.20C, a resist process of the photolithography technique and RIEs using CCl₄/O₂ and CHF₃/He as the etching gases are carried out pattern the sixth polysilicon layer, the insulator layer 90, the fifth polysilicon layer, the insulator layer 81 and the fourth polysilicon layer, and to form a storage electrode 91 of the memory capacitor, a fin 89 of the memory capacitor, and an upper gate electrode 80 of the TFT load. This upper gate electrode 80 of the TFT load is used in common as a fin of the memory capacitor.

The above described structure is submerged in a HF solution to remove the SiO₂ insulator layers 90 and 81.

Thereafter, processes similar to those described above in conjunction with FIGS.19I and 19J of the eighth embodiment are carried out to form a dielectric layer of the memory capacitor and the like.

According to this embodiment, substantially three fins can be integrally formed on the storage electrode 91 of the memory capacitor, without increasing the number of mask processes. Hence, the capacitance of the memory capacitor can be increased considerably.

Next, a description will be given of a tenth embodiment of the semiconductor memory device according to the present invention which is produced by a tenth embodiment of the method of producing the semiconductor memory device according to the present invention. FIGS.21A through 21D are side views in cross section showing an essential part of the tenth embodiment of the semiconductor memory device according to the present invention at essential stages of the tenth embodiment of the method of producing the semiconductor memory device according to the present invention. In FIGS.21A through 21D, those parts which are the same as those corresponding parts in FIGS.19A through 19J are designated by the same reference numerals, and a description thereof will be omitted.

In this embodiment of the method, the processes are the same as those of the eighth embodiment up to the processes shown in FIGS.19A through 19C, that is, until the third polysilicon layer is patterned to form the contact part, the drain, source and channel regions of the TFT load and the Vcc line. Hence, a description will only be given of the processes carried out thereafter.

In FIG.21A, the double gate structure TFT load type SRAM already has on the Si semiconductor substrate 51 the field insulator layer 52, the gate insulator layer 53, the n⁺-type impurity region 54, the gate electrodes 55 and 56 of the driver transistors formed from the first polysilicon layer, the n⁺-type source region 57, the n⁺-type drain region 58, the insulator layer 59, the lower gate electrode 61 of the TFT load formed from the second polysilicon layer, the lower gate insulator layer 62 of the TFT load, the source, drain and channel regions of the TFT load formed from the third polysilicon layer, and the Vcc supply line.

A CVD is carried out to form an upper gate insulator layer 92 of the TFT load. This upper gate insulator layer 92 is made of SiO₂ and has a thickness of 500 Å.

Then, a CVD is carried out to form a fourth polysilicon layer having a thickness of 500 Å, for example.

A vapor phase diffusion is carried out to introduce P in the fourth polysilicon layer with an impurity concentration of 1 x 10²⁰ cm⁻³, for example.

A resist process of the photolithography technique and a RIE using CCl₄/O₂ as the etching gas are carried out to pattern the fourth polysilicon layer and to form an upper gate electrode 93 of the TFT load.

In FIG.21B, a CVD is carried out to form an insulator layer 94 which is made of Si₃N₄ and has a thickness of 500 Å, for example, and an insulator layer 95 which is made of SiO₂ and has a thickness of 500 Å, for example. The insulator layer 94 functions as an etching stopper, and the insulator layer 95 functions as a spacer.

Then, a resist process of the photolithography technique and RIEs using CHF₃/He and CCl₄/O₂ as the etching gases are carried out to selectively etch the insulator layers 95 and 94, the upper gate electrode 93 of the TFT load, the upper gate insulator layer 92 of the TFT load, the third polysilicon layer in which the source and drain regions of the TFT load are formed, the lower gate insulator layer 62 of the TFT load, the lower gate electrode 61 of the TFT load and the insulator layer 59, and to form a contact hole 95A. The CHF₃/He etching gas is used to etch the SiO₂ and the Si₃N₄, while the CCl₄/O₂ etching gas is used to etch the polysilicon. The contact hole 95A extends from the top surface of the insulator layer 95 and reaches the top surface of the gate electrode 56 of the driver transistor formed from the first polysilicon.

In FIG.21C, a CVD is carried out to form a fifth polysilicon layer having a thickness of 500 Å, for example.

Then, a thermal diffusion process is carried out to diffuse P in the fifth polysilicon layer with an impurity concentration of 1 x 10²¹ cm⁻³, for example.

A resist process of the photolithography technique and a RIE using CCl₄/O₂ as the etching gas are carried out to pattern the fifth polysilicon layer and to form a storage electrode 96 of the memory capacitor.

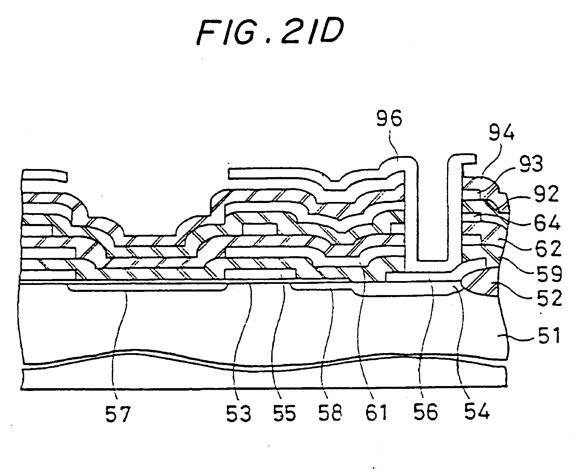

In FIG.21D, the structure described above is submerged into a HF solution to remove the SiO₂ insulator layer 95.

Thereafter, processes similar to those described above in conjunction with FIGS.19I and 19J of the eighth embodiment are carried out to form a dielectric layer of the memory capacitor and the like.

Normally, when etching the polysilicon, the underlying layer is suited as an etching stopper if this underlying layer is made of SiO₂ rather than Si₃N₄. In addition, the Si₃N₄ layer which functions as the etching stopper in the hydrofluoric acid is not damaged by the RIE is carried out to etch the polysilicon layer because the Si₃N₄ layer is not subjected to the RIE. Hence, this embodiment has an. advantage in that the formation of the storage electrode of the memory capacitor is facilitated and is stably carried out compared to the eighth embodiment. On the other hand, the number of mask processes increases by one compared to the eighth embodiment, but the number of mask processes as a whole is still reduced by one compared to that of the prior art.

Next, a description will be given of a twelfth embodiment of the semiconductor memory device according to the present invention which is produced by a twelfth embodiment of the method of producing the semiconductor memory device according to the present invention. FIGS.22A through 22G are side views in cross section showing an essential part of the twelfth embodiment of the semiconductor memory device according to the present invention at essential stages of the twelfth embodiment of the method of producing the semiconductor memory device according to the present invention. In FIGS.22A through 22G, those parts which are the same as those corresponding parts in FIGS.1A through 1J are designated by the same reference numerals, and a description thereof will be omitted. FIGS.22A through 22G respectively correspond to cross sections similar to the cross sections taken along a line Y-Y in FIG.5D.

In this embodiment of the method, the processes are the same as those of the prior art up to the processes shown in FIGS.1A through 1F, that is, until the formation of the ground line 8 from the second polysilicon layer. Hence, a description will only be given of the processes carried out thereafter.

In FIG.22A, the TFT load type SRAM already has on the Si semiconductor substrate 1 the field insulator layer 2, the gate insulator layer 3, the gate electrode 4 of the driver transistor formed from the first polysilicon layer, the n⁺-type impurity region 5', the n⁺-type source region 5, the n⁺-type drain region 6, the insulator layer 7 made of SiO₂, and the ground line 8 formed from the second polysilicon layer.

A CVD is carried out for form an insulator layer 9 which is made of SiO₂ and has a thickness of 1000 Å, for example.

Then, a CVD is carried out to form a third polysilicon layer having a thickness of 500 Å, for example.

An ion implantation is carried out to inject P ions into the third polysilicon layer with a dosage of 1 x 10¹⁵ cm⁻² and an acceleration energy of 10 keV, for example.

A resist process of the photolithography technique and a RIE using CCl₄/O₂ as the etching gas are carried out to pattern the third polysilicon layer and to form a gate electrode 15 of the TFT load.

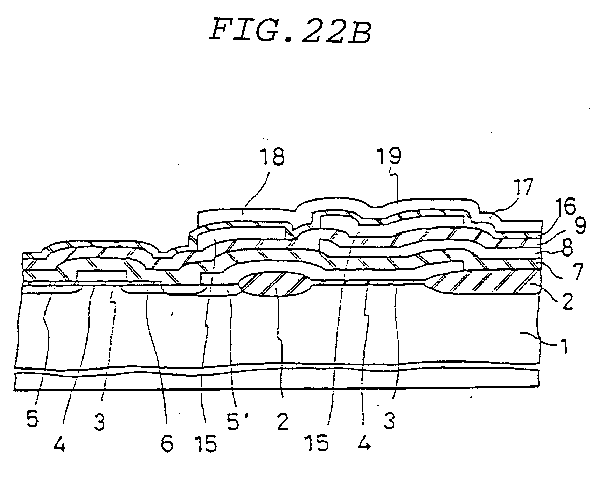

In FIG.22B, a CVD is carried out to form a gate insulator layer 16 of the TFT load, which is made of SiO₂ and has a thickness of 200 Å, for example.

Then, a CVD is carried out to form a fourth polysilicon layer having a thickness of 200 Å, for example.

A resist process of the photolithography technique and an ion implantation are carried out to inject B ions with a dosage of 1 x 10¹⁴ cm⁻² and an acceleration energy of 5 keV, into parts of the fourth polysilicon layer where source and drain regions of the TFT load are formed.

A resist process of the photolithography technique and a RIE using CCl₄/O₂ as the etching gas are carried out to pattern the fourth polysilicon layer and to form a source region 17, a drain region n18 and a channel region 19 of the TFT load, and a Vcc supply line. The Vcc supply line cannot be seen in FIG.22B.

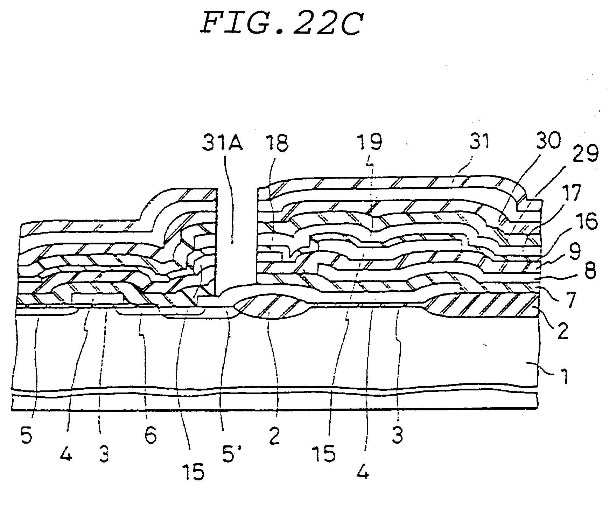

In FIG.22C, a CVD is carried out to form on the entire surface an insulator layer 29 which is made of Si₃N₄ and has a thickness of 500 Å, for example. In addition, a CVD is carried out to form an insulator layer 30 which is made of SiO₂ and has a thickness of 500 Å, for example.

Then, a CVD is carried out to form a fifth polysilicon layer having a thickness of 500 Å, for example.

An ion implantation is carried out to inject P ions into the fifth polysilicon layer with a dosage of 1 x 10¹⁵ cm⁻² and an acceleration energy of 10 keV.

A CVD is carried out to form on the entire surface an insulator layer 31 which is made of SiO₂ and has a thickness of 500 Å, for example.

A resist process of the photolithography technique and RIEs using CHF₃/He and CCl₄/O₂ as the etching gases are carried out to selectively etch the insulator layer 31, the fifth polysilicon layer, the insulator layer 29, the drain region 18 of the TFT load formed from the fourth polysilicon layer, the gate insulator layer 16, the gate electrode 15 formed from the third polysilicon layer, the insulator layer 9 and the insulator layer 7, and to form a contact hole 31A. The CHF₃/He etching gas is used to etch the SiO₂ and the Si₃N₄, and the CCl₄/O₂ etching gas is used to etch the polysilicon. The contact hole 31A extends from the top surface of the insulator layer 31 and reaches the top surface of the gate electrode 4 of the driver transistor formed from the first polysilicon layer.

This process forms an essential part of this twelfth embodiment. In other words, the number of mask processes related to the formation of the contact hole 31A is reduced by two compared to that of the eleventh embodiment.

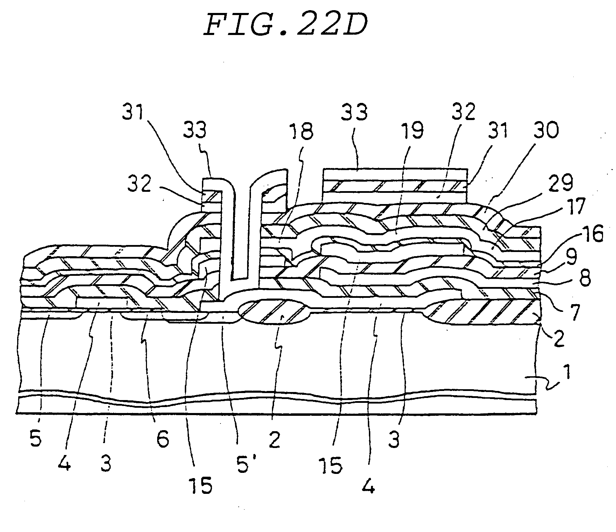

In FIG.22D, a CVD is carried out to form a sixth polysilicon layer having a thickness of 500 Å, for example.

Then, a thermal diffusion process is carried out to diffuse P in the sixth polysilicon layer with an impurity concentration of 1 x 10²¹ cm⁻³, for example.

A resist process of the photolithography technique and RIEs using CCl₄/O₂ and CHF₃/He as the etching gases are carried out to pattern the sixth polysilicon layer, the insulator layer 31 and the fifth polysilicon layer, and to form a storage electrode 33 of the memory capacitor and a fin 32 of the memory capacitor. The CCl₄/O₂ etching gas is used to etch the polysilicon, and the CHF₃/He etching gas is used to etch the SiO₂.

When carrying out this etching, it is possible to make a sufficient over-etching, similarly as in the case of the eleventh embodiment. Hence, it is possible to stably form the fin 32.

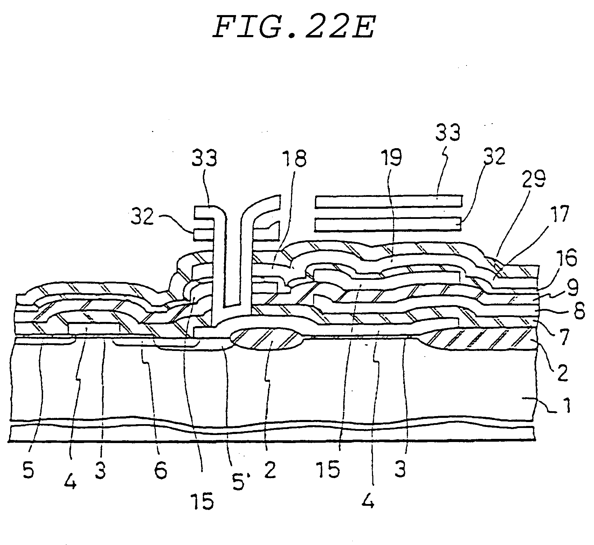

In FIG.22E, the above described structure is submerged in a HF solution so as to remove the SiO₂ insulator layers 31 and 30.

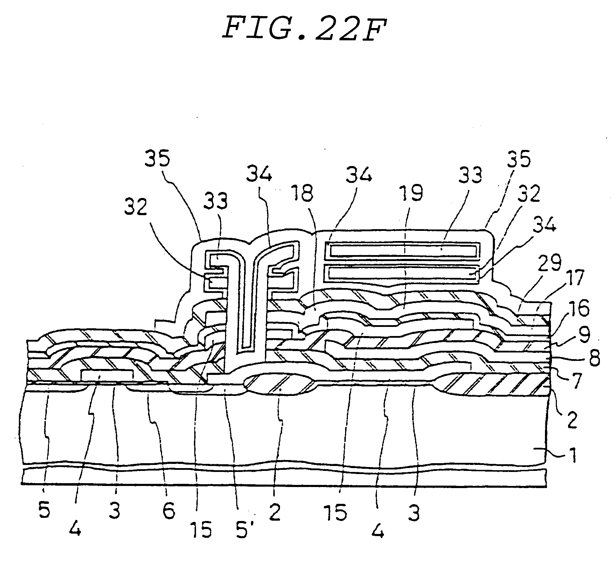

In FIG.22F, a CVD is carried out to form a dielectric layer which is made of Si₃N₄ and has a thickness of 200 Å, for example, on the storage electrode 33 of the memory capacitor and on the surface of the fin 32 of the memory capacitor.

Then, a CVD is carried out to form a seventh polysilicon layer having a thickness of 1000 Å, for example.

A thermal diffusion process is carried out to diffuse P in the seventh polysilicon layer with an impurity concentration of 1 x 10²¹ cm⁻³, for example.

A resist process of the photolithography technique and a RIE using CCl₄/O₂ as the etching gas are carried out to pattern the seventh polysilicon layer and to form an opposing electrode 35 of the memory capacitor. This opposing electrode 35 is used in common as a shield electrode.

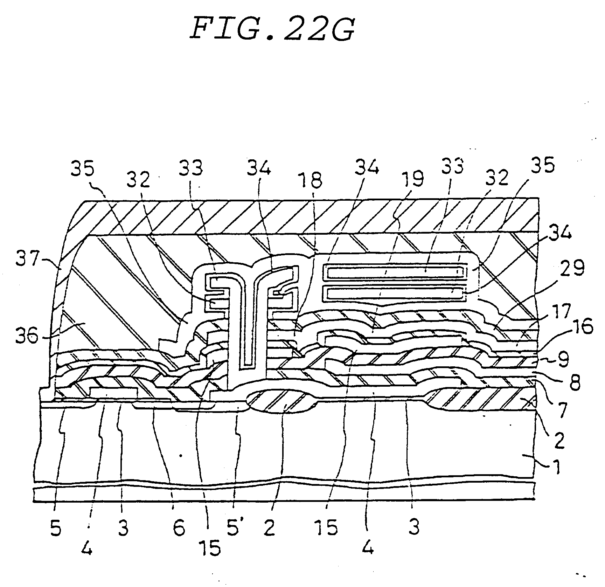

In FIG.22G, a CVD is carried out to form an insulator layer which is made of SiO₂ and has a thickness of 500 Å, for example, and an insulator layer which is made of PSG and has a thickness of 5000 Å, for example. These two insulator layers are shown as an insulator layer 36 in FIG.22G.

Then, a thermal process is carried out to reflow and planarize the insulator layer 36.

A resist process of the photolithography technique and a RIE using CHF₃ /He as the etching gas are carried out to selectively etch the insulator layer 36 and the like, and to form a bit line contact hole.

A sputtering is carried out to form an Al layer having a thickness of 1 µm, for example, and this Al layer is patterned into a bit line 37 using the normal photolithography technique.

This embodiment differs from the eleventh embodiment described above in that the contact hole 31A is formed so that the storage electrode 33 of the memory capacitor can make direct contact with the gate electrode 4 of the driver transistor. For this reason, the contact hole 31A can be formed in one mask process, and the number of mask processes can be reduced by two compared to that of the eleventh embodiment and by one compared to the prior art method of producing the double gate structure TFT load type SRAM. Hence, the production process can be simplified according to this twelfth embodiment. In addition, it is possible to stably form a memory capacitor having a sufficiently large capacitance while preventing the undesirable parasitic effect of the TFT load.

Next, a description will be given of a thirteenth embodiment of the semiconductor memory device according to the present invention which is produced by a thirteenth embodiment of the method of producing the semiconductor memory device according to the present invention. FIGS.23A through 23C are side views in cross section showing an essential part of the thirteenth embodiment of the semiconductor memory device according to the present invention at essential stages of the thirteenth embodiment of the method of producing the semiconductor memory device according to the present invention. In FIGS.23A through 23C, those parts which are the same as those corresponding parts in FIGS.22A through 22G are designated by the same reference numerals, and a description thereof will be omitted. FIGS.23A through 23C respectively correspond to cross sections similar to the cross sections taken along a line Y-Y in FIG.5D.

In this embodiment of the method, the processes are the same as those of the twelfth embodiment up to the processes shown in FIGS.22A through 22F, that is, until P is diffused in the seventh polysilicon layer to make is conductive. Hence, a description will only be given of the processes carried out thereafter.

In FIG.23A, the TFT load type SRAM already has on the Si semiconductor substrate 1 the field insulator layer 2, the gate insulator layer 3, the gate electrode 4 of the driver transistor formed from the first polysilicon layer, the n⁺-type impurity region 5', the n⁺-type source region 5, the n⁺-type drain region 6, the insulator layer 7 made of SiO₂, the ground line 8 formed from the second polysilicon layer, the insulator layer 9 made of SiO₂, the gate electrode 15 of the TFT load, the gate insulator layer 16 of the TFT load, the source region 17 of the TFT load, the drain region 18 of the TFT load, the fin 32 of the memory capacitor, the storage electrode 33 of the memory capacitor, the dielectric layer 34, and the seventh polysilicon layer which covers the entire surface.

A resist process of the photolithography technique is carried out to form a photoresist layer 38 which has a pattern for forming an opposing electrode of the memory capacitor, which opposing electrode is also to function as a shield electrode.

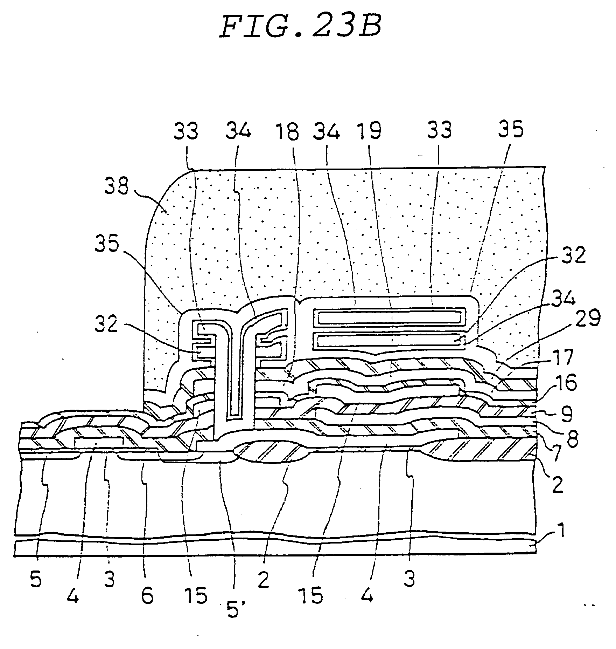

In FIG.23B, a RIE using CCl₄/O₂ as the etching gas is carried out to pattern the seventh polysilicon layer using the photoresist layer 38 as a mask, and to form an opposing electrode 35 of the memory capacitor. This opposing electrode 35 also functions as the shield electrode.

Then, a RIE using CF₄/O₂ as the etching gas is carried out in a state where the photoresist layer 38 remains, so as to pattern the Si₃N₄ insulator layer 29. As a result, at the insulator layer 29 which covers a part where a bit line contact hole is to be formed is removed.

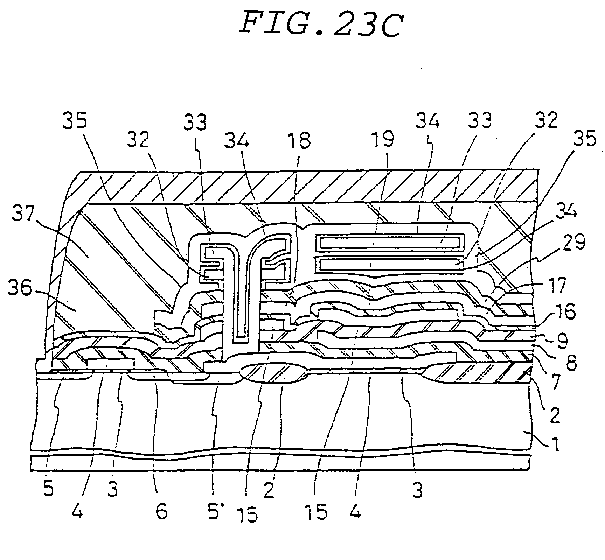

In FIG.23C, a CVD is carried out to form an insulator layer which is made of SiO₂ and has a thickness of 500 Å, for example, and an insulator layer which is made of PSG and has a thickness of 5000 Å, for example. These two insulator layers are shown as an insulator layer 36 in FIG.23C.

Then, a thermal process is carried out to reflow and planarize the insulator layer 36.

A resist process of the photolithography technique and a RIE using CHF₃/He as the etching gas are carried out to selectively etch the insulator layer 36 and the like, and to form the bit line contact hole.

A sputtering is carried out to form an Al layer having a thickness of 1 µm, for example, and this Al layer is patterned into a bit line 37 by using the normal photolithography technique.

According to this embodiment, the mask which is used to pattern the opposing electrode 35 is also used to pattern the Si₃N₄ insulator layer 29. Hence, the advantages which will be described hereunder are obtained when forming the bit line 37.

Next, a description will be given of the effects obtainable in the thirteenth embodiment, by referring to FIGS.24A through 24D.

In FIG.24A, a SiO₂ insulator layer 102, a Si₃N₄ insulator layer 103 and a PSG insulator layer 104 are successively stacked on a Si semiconductor substrate 101.

A resist process of the photolithography technique and a RIE using CHF₃/He as the etching gas are carried out to selectively etch the insulator layer 104 and the like using as a mask a photoresist layer 105 which has an opening 105A. By this selective etching, a contact hole 104A is formed. This contact hole 104A extends from the top surface of the insulator layer 104 and reaches the top surface of the Si semiconductor substrate 101.

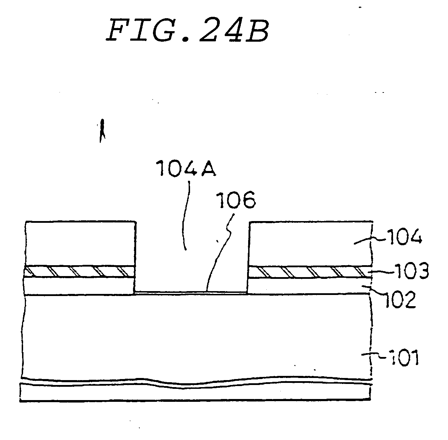

In FIG.24B, a plasma ashing is carried out to remove the photoresist layer 105 in oxygen plasma by the ashing. During this process, a thin oxide layer 106 is generated at the surface of the Si semiconductor substrate 101 exposed at the bottom of the contact hole 104A.

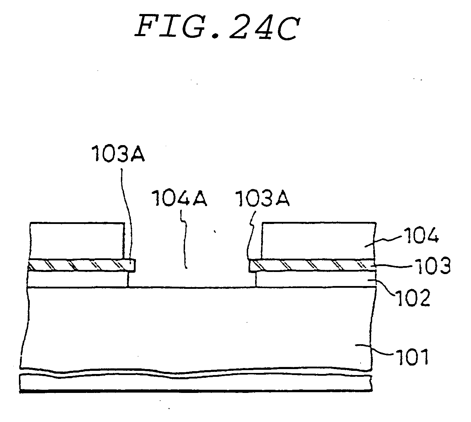

In FIG.24C, the above described structure is submerged in a HF solution to remove the thin oxide layer 106. In this case, the PSG insulator layer 104 and the SiO₂ insulator layer 102 are etched, and the side wall within the contact hole 104A recedes at these insulator layers 104 and 102. However, the Si₃N₄ insulator layer 103 will not be etched and thus projects within the contact hole 104A.

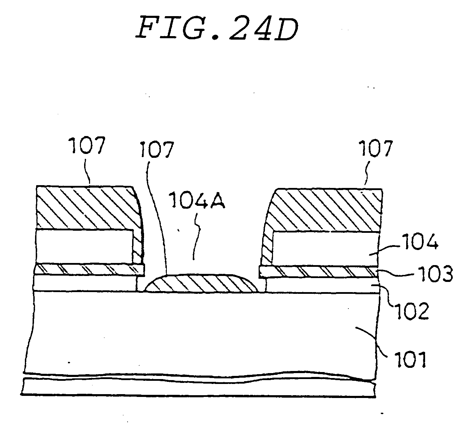

In FIG.24D, a sputtering is carried out to form an Al electrode/interconnection layer 107. In this case, the Al layer 107 may be disconnected within the contact hole 104A due to the Si₃N₄ insulator layer 103 which projects within the contact hole 104A.

The above phenomenon described in conjunction with FIGS.24A through 24D directly applies to the forming of the bit line contact hole of the TFT load type SRAM. However, according to the thirteenth embodiment, no Si₃N₄ insulator layer 29 exists at the part where the bit line contact hole is to be formed. In addition, the process of forming the opposing electrode 35 is used to remove the unwanted part of the Si₃N₄ insulator layer 29. Therefore, the number of production processes will not increase.

FIG.25 shows a plan view of a TFT load type SRAM which has a split word line structure. FIG.25 shows a gate 41 of the TFT load, a channel 42 of the TFT load, a word line 43 (WL), and a positive power source voltage supply line Vcc for supplying the positive power source voltage Vcc.

According to this SRAM shown in FIG.25, the driver transistors and the TFT loads are arranged in a symmetric manner. In addition, there are only two connection regions per memory cell, and the number of connection regions is reduced compared to that of the prior art. Accordingly, the layout of this SRAM can be designed with ease. Accordingly, a description will be given of a fourteenth embodiment of the semiconductor memory device according to the present invention which is applied to the SRAM shown in FIG.25.

Next, a description will be given of a fourteenth embodiment of the semiconductor memory device according to the present invention which is produced by a fourteenth embodiment of the method of producing the semiconductor memory device according to the present invention. FIGS.26A through 26J are side views in cross section showing an essential part of the fourteenth embodiment of the semiconductor memory device according to the present invention at essential stages of the fourteenth embodiment of the method of producing the semiconductor memory device according to the present invention. FIGS.26A through 26J are cross sections taken along a line which corresponds to a line X-X shown in FIG.25.

In FIG.26A, a pad layer made of SiO₂ covering an active region of a Si semiconductor substrate 51 and an oxidation resistant mask layer made of Si₃N₄ formed on the pad layer are used to carry out a selective thermal oxidation to form a field insulator layer 52 which is made of SiO₂ and has a thickness of 4000 Å, for example.

After exposing the active region by removing the oxidation resistant mask layer and the pad layer, a thermal oxidation is carried out to form a gate insulator layer 53 which is made of SiO₂ and has a thickness of 100 Å, for example.

A resist process of the photolithography technique and a wet etching using hydrofluoric acid as the etchant are carried out to selective etch the gate insulator layer 53 and to form a contact hole which is also used when diffusing impurities.

A CVD is carried out to form a first polysilicon layer having a thickness of 1000 Å, for example.

Then, a vapor phase diffusion is carried out to introduce P with an impurity concentration of 1 x 10²⁰ cm⁻³, for example, so as to form an n⁺-type impurity region 54.

A resist process of the photolithography technique and a RIE using CCl₄/O₂ as the etching gas are carried out to pattern the first polysilicon layer and to form gate electrodes 55 and 56.

An ion implantation is carried out to inject As ions into the first polysilicon layer with a dosage of 1 x 10¹⁵ cm⁻² and an acceleration energy of 30 keV, for example, so as to form an n⁺-type source region 57 and an n⁺-type drain region 58.

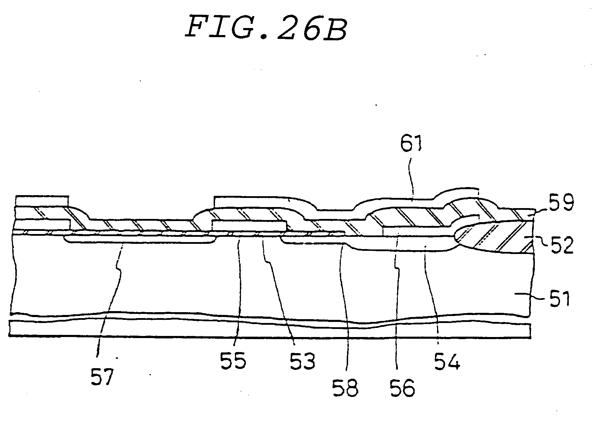

In FIGS.26B, a CVD is carried out to form an insulator layer 59 which is made of SiO₂ and has a thickness of 1000 Å, for example.

Then, a CVD is carried out to form a second polysilicon layer having a thickness of 1000 Å, for example.

A vapor phase diffusion is carried out to introduce P into the second polysilicon layer with an impurity concentration of 1 x 10²⁰ cm⁻³, for example.

Next, a resist process of the photolithography technique and a RIE using CCl₄/O₂ as the etching gas are carried out to pattern the second polysilicon layer and to form a lower gate electrode 61 of the TFT load and the like.

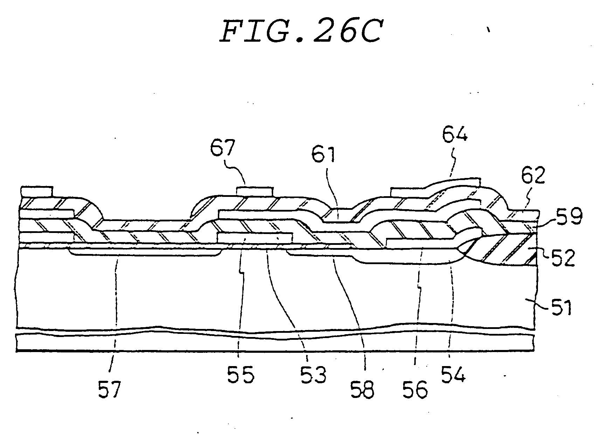

In FIG.26C, a CVD is carried out to form an insulator layer 62 which is made of SiO₂ and has a thickness of 200 Å, for example.

Then, a CVD is carried out to form a third polysilicon layer having a thickness of 200 Å, for example.

A resist process of the photolithography technique and an ion implantation are carried out to inject B ions with a dosage of 1 x 10¹⁴ cm⁻² and an acceleration energy of 5 keV, for example, into parts of the third polysilicon layer where source and drain regions of the TFT load and a Vcc supply line are formed.

A resist process of the photolithography technique and a RIE using CCl₄/O₂ as the etching gas are carried out to pattern the third polysilicon layer and to form a contact part, a drain region, a source region and a channel region of each TFT load, and the Vcc supply line. In FIG.26C, only a contact part 64 which connects to a tip end of a drain region of a TFT load and a channel region 67 of an adjacent TFT load can be seen.

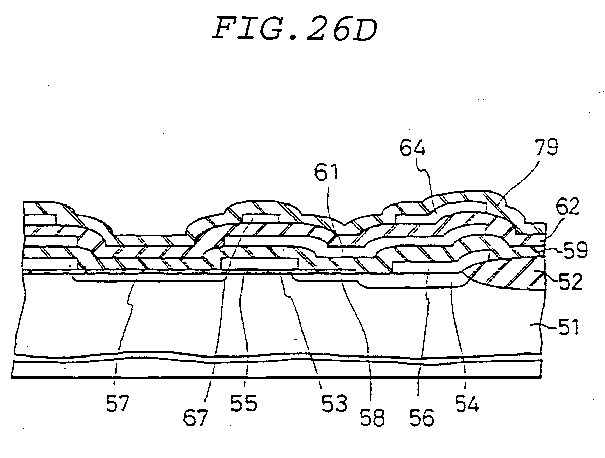

In FIG.26D, a CVD is carried out to form an insulator layer 79 which is made of Si₃N₄ and has a thickness of 500 Å, for example. This insulator layer 79 also functions as an etching stopper.

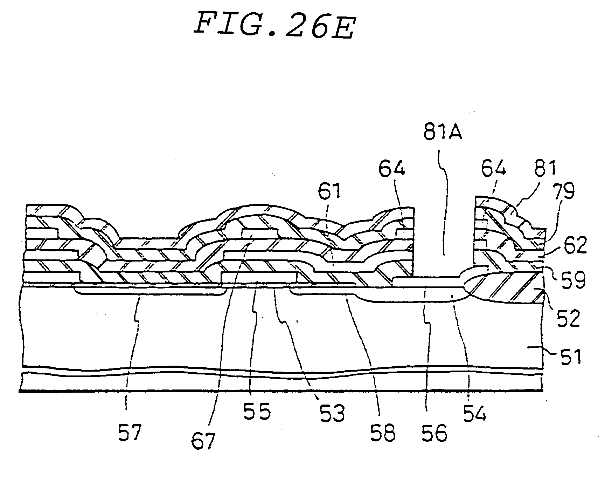

In FIG. 26E, a CVD is carried out to form an insulator layer 81 which is made of SiO₂ and has a thickness of 500 Å, for example.

A resist process of the photolithography technique and RIEs using CHF₃/He and CCl₄/O₂ as the etching gases are carried out to selectively etch the insulator layer 81, the insulator layer 79, the contact part 64 formed from the third polysilicon layer, the insulator layer 62, the gate electrode 61 of the TFT load formed from the second polysilicon layer and the insulator layer 59, and to form a contact hole 81A. The CHF₃/He etching gas is used to etch the SiO₂ and the Si₃N₄, while the CCl₄/O₂ etching gas is used to etch the polysilicon. The contact hole 81A extends from the top surface of the insulator layer 81 and reaches the top surface of the gate electrode 56 or 55 of the driver transistor formed from the first polysilicon layer.

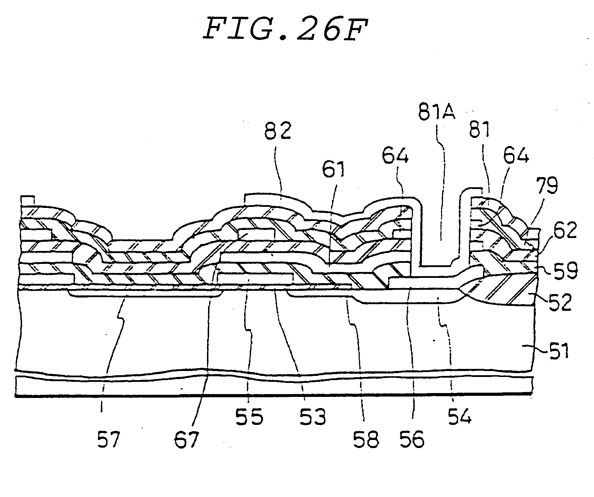

In FIG.26F, a CVD is carried out to form a fourth polysilicon layer having a thickness of 500 Å, for example.

Then, a thermal diffusion process is carried out to diffuse P in the fourth polysilicon layer with an impurity concentration of 1 x 10²¹ cm⁻³.

A resist process of the photolithography technique and an RIE using CCl₄/O₂ as the etching gas are carried out to pattern the fourth polysilicon layer and to form a storage electrode 82 of the memory capacitor.

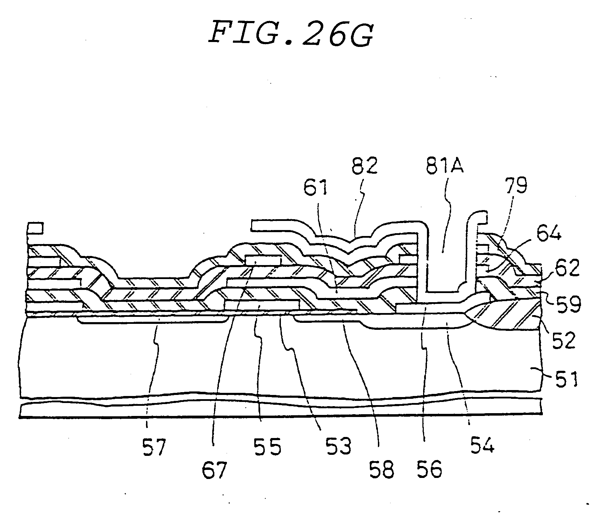

In FIG.26G, the structure described above is submerged in a HF solution to remove the SiO₂ insulator layer 81.

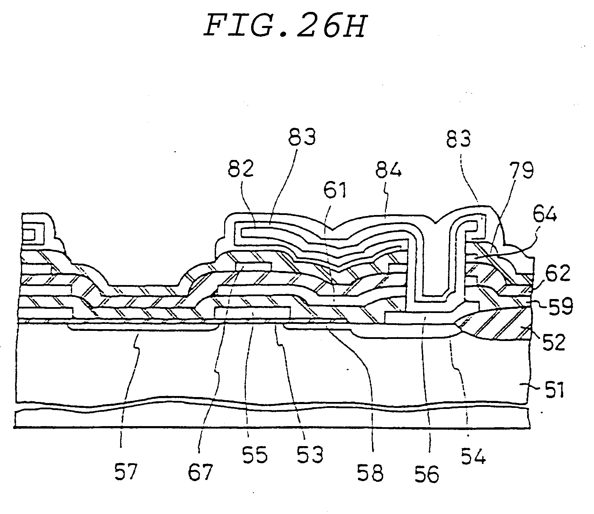

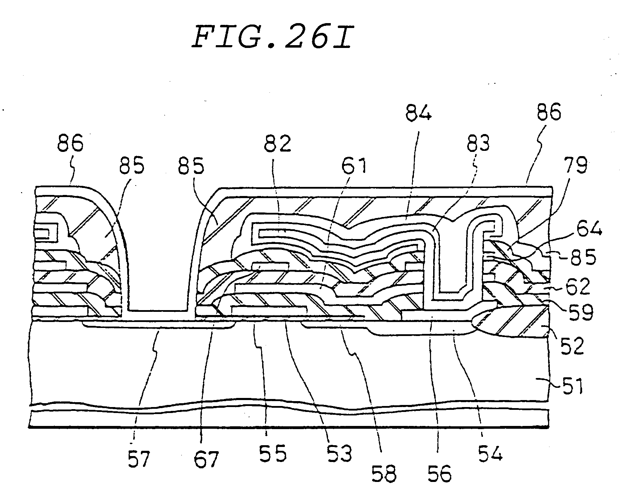

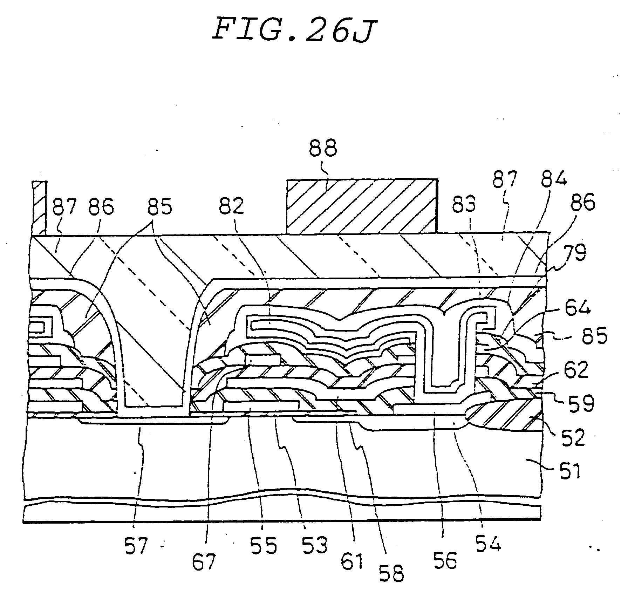

In FIG.26H, a CVD is carried out to form a dielectric layer 83 which is made of Si₃N₄ and has a thickness of 200 Å, for example, on the surface of the storage electrode 82.

Then, a CVD is carried out to form a fifth polysilicon layer having a thickness of 1000 Å, for example.

A thermal diffusion process is carried out to diffuse P in the fifth polysilicon layer with an impurity concentration of 1 x 10²¹ cm⁻³, for example.

A resist process of the photolithography technique and a RIE using CCl₄/O₂ as the etching gas are carried out to pattern the fifth polysilicon layer and to form an opposing electrode 84 of the memory capacitor.

In FIGS.26I, a CVD is carried out to form an insulator layer which is made of SiO₂ and has a thickness of 1000 Å, for example, and an insulator layer which is made of PSG and has a thickness of 5000 Å, for example. In FIG.26I, these two insulator layers are shown as an insulator layer 85.

A thermal process is carried out to reflow and planarize the insulator layer 85.

Thereafter, a resist process of the photolithography technique and a RIE using ^{CHF}3/He as the etching gas are carried out to selectively etch the insulator layer 85 and the like and to form a gr ound line contact hole which cannot be seen in FIG.26I.

A CVD is carried out to form a sixth polysilicon layer having a thickness of 1000 Å, for example.

Next, a thermal diffusion process is carried out to diffuse P in the sixth polysilicon layer with an impurity concentration of 1 x 10²¹ cm⁻³, for example.

A resist process of the photolithography technique and a RIE using CCl₄/O₂ as the etching gas are carried out to pattern the sixth polysilicon layer and to form a Vss supply line 86.

In FIG.26J, a CVD is carried out to form an insulator layer 87 which is made of PSG and has a thickness of 5000 Å, for example.

Then, a thermal process is carried out to reflow and planarize the insulator layer 87.

A resist process of the photolithography technique and a RIE using CCl₄/O₂ or the like as the etching gas are carried out selectively etch the insulator layer 87 and the like, and to form a bit line contact hole which cannot be seen in FIG.26J but can be seen in FIG.25.

A sputtering is carried out to form an Al layer having a thickness of 1 µm, for example, and this Al layer is patterned into a bit line 88 by using the normal photolithography technique.

According to this embodiment, the TFT load is also shielded by the opposing electrode 84 and the TFT load is unaffected by the noise. In addition, similarly as in the case of the twelfth embodiment, the number of mask processes can be reduced by one compared to the prior art method of producing the double gate structure TFT load type SRAM, and the capacitance of the memory capacitor can be made large. Furthermore, the symmetrical character of the memory cells in this embodiment is superior compared to that of the twelfth embodiment, and only two connection regions are required per memory cell, thereby making it possible to produce the SRAM with a simple process.

In the embodiments described above, the insulator layers made of SiO₂ and the polysilicon layers are etched during the process of forming the contact holes, such as the contact hole 23A shown in FIG.8C, the contact holes 31A shown in FIGS.9A, 16D, 23C, the contact holes 81A shown in FIGS.11E, 19E and 27E, the contact holes 90A shown in FIGS.13A and 20A, the contact holes 95A shown in FIGS.14B and 21B. However, the following problems may occur when penetrating the stacked structure which is made up of the insulator layers and polysilicon layers.

FIGS.27A through 27F are side views in cross section showing essential parts of a semiconductor memory device at essential stages of the production, for explaining the process of forming a contact hole which penetrates a stacked structure. In each of FIGS.27A through 27F, the left hand side shows the result of an expected process while the right hand side shows the result of an actual process, and the description will be given mainly with reference to the right hand side of FIGS.27A through 27F which shows the actual process.

In FIG.27A, a first conductor layer 932 made of polysilicon, a first insulator layer 933 made of SiO₂, a second conductor layer 934 made of polysilicon, a second insulator layer 935 made of SiO₂, a third conductor layer 936 made of polysilicon and a third insulator layer 937 made of SiO₂ are successively formed and stacked on a Si semiconductor substrate 931.

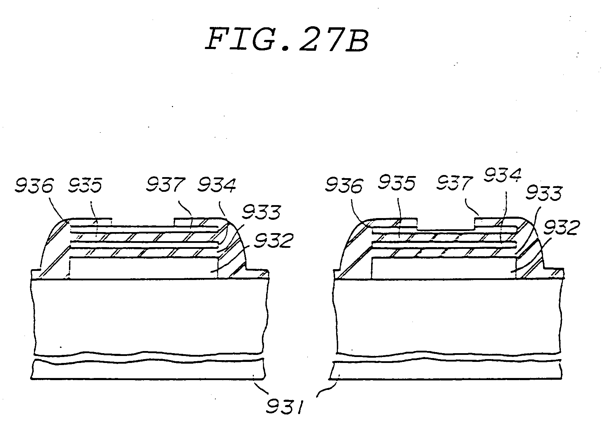

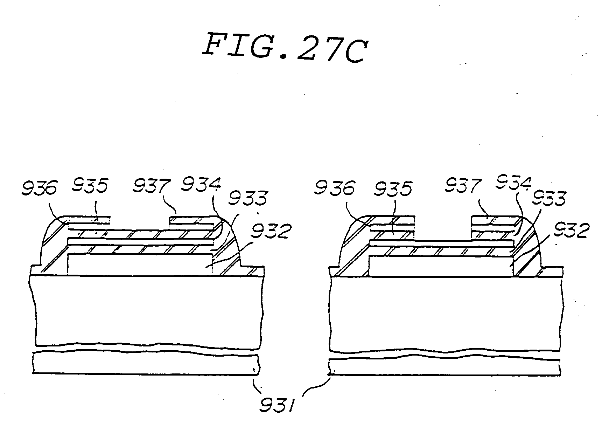

In FIG.27B, a resist process of the normal photolithography technique and a RIE using CHF₃/He as the etching gas are carried out to etch the third insulator layer 937 and to form a part of a contact hole. In FIG.27B, the illustration of a photoresist layer is omitted for the sake of convenience. The illustration of the photoresist layer will be omitted similarly in FIGS.27C through 27F which follow.

When etching the third insulator layer 937, a part of the underlying third conductor layer 936 is also etched. As a result, the remaining third conductor layer 936 becomes extremely thin when the third conductor layer 936 is thin to start with.

In FIG.27C, a RIE using CCl₄/O₂ as the etching gas is carried out to etch the third conductor layer 936.

Although dependent on the thickness of the underlying second insulator layer 935, the thickness of the second insulator layer 935 becomes extremely thin when the third conductor layer 936 is etched. In an extreme case, not only the second insulator layer 935 but also a part of the second conductor layer 934 may be etched when etching the third conductor layer 936.

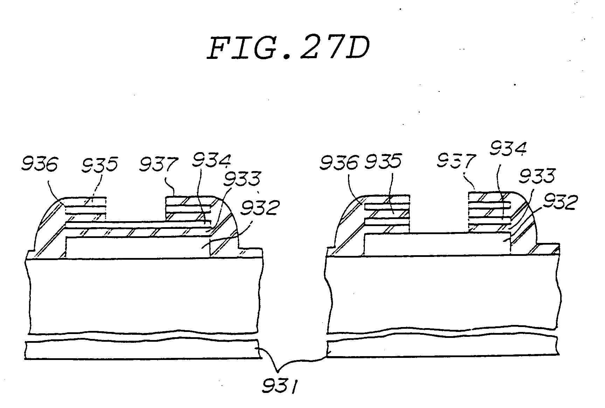

In FIG.27D, a RIE using CHF₃/He as the etching gas is carried out to etch the second insulator layer 935. However, although this etching is originally intended to etch the second insulator layer 935, the second insulator layer 935 may not exist from the start of this etching, for the reasons described above.

If the second insulator layer 935 is extremely thin or does not even exist at the start of this etching, the second conductor layer 934 and the first insulator layer 933 are etched although this etching is originally intended to etch the second insulator layer 935. When the second conductor layer 934 and the first insulator layer 933 are etched, the surface of the first conductor layer 932 may become exposed by this etching which is originally intended to etch the second insulator layer 935.

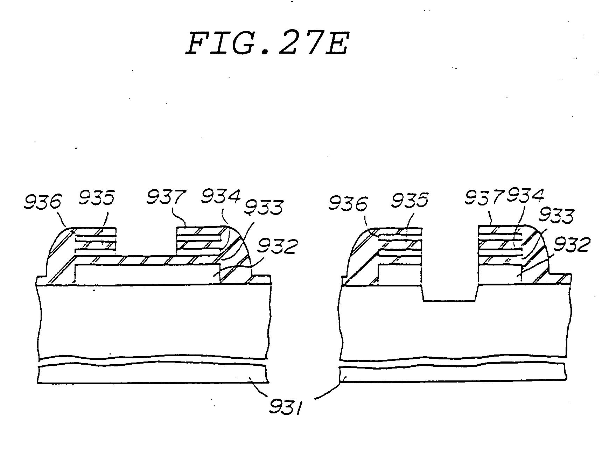

In FIG.27E, a RIE using CCl₄/O₂ as the etching gas is carried out to etch the second conductor layer 934.

However, although this etching is originally intended to etch the second conductor layer 934, the surface of the first conductor layer 932 may already be exposed as described above. In this case, even a part of the Si semiconductor substrate 931 may be etched by this etching which is originally intended to etch the second conductor layer 934.

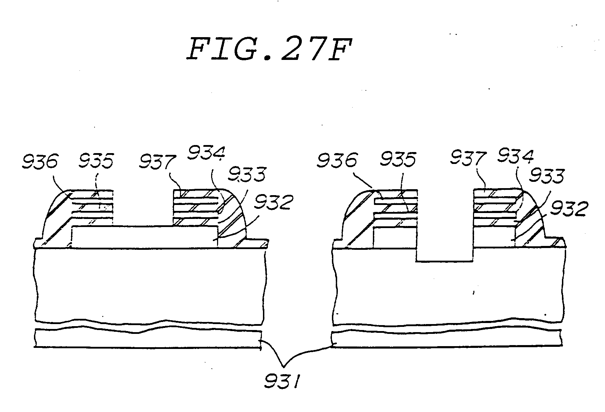

In FIG.27F, a RIE using CHF₃/He as the etching gas is carried out to etch the first insulator layer 933.

But although this etching is originally intended to etch the first insulator layer 933, a part of the Si semiconductor substrate 931 may already be etched as described above. In this case, the contact hole completely extends into the Si semiconductor substrate 931 as shown in FIG. 27F and the Si semiconductor substrate 931 is extremely damaged.

If the contact hole extends into the Si semiconductor substrate 931 as shown in FIG.27F, a leak is introduced at a node part between the driver transistor and the load transistor of the memory cell, and the operation of the memory cell becomes unstable. Hence, it is conceivable to carry out a moderate etching so as to etch only the originally intended layer, but such a moderate etching is difficult to control.

The etching of each layer cannot be controlled to etch only the originally intended layer by the moderate etching, because the contact hole is seldom formed at a flat part shown in FIGS.27A through 27F. In actual practice, the contact hole is usually formed at a stepped part, and an etching residue tends to remain at the stepped part within the contact hole. However, a sufficient over-etching becomes necessary in order to remove such an etching residue.

Next, a description will be given of a fifteenth embodiment of the semiconductor memory device according to the present invention which is produced by a fifteenth embodiment of the method of producing the semiconductor memory device according to the present invention. FIGS.28A through 28F are side views in cross section showing an essential part of the fifteenth embodiment of the semiconductor memory device according to the present invention at essential stages of the fifteenth embodiment of the method of producing the semiconductor memory device according to the present invention, for explaining the operating principle of the third embodiment. In each of FIGS.29A through 29F, the left hand side shows the result of an expected process while the right hand side shows the result of an actual process, and the description will be given mainly with reference to the right hand side of FIGS.28A through 28F which shows the actual process.

In this embodiment, measures are taken so that the contact hole will not extend into the substrate even when an over-etching is carried out to remove the etching residue within the contact hole.

In FIG.28A, a first conductor layer 142 made of polysilicon, a second conductor layer 143 made of a refractory metal such as W and Mo or a silicide thereof, a first insulator layer 144 made of SiO₂, a third conductor layer 145 made of polysilicon, a second insulator layer 146 made of SiO₂, a fourth conductor layer 147 made of polysilicon and a third insulator layer 148 made of SiO₂ are successively formed and stacked on a Si semiconductor substrate 141.

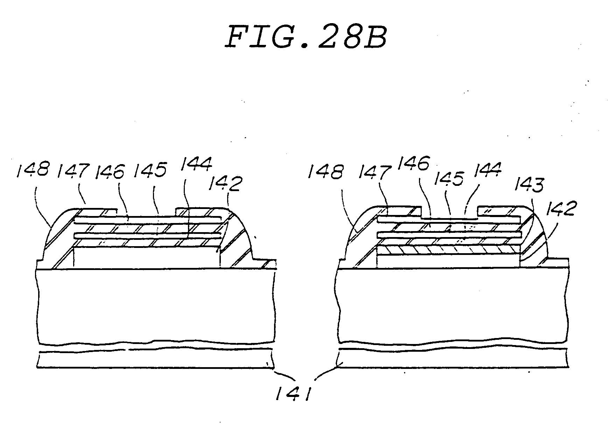

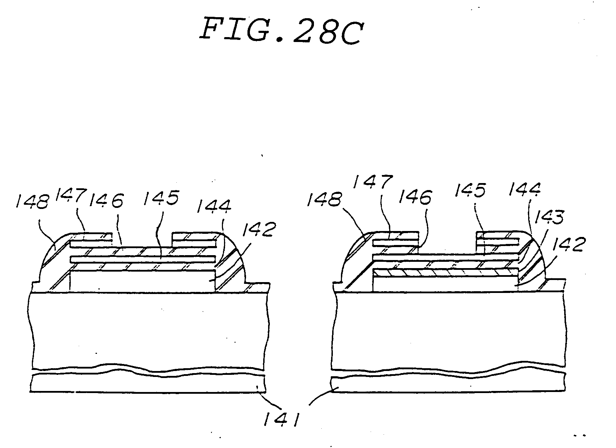

In FIG.28B, a resist process of the normal photolithography technique and a RIE using CHF₃/He as the etching gas are carried out to etch the third insulator layer 148 and to form a part of a contact hole. In FIG.28B, the illustration of a photoresist layer is omitted for the sake of convenience. The illustration of the photoresist layer will be omitted similarly in FIGS.28C through 28F which follow.

During this process, a part of the fourth conductor layer 147 underlying the third insulator layer 148 is also etched. Accordingly, the thickness of the fourth conductor layer 147 remaining after this etching is also extremely small, similarly as in the case described above with reference to FIGS.28A through 28F.

In FIG.28C, a RIE using HBr/Ar as the etching gas is carried out to etch the fourth conductor layer 147.

In this case, although dependent on the thickness of the second insulator layer 146 underlying the fourth conductor layer 147, the thickness of the second insulator layer 146 would be reduced by this etching. In an extreme case, not only the second insulator layer 146 but also a part of the third conductor layer 145 becomes etched by this etching which is originally intended to etch the fourth conductor layer 147.

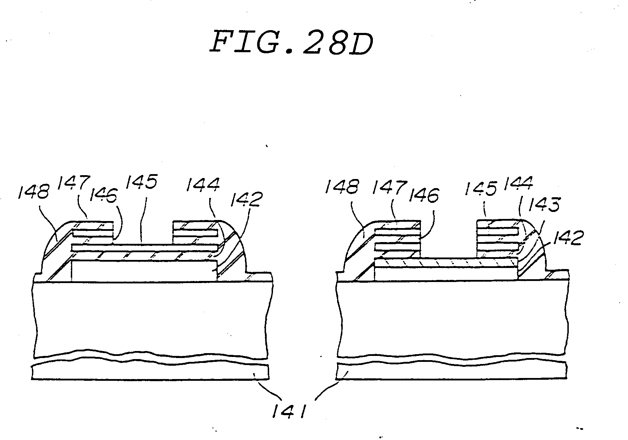

In FIG.28D, a RIE using CHF₃/He as the etching gas is carried out to etch the second insulator layer 146.

However, the thickness of the second insulator layer 146 is already reduced to start with and may not even exist in an extreme case, as described above. Hence, although this etching is originally intended to etch the second insulator layer 146, the third conductor layer 145 and the first insulator layer 144 may be etched to expose the surface of the second conductor layer 143.

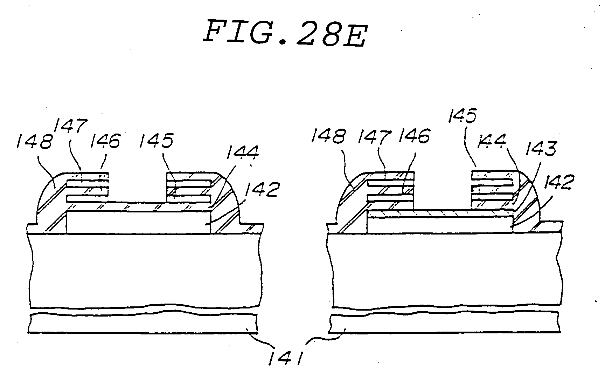

In FIG.28E, a RIE using HBr/Ar as the etching gas is carried out to etch the third conductor layer 145.

Even though the surface of the second conductor layer 143 may already be exposed as described above when this etching is carried out, the second conductor layer 143 is made of the refractory metal or refractory metal silicide. For this reason, the second conductor layer 143 is hardly etched by this RIE which uses HBr, and no problems will be introduced by this RIE.

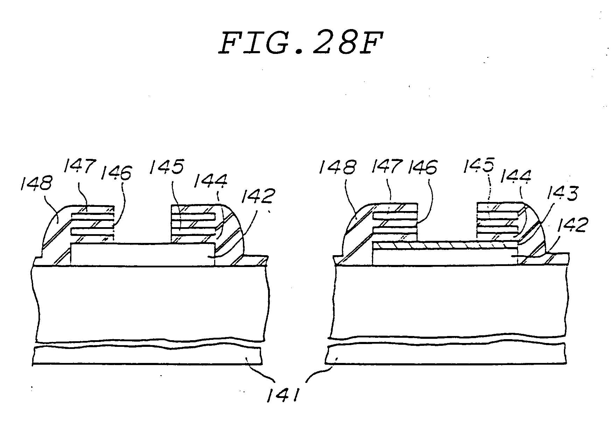

In FIG.28F, a RIE using CHF₃/He as the etching gas is carried out to etch the first insulator layer 144.

The first insulator layer 144 may already be etched when this etching is started, but no adverse effects are introduced because the second conductor layer 143 is made of the refractory metal or refractory metal silicide and is hardly etched by the CHF₃/He etching gas.

Therefore, the contact hole is formed to an ideal shape. The only difference of the resulting contact hole shown in FIG. 29F with that shown in FIG.27F is that the lowermost conductor layer in FIG.28F is made up of the first conductor layer 142 and the second conductor layer 143.

Moreover, the present invention may be applied to a lightly doped drain (LDD) transistor, a polycide interconnection (polysilicon and metal silicide stacked layer) and the like.

## Claims

1. A semiconductor memory device comprising a memory cell provided on a semiconductor substrate (1, 51) and including first and second transfer transistors (Q3, Q4), first and second driver transistors (Q1, Q2), first and second thin film transistor loads (Q5, Q6), and first and second memory capacitors, each of said first and second transfer transistors, said first and second driver transistors and said first and second thin film transistor load having a source, a drain and a gate electrode, said driver transistors and said transistor loads being interconnected as first and second cross-coupled inverters having first and second storage nodes (S₁, S₂) respectively, wherein each of said first and second memory capacitors has a first electrode (24, 30, 33, 80, 82, 89, 91, 93, 96) which is electrically connected to the respective gate electrode of the first and second driver transistors, a dielectric layer (27, 34, 83) which covers the first electrode, and a second electrode (28, 35, 84) which is formed on the dielectric layer; wherein there is provided a connection region (23A, 31A, 81A, 90A, 95A) in which the first electrode of the first memory capacitor, the drain (18) of the second thin film transistor load (Q6), the gate electrode (15, 24, 30, 61, 80, 82, 89, 91, 93) of the first thin film transistor load (Q5) and the gate electrode (4, 55, 56) of the first driver transistor (Q1) and the drain of the second driver transistor (Q2) are connected; wherein said connection region comprises a sidewall contact formed by the first electrode of the first memory capacitor contacting in a contact hole, side surfaces of the gate electrode of the first thin film transistor load and the drain electrode of the second thin film transistor load and with a top surface of the gate electrode of the first driver transistor; and wherein the first electrode (24, 30, 33, 80, 82, 89, 91, 93, 96) of the first memory capacitor is used in common as a gate electrode (24, 30, 80, 92, 91, 93) of the first thin film transistor load (Q5).

2. The semiconductor memory device as claimed in claim 1, **characterized** in that said first electrode of the first memory capacitor is made up of one or a plurality of fins (30, 32, 80, 82, 89, 91, 93).

3. The semiconductor memory device as claimed in claim 1, **characterized** in that said first and second thin film transistor loads (Q5, Q6) have a double gate structure; that the gate electrode of said first thin film transistor load (Q5) is made up of upper and lower gate electrodes; and that said first electrode (24, 30, 80, 82, 81, 93) of the first memory capacitor is used in common as the upper gate electrode (24, 30, 80, 82, 91, 93) of the first thin film transistor load (Q5).

4. The semiconductor memory device as claimed in claim 3, characterized in that the first electrode (24, 30, 33, 80, 82, 89, 91, 93, 96) of the first memory capacitor, the gate electrode (15, 24, 30, 61, 80, 82, 89, 93) of the first thin film transistor load (Q5) and the drain electrode of the second thin film transistor load (Q6) are stacked on the gate electrode (4, 55, 56) of the first driver transistor (Q1) via insulator layers (7, 9, 16, 23, 29, 59, 62, 79, 81, 92, 94) within said connection region (23A, 31A, 81A, 90A, 95A), said first electrode of the first memory capacitor making contact with side surfaces of the lower gate electrode of the first thin film transistor load and the drain electrode of the second thin film transistor load and with a top surface of the gate electrode of the first driver transistor.

5. The semiconductor memory device as claimed in claim 2, characterized in that a lowermost one (80, 93) of the fins (80, 93) form an upper electrode of the first thin film transistor load (Q5).

6. The semiconductor memory device as claimed in claim 5, characterized in that the fins (30, 80, 89, 91, 93) of the first memory capacitor and the upper gate electrode (24, 30, 80, 82, 91, 93) of the first thin film transistor load (Q5) have approximately the same pattern in a plan view.

7. The semiconductor memory device as claimed in any of claims 1 to 6, characterized in that an insulator layer (79) is provided under the second electrode (84), said insulator layer having a pattern which extends outside that of the gate electrode (80) of the first thin film transistor load (Q5) in a plan view but is approximately the same as that of the second electrode of the first memory capacitor.

8. The semiconductor memory device as claimed in any of claims 1 to 7, characterized in that the second electrode (28, 35, 84) of the first memory capacitor receives a voltage which is approximately a center voltage between first and second voltages which respectively correspond to mutually opposite data values to be stored in the memory cell.

9. The semiconductor memory device as claimed in claim 4, characterized in that the gate electrode of (4, 55, 56) the first driver transistor (Q1) is made up of a first conductor layer (4, 55, 56) formed on said semiconductor substrate (1, 51) and a second conductor layer (150) formed on the first conductor layer, said second conductor layer being made of a material selected from a group consisting of refractory metals and refractory metal silicides.

10. The semiconductor memory device as claimed in any of claims 1 to 7, characterized in that the second electrode (28, 84) of the first memory capacitor is used in common as a ground line which connects to the source of the first driver transistor (Q1).

11. The semiconductor memory device as claimed in any of claims 1 to 10, characterized in that the first and second thin film transistor loads (Q5, Q6) respectively include a lower gate insulator layer (16, 62) which is formed on a lover gate electrode (15, 61) of the first and second thin film transistor loads, a channel layer which is formed on the lower gate electrode, and an upper gate insulator layer (29, 79) which is formed on the channel layer, an upper gate electrode (30, 80) of the first and second thin film transistor loads being formed on the upper gate insulator layer.

12. The semiconductor memory device as claimed in claim 11, characterized in that the upper gate insulator layer (29, 79) is thicker than the dielectric layer (27, 84).

13. The semiconductor memory device as claimed in claim 11 or 12, characterized in that the upper gate insulator layer (29, 79) is made of Si₃N₄, so that the upper gate insulator layer functions as an etching stopper.

14. The semiconductor memory device as claimed in any of claims 1 to 13, characterized in that the second electrode (35, 84) of the first memory capacitor is used in common as a shield electrode of the first thin film transistor load (Q5).

15. The semiconductor memory device as claimed in any of claims 1 to 7, **characterized** in that the source of the first thin film transistor load (Q5) and the second electrode (35, 84) of the first memory capacitor receive the same power source voltage.

16. A method of producing a semiconductor memory device which includes a memory cell made up of two transfer transistors (Q3, Q4), too driver transistors (Q1, Q2), two thin film transistor loads (Q5, Q6), and too memory capacitors, each of the two transfer transistors, two driver transistors and two thin film transistor loads having a source electrode a drain electrode and a gate electrode characterized in that said method comprises the steps of:
(a) forming a gate insulator layer (3, 53) on a semiconductor substrate (1, 51) after forming a field insulator layer (2, 52) on a surface of the semiconductor substrate;
(b) forming a gate electrode (4, 55, 56) of the driver transistor by forming a first conductor layer and patterning the first conductor layer;
(c) forming a first insulator layer (7, 59) after forming impurity regions (5, 6, 57, 58) in the semiconductor substrate using the field insulator layer and the first conductor layer as masks;
(d) forming source, drain and channel regions (17, 18, 19, 67) of the thin film transistor load by forming a second conductor layer and selectively injecting impurities into the second conductor layer;
(e) forming a second insulator layer (23, 29, 79, 90, 95) after patterning the second conductor layer;
(f) forming a contact hole (23A, 31A, 81A, 90A, 95A) which extends from a top surface of the second insulator layer and reaches a top surface of the first conductor layer;
(g) forming a first electrode (24, 30, 80, 82, 89, 91, 93, 96) of the memory capacitor and a gate electrode of the thin film transistor load by forming a third conductor layer which makes contact with the top surface of the first conductor layer and with a side surface of the second conductor layer and patterning the third conductor layer, so that a connection region within the contact hole comprises a sidewall contact formed by the first electrode of the memory capacitors; and
(h) successively forming a dielectric layer (27, 83) which covers the first electrode of the memory capacitor and a fourth conductor layer which forms a second electrode (28, 84) of the memory capacitor.

17. The method of producing the semiconductor memory device as claimed in claim 16, characterized in that said step (e) successively stacks spacer insulator layers (31, 81, 95) and at least one conductive fin (30, 32, 80, 82, 89, 91, 93) on the second conductor layer, said step (f) forms the contact hole (23A, 31A, 81A, 90A, 95A) which also penetrate's the spacer insulator layer and the conductive fin, and said step (g) removes the spacer insulator layers using the second insulator layer (29, 79, 94) as an etching stopper.

18. The method of producing the semiconductor memory device as claimed in claim 17, characterized in that said step (e) successively and alternately forms the spacer insulator layers (31, 81, 95) and the conductive fins (30, 32, 80, 82, 89, 91, 93), and said step (g) simultaneously patterns the spacer insulator layer and the conductive fins to form the first electrode (24, 30, 80, 82, 89, 91, 93, 96).

19. The method of producing the semiconductor memory device as claimed in claim 17 or 18, characterized in that said step (h) simultaneously patterns the second insulator layer to form the second electrode (28, 84).

20. The method of producing the semiconductor memory device as claimed in any of claims 17 to 19, characterized in that said step (g) forms the conductive fins (30, 32, 80, 82, 89, 91, 93) so that a lowermost one (80, 93) of the conductive fins functions both as the first electrode (80, 93) of the memory capacitor and an upper gate electrode (80, 93) of the thin film transistor load.

21. The method of producing the semiconductor memory device as claimed in claim 16, **characterized** in that:
said step (e) forms an upper gate insulator layer (29, 79, 90, 95) of the thin film transistor load by the second insulator layer;
said step (f) forms the contact hole (31A, 81A, 90A, 95A) which further extends from the top surface of the fifth insulator layer and reaches the top surface of the first conductor layer via a third insulator layer (31, 81, 90, 95) which is formed after forming a fifth conductor layer;
said step (g) forms the first electrode (24, 82, 91, 96) of the memory capacitor by forming the third conductor layer which further makes contact with a side surface of the fifth conductor layer and patterning the third conductor layer, the third insulator layer and the fifth conductor layer, the patterned fifth and third conductor layers forming fins of the memory capacitor and an upper gate electrode of the thin film transistor load, the patterned third insulator layer forming a spacer of the memory capacitor;
that there are further provided the steps of:
(i) removing the third insulator layer which forms the spacer (31, 81, 90, 95) between the first electrode of the memory capacitor and the upper gate electrode of the thin film transistor load;
and that said step (h) successively forms the di-electric layer (27, 83) which covers the first electrode of the memory capacitor and a fifth conductor layer (28, 84) which forms a second electrode of the memory capacitor, said second electrode also functioning as a ground line.

22. The method of producing the semiconductor memory device as claimed in claim 21, characterized in that said step (h) simultaneously patterns at least the fourth conductor layer, the third insulator layer (31, 81, 90, 95) and the third conductor layer to form the first electrode (24, 82, 91, 90) of the memory capacitor.

23. The method of producing the semiconductor memory device as claimed in claim 21 or 22, characterized in that said step (i) uses the second insulator layer (29, 79) which forms the upper gate insulator layer (29, 79) of the thin film transistor load as an etching stopper when removing the third insulator layer (31, 81, 90, 95).

24. The method of producing the semiconductor memory device as claimed in claim 23, characterized in that said step (i) uses a silicon nitride (Si₃N₄) layer as the second insulator layer.

25. The method of producing the semiconductor memory device as claimed in any of claims 21 to 24, characterized in that said step (f) successively forms a silicon nitride (Si₃N₄) layer (94) and a spacer insulator layer (95) as the third insulator layer (95), said silicon nitride (Si₃N₄) layer (94) functioning as an etching stopper when forming the first electrode (96) of the memory capacitor.

26. The method of producing the semiconductor device as claimed in claim 16, **characterized** in that there are provided the steps of:
(i) forming a lower gate insulator layer (16, 59) of the thin film transistor load by forming a fourth insulator layer after forming a lower gate electrode (15, 61) of the thin film transistor load by forming and patterning a fifth conductor layer;
(j) forming a fifth insulator layer (29, 81) after patterning the second conductor layer;
(k) forming a sixth insulator layer (30, 31, 81) after forming a sixth conductor layer; wherein:
said step (f) forms the contact hole (31A, 81A) which further extends from the top surface of the sixth insulator layer and reaches the top surface of the first conductor layer;
said step (g) forms the first electrode (33, 82) of the memory capacitor by forming the third conductor layer which further makes contact with side surfaces of the fifth and sixth conductor layers and patterning the third conductor layer, the sixth insulator layer and the sixth conductor layer, the patterned third and sixth conductor layers forming fins of the memory capacitor, the patterned sixth insulator layer forming a spacer of the memory capacitor;
that there are further provided the steps of:
(1) removing the sixth insulator layer (30, 31) which forms the spacer between the first electrode of the memory capacitor and the upper gate electrode of the thin film transistor load;
and that said step (h) successively forms the di-electric layer (27, 83) which covers first electrode of the memory capacitor and a seventh conductor layer which forms a second electrode (28, 84) of the memory capacitor, said second electrode also functioning as a shield electrode of the thin film transistor load.

27. The method of producing the semiconductor memory device as claimed in claim 26, characterized in that said step (g) simultaneously patterns at least the third conductor layer, the sixth insulator layer (30) and the fourth conductor layer to form the first electrode of the memory capacitor.

28. The method of producing the semiconductor memory device as claimed in claim 26 or 27, characterized in that said step (l) uses the fifth insulator layer (29, 81) as an etching stopper when removing the sixth insulator layer (30, 31).

29. The method of producing the semiconductor memory device as claimed in claim 27, characterized in that said step (g) uses a silicon nitride (Si₃N₄) layer as the fifth insulator layer.

30. The method of producing the semiconductor memory device as claimed in any of claims 16 to 29, characterized in that said step (b) includes the substeps of:
forming a first layer which is made of a conductive material; and
forming a second layer (150) which is made of a conductive material on the first layer to form the first conductor layer which is made up of the first and second layers,
said second layer being made of a material selected from a group consisting of refractory metals and refractory metal silicides.

## Patentansprüche

1. Halbleiterspeichervorrichtung, enthaltend eine Speicherzelle, die auf einem Halbleitersubstrat (1, 51) vorgesehen ist und erste und zweite Übertragungstransistoren (Q3, Q4), erste und zweite Steuertransistoren (Q1, Q2), erste und zweite Dünnfilmtransistorlasten (Q5, Q6) und erste und zweite Speicherkondensatoren enthält, welcher jeder der ersten und zweiten Übertragungstransistoren, der ersten und zweiten Steuertransistoren und der ersten und zweiten Dünnfilmtransistorlasten eine Quellen-, eine Drain- und eine Gate-Elektrode hat, die Steuertransistoren und die Transistorlasten als erste und zweite kreuzgekoppelte Inverter verbunden sind, die erste bzw. zweite Speicherknoten (S₁, S₂) haben, wobei jeder der ersten und zweiten Speicherkondensatoren eine erste Elektrode (24, 30, 33, 80, 82, 89, 91, 93, 96), die elektrisch an die jeweilige Gate-Elektrode der ersten und zweiten Steuertransistoren angeschlossen ist, eine dielektrische Schicht (27, 34, 83), die die erste Elektrode bedeckt, und eine zweite Elektrode (28, 35, 84) hat, die auf der dielektrischen Schicht gebildet ist, wobei eine Verbindungsregion (23A, 31A, 81A, 90A, 95A) vorgesehen ist, in welcher die erste Elektrode des ersten Speicherkondensators, die Drain (18) der zweiten Dünnfilmtransistorlast (Q6), die Gate-Elektrode (15, 24, 30, 61, 80, 82, 89, 91, 93) der ersten Dünnfilmtransistorlast (Q5) und die Gate-Elektrode (4, 55, 56) des ersten Steuertransistors (Q1) und die Drain des zweiten Steuertransistors (Q2) verbunden sind, wobei die Verbindungsregion einen durch die erste Elektrode des ersten Speicherkondensators gebildeten Seitenwandkontakt enthält, der in einem Kontaktloch Seitenoberflächen der Gate-Elektrode der ersten Dünnfilmtransistorlast und der Drain-Elektrode der zweiten Dünnfilmtransistorlast und mit einer Oberseitenoberfläche der Gate-Elektrode des ersten Steuertransistors kontaktiert, und wobei die erste Elektrode (24, 30, 33, 80, 82, 89, 91, 93, 96) des ersten Speicherkodensators gemeinsam als eine Gate-Elektrode (24, 30, 80, 92, 91, 93) der ersten Dünnfilmtransistorlast (Q5) verwendet wird.

2. Halbleiterspeichervorrichtung nach Anspruch 1, dadurch gekennzeichnet, daß die erste Elektrode des ersten Speicherkondensators aus einer oder einer Mehrzahl von Rippen (30, 32, 80, 82, 89, 91, 93) besteht.

3. Halbleiterspeichervorrichtung nach Anspruch 1, dadurch gekennzeichnet, daß die ersten und zweiten Dünnfilmtransistorlasten (Q5, Q6) eine Doppel-Gate-Struktur haben, daß die Gate-Elektrode der ersten Dünnfilmtransistorlast (Q5) aus oberen und unteren Gate-Elektroden besteht, und daß die erste Elektrode (24, 30, 80, 82, 81, 93) des ersten Speicherkondensators gemeinsam als die obere Gate-Elektrode (24, 30, 80, 82, 91, 93) der ersten Dünnfilmtransistorlast (Q5) verwendet wird.

4. Halbleiterspeichervorrichtung nach Anspruch 3, dadurch gekennzeichnet, daß die erste Elektrode (24, 30, 33, 80, 82, 89, 91, 93, 96) des ersten Speicherkondensators, die Gate-Elektrode (15, 24, 30, 61, 80, 82, 89, 93) der ersten Dünnfilmtransistorlast (Q5) und die Drain-Elektrode der zweiten Dünnfilmtransistorlast (Q6) auf der Gate-Elektrode (4, 55, 56) des ersten Steuertransistors (Q1) über Isolatorschichten (7, 9, 16, 23, 29, 59, 62, 79, 81, 92, 94) innerhalb des Verbindungsbereichs (23A, 31A, 81A, 90A, 95A) gestapelt sind, welche erste Elektrode des ersten Speicherkondensators einen Kontakt mit Seitenflächen der unteren Gate-Elektrode der ersten Dünnfilmtransistorlast und der Drain-Elektrode der zweiten Dünnfilmtransistorlast und mit einer Oberseitenoberfläche der Gate-Elektrode des ersten Steuertransistors herstellt.

5. Halbleiterspeichervorrichtung nach Anspruch 2, dadurch gekennzeichnet, daß eine unterste (80, 93) der Rippen (80, 93) eine obere Elektrode der ersten Dünnfilmtransistorlast (Q5) bildet.

6. Halbleiterspeichervorrichtung nach Anspruch 5, dadurch gekennzeichnet, daß die Rippen (30, 80, 89, 91, 93) des ersten Speicherkondensators und die obere Gate-Elektrode (24, 30, 80, 82, 91, 93) der ersten Dünnfilmtransistorlast (Q5) ungefähr dieselbe Gestalt in einer Draufsicht haben.

7. Halbleiterspeichervorrichtung nach einem der Ansprüche 1 bis 6, dadurch gekennzeichnet, daß die Isolatorschicht (79) unter der zweiten Elektrode (84) vorgesehen ist, welche Isolatorschicht eine Gestalt hat, die sich nach außerhalb jener der Gate-Elektrode (80) der ersten Dünnfilmtransistorlast (Q5) in einer Draufsicht erstreckt, aber ungefähr dieselbe ist wie jene der zweiten Elektrode des ersten Speicherkondensators.

8. Halbleiterspeichervorrichtung nach einem der Ansprüche 1 bis 7, dadurch gekennzeichnet, daß die zweite Elektrode (28, 35, 84) des ersten Speicherkondensators eine Spannung erhält, welche ungefähr eine Mittelspannung zwischen ersten und zweiten Spannungen ist, die entsprechend einander entgegengesetzten Datenwerten entsprechen, die in der Speicherzelle gespeichert werden sollen.

9. Halbleiterspeichervorrichtung nach Anspruch 4, dadurch gekennzeichnet, daß die Gate-Elektrode (4, 55, 56) des ersten Steuertransistors (Q1) aus einer ersten Leiterschicht (4, 55, 56), die auf dem Halbleitersubstrat (1, 51) gebildet ist, und einer zweiten Leiterschicht (150) besteht, die auf der ersten Leiterschicht gebildet ist, welche zweite Leiterschicht aus einem Material besteht, das aus einer Gruppe ausgewählt ist, die aus feuerbeständigen Metallen und feuerbeständigen Metallsiliziden besteht.

10. Halbleiterspeichervorrichtung nach einem der Ansprüche 1 bis 7, dadurch gekennzeichnet, daß die zweite Elektrode (28, 84) des ersten Speicherkondensators gemeinsam als eine Erdungsleitung verwendet wird, welche an die Quelle des ersten Steuertransistors (Q1) anschließt.

11. Halbleiterspeichervorrichtung nach einem der Ansprüche 1 bis 10, dadurch gekennzeichnet, daß die ersten und zweiten Dünnfilmtransistorlasten (Q5, Q6) jeweils eine untere Gate-Isolatorschicht (16, 62), die auf einer unteren Gate-Elektrode (15, 61) der ersten und zweiten Dünnfilmtransistorlasten gebildet ist, eine Kanalschicht, die auf der unteren Gate-Elektrode gebildet ist, und eine obere Gate-Isolatorschicht (29, 79) enthalten, die auf der Kanalschicht gebildet ist, wobei eine obere Gate-Elektrode (30, 80) der ersten und zweiten Dünnfilmtransistorlasten auf der oberen Gate-Isolatorschicht gebildet ist.

12. Halbleiterspeichervorrichtung nach Anspruch 11, dadurch gekennzeichnet, die obere Gate-Isolatorschicht (29, 79) dicker ist als die dielektrische Schicht (27, 84).

13. Halbleiterspeichervorrichtung nach Anspruch 11 oder 12, dadurch gekennzeichnet, daß die obere Gate-Isolatorschicht (29, 79) aus Si₃N₄ besteht, so daß die obere Gate-Isolatorschicht als ein Ätzstopper wirkt.

14. Halbleiterspeichervorrichtung nach einem der Ansprüche 1 bis 13, dadurch gekennzeichnet, daß die zweite Elektrode (35, 84) des ersten Speicherkondensators gemeinsam als eine Abschirmelektrode der ersten Dünnfilmtransistorlast (Q5) verwendet wird.

15. Halbleiterspeichervorrichtung nach einem der Ansprüche 1 bis 7, dadurch gekennzeichnet, daß die Quelle der ersten Dünnfilmtransistorlast (Q5) und die zweite Elektrode (35, 84) des ersten Speicherkondensators dieselbe Leistungsquellenspannung erhalten.

16. Verfahren zum Herstellen einer Halbleiterspeichervorrichtung, die eine Speicherzelle enthält, die aus zwei Übertragungstransistoren (Q3, Q4), zwei Steuertransistoren (Q1, Q2), zwei Dünnfilmtransistorlasten (Q5, Q6) und zwei Speicherkondensatoren besteht, welche jeder der zwei Übertragungstransistoren, zwei Steuertransistoren und zwei Dünnfilmtransistorlasten eine Quellenelektrode, eine Drain-Elektrode und eine Gate-Elektrode hat, dadurch gekennzeichnet, daß das Verfahren die Schritte enthält:
(a) Bilden einer Gate-Isolatorschicht (3, 53) auf einem Halbleitersubstrat (1, 51) nach dem Bilden einer Feldisolatorschicht (2, 52) auf einer Oberfläche des Halbleitersubstrats,
(b) Bilden einer Gate-Elektrode (4, 55, 56) des Steuertransistors durch Bilden einer ersten Leiterschicht und Mustern der ersten Leiterschicht,
(c) Bilden einer ersten Isolatorschicht (7, 59) nach dem Bilden von Verunreinigungsregionen (5, 6, 57, 58) in dem Halbleitersubstrat unter Verwendung der Feldisolatorschicht und der ersten Leiterschicht als Masken,
(d) Bilden von Quellen-, Drain- und Kanalregionen (17, 18, 19, 67) der Dünnfilmtransistorlast durch Bilden einer zweiten Leiterschicht und selektives Einführen von Verunreinigungen in die zweite Leiterschicht,
(e) Bilden einer zweiten Isolatorschicht (23, 29, 79, 90, 95) nach dem Mustern der zweiten Leiterschicht,
(f) Bilden eines Kontaktloches (23A, 31A, 81A, 90A, 95A), welches sich von einer Oberseitenoberfläche der zweiten Isolatorschicht erstreckt und eine Oberseitenoberfläche der ersten Leiterschicht erreicht,
(g) Bilden einer ersten Elektrode (24, 30, 80, 82, 89, 91, 93, 96) des Speicherkondensators und einer Gate-Elektrode der Dünnfilmtransistorlast durch Bilden einer dritten Leiterschicht, die einen Kontakt zu der Oberseitenoberfläche der ersten Leiterschicht und zu einer Seitenoberfläche der zweiten Leiterschicht herstellt, und Mustern der dritten Leiterschicht, so daß ein Verbindungsbereich innerhalb des Kontaktloches einen Seitenwandkontakt enthält, der durch die erste Elektrode der Speicherkondensatoren gebildet ist, und
(h) nacheinander Bilden einer dielektrischen Schicht (27, 83), welche die erste Elektrode des Speicherkondensators bedeckt, und einer vierten Leiterschicht, die eine zweite Elektrode (28, 84) des Speicherkondensators bildet.

17. Verfahren zum Herstellen der Halbleiterspeichervorrichtung nach Anspruch 16, dadurch gekennzeichnet, daß der Schritt (e) nacheinander Abstandhalterisolatorschichten (31, 81, 95) und wenigstens eine leitende Rippe (30, 32, 80, 82, 89, 91, 93) auf der zweiten Leiterschicht stapelt, der Schritt (f) das Kontaktloch (23A, 31A, 81A, 90A, 95A) bildet, welches auch durch die Speicherisolatorschicht und die leitende Rippe hindurchgeht, und der Schritt (g) die Abstandhalterisolatorschichten unter Verwendung der zweiten Isolatorschicht (29, 79, 94) als ein Ätzstopper entfernt.

18. Verfahren zum Herstellen der Halbleiterspeichervorrichtung nach Anspruch 17, dadurch gekennzeichnet, daß der Schritt (e) nacheinander und abwechselnd die Abstandhalterisolatorschichten (31, 81, 95) und die leitenden Rippen (30, 32, 80, 82, 89, 91, 93) bildet, und der Schritt (g) gleichzeitig die Abstandhalterisolatorschichten und die leitenden Rippen gmustert, um die erste Elektrode (24, 30, 80, 82, 89, 91, 93, 96) zu bilden.

19. Verfahren zum Herstellen der Halbleiterspeichervorrichtungen nach Anspruch 17 oder 18, dadurch gekennzeichnet, daß der Schritt (h) gleichzeitig die zweite Isolatorschicht gmustert, um die zweite Elektrode (28, 84) zu bilden.

20. Verfahren zum Herstellen der Halbleiterspeichervorrichtung nach einem der Ansprüche 17 bis 19, dadurch gekennzeichnet, daß der Schritt (g) die leitenden Rippen (30, 32, 80, 82, 89, 91, 93) bildet, so daß eine unterste (80, 93) der leitenden Rippen sowohl als die erste Elektrode (80, 93) des Speicherkondensators, als auch eine obere Gate-Elektrode (80, 93) der Dünnfilmtransistorlast wirkt.

21. Verfahren zum Herstellen der Halbleiterspeichervorrichtung nach Anspruch 16, dadurch gekennzeichnet, daß:
der Schritt (e) eine obere Gate-Isolatorschicht (29, 79, 90, 95) der Dünnfilmtransistorlast durch die zweite Isolatorschicht bildet,
der Schritt (f) das Kontaktloch (31A, 81A, 90A, 95A) bildet, welches sich ferner von der Oberseitenoberfläche der fünften Isolatorschicht erstreckt und die Oberseitenoberfläche der ersten Leiterschicht über eine dritte Isolatorschicht (31, 81, 90, 95) erreicht, welche nach dem Bilden der fünften Leiterschicht gebildet wird,
der Schritt (g) die erste Elektrode (24, 82, 91, 96) des Speicherkondensators durch Bilden der dritten Leiterschicht, welche ferner einen Kontakt mit einer Seitenoberfläche der fünften Leiterschicht herstellt, und Mustern der dritten Leiterschicht, der dritten Isolatorschicht und der fünften Leiterschicht bildet, wobei die gmusterten fünften und dritten Leiterschichten Rippen des Speicherkondensators und eine obere Gate-Elektrode der Dünnfilmtransistorlast bilden, welche gmusterte dritte Isolatorschicht einen Abstandhalter des Speicherkondensators bildet,
daß ferner vorgesehen sind die Schritte:
(i) Entfernen der dritten Isolatorschicht, die den Abstandhalter (31, 81, 90, 95) zwischen der ersten Elektrode des Speicherkondensators und der oberen Gate-Elektrode der Dünnfilmtransistorlast bildet,
und daß der Schritt (h) nacheinander die dielektrische Schicht (27, 83), die die erste Elektrode des Speicherkondensators bedeckt, und eine fünfte Leiterschicht (28, 84) bildet, die eine zweite Elektrode des Speicherkondensators bildet, welche zweite Elektrode auch als eine Erdungsleitung wirkt.

22. Verfahren zum Herstellen der Halbleiterspeichervorrichtung nach Anspruch 21, dadurch gekennzeichnet, daß der Schritt (h) gleichzeitig wenigstens die vierte Leiterschicht, die dritte Isolatorschicht (31, 81, 90, 95) und die dritte Leiterschicht gmustert, um die erste Elektrode (24, 82, 91, 96) des Speicherkondensators zu bilden.

23. Verfahren zum Herstellen der Halbleiterspeichervorrichtung nach Anspruch 21 oder 22, dadurch gekennzeichnet, daß der Schritt (i) die zweite Isolatorschicht (29, 79), welche die obere Gate-Isolatorschicht (29, 79) der Dünnfilmtransistorlast bildet, als einen Ätzstopper verwendet, wenn die dritte Isolatorschicht (31, 81, 90, 95) entfernt wird.

24. Verfahren zum Herstellen der Halbleiterspeichervorrichtung nach Anspruch 23, dadurch gekennzeichnet, daß der Schritt (i) eine Siliziumnitrid- (Si₃N₄-) Schicht als die zweite Isolatorschicht verwendet.

25. Verfahren zum Herstellen der Halbleiterspeichervorrichtung nach einem der Ansprüche 21 bis 24, dadurch gekennzeichnet, daß der Schritt (f) nacheinander eine Siliziumnitrid- (Si₃N₄-) Schicht (94) und eine Abstandhalterisolatorschicht (95) als die dritte Isolatorschicht (95) bildet, welche Siliziumnitrid- (Si₃N₄-) Schicht als ein Ätzstopper wirkt, wenn die erste Elektrode (96) des Speicherkondensators gebildet wird.

26. Verfahren zum Herstellen der Halbleiterspeichervorrichtung nach Anspruch 16, dadurch gekennzeichnet, daß vorgesehen sind die Schritte:
(i) das Bilden einer unteren Gate-Isolatorschicht (16, 59) der Dünnfilmtransistorlast durch Bilden einer vierten Isolatorschicht nach dem Bilden einer unteren Gate-Elektrode (15, 61) der Dünnfilmtransistorlast durch Bilden und Mustern einer fünften Leiterschicht,
(j) Bilden einer fünften Isolatorschicht (29, 81) nach dem Mustern der zweiten Leiterschicht,
(k) Bilden einer sechsten Isolatorschicht (30, 31, 81) nach dem Bilden einer sechsten Leiterschicht,
wobei:
der Schritt (f) das Kontaktloch (31A, 81A) bildet, welches sich ferner von der Oberseitenoberfläche der sechsten Isolatorschicht erstreckt und die Oberseitenoberfläche der ersten Leiterschicht erreicht,
der Schritt (g) die erste Elektrode (33, 82) des Speicherkondensators durch Bilden der dritten Leiterschicht, die ferner Kontakt mit Seitenoberflächen der fünften und sechsten und sechsten Leiterschichten herstellt, und Mustern der dritten Leiterschicht, der sechsten Isolatorschicht und der sechsten Leiterschicht bildet, welche gmusterte dritte und vierte Leiterschichten Rippen des Speicherkondensators bilden, welche gmusterte sechste Isolatorschicht einen Abstandhalter des Speicherkondensators bildet,
daß ferner vorgesehen sind die Schritte:
(l) Entfernen der sechsten Isolatorschicht (30, 31), die den Abstandhalter zwischen der ersten Elektrode des Speicherkondensators und der oberen Gate-Elektrode der Dünnfilmtransiscorlast bildet, und
daß der Schritt (h) nacheinander die dielektrische Schicht (27, 83), die die erste Elektrode des Speicherkondensators bedeckt, und eine siebte Leiterschicht bildet, die eine zweite Elektrode (28, 84) des Speicherkondensators bildet, welche zweite Elektrode auch als eine Abschirmelektrode der Dünnfilmtransistorlast wirkt.

27. Verfahren zum Herstellen der Halbleiterspeichervorrichtung nach Anspruch 26, dadurch gekennzeichnet, daß der Schritt (g) gleichzeitig wenigstens die dritte Leiterschicht, die sechste Isolatorschicht (30) und die vierte Leiterschicht gmustert, um die erste Elektrode des Speicherkondensators zu bilden.

28. Verfahren zum Herstellen der Halbleiterspeichervorrichtung nach Anspruch 26 oder 27, dadurch gekennzeichnet, daß der Schritt (1) die fünfte Isolatorschicht (29, 81) als einen Ätzstopper verwendet, wenn die sechste Isolatorschicht (30, 31) entfernt wird.

29. Verfahren zum Herstellen der Halbleiterspeichervorrichtung nach Anspruch 27, dadurch gekennzeichnet, daß der Schritt (g) eine Siliziumnitrid- (Si₃N₄-) Schicht als die fünfte Isolatorschicht verwendet.

30. Verfahren zum Herstellen der Halbleiterspeichervorrichtung nach einem der Ansprüche 16 bis 29, dadurch gekennzeichnet, daß der Schritt (b) die Unterschritte enthält:
Bilden einer ersten Schicht, die aus einem leitenden Material besteht, und
Bilden einer zweiten Schicht (150), die aus einem leitenden Material besteht, auf der ersten Schicht, um die erste Leiterschicht zu bilden, die aus den ersten und zweiten Schichten besteht,
welche zweite Schicht aus einem Material besteht, die aus einer Gruppe ausgewählt ist, die aus feuerbeständigen Metallen und feuerbeständigen Metallsiliziden besteht.

## Revendications

1. Un dispositif de mémoire à semiconducteur comprenant une cellule de mémoire formée sur un substrat semiconducteur (1, 51) et incluant des premier et second transistors de transfert (Q3, Q4), des premier et second transistors d'attaque (Q1, Q2), des première et seconde charges à transistor à couches minces (Q5, Q6), et des premier et second condensateurs de mémoire, chacun des premier et second transistors de transfert, des premier et second transistors d'attaque et des première et seconde charges à transistor à couches minces ayant une source, un drain et une électrode de grille, les transistors d'attaque et les charges à transistor étant interconnectés sous la forme d'un premier et d'un second inverseurs en couplage croisé ayant respectivement des premier et second noeuds de stockage (S₁, S₂), dans lequel chacun des premier et second condensateurs de mémoire a une première électrode (24, 30, 33, 80, 82, 89, 91, 93, 96) qui est connectée électriquement à l'électrode de grille respective des premier et second transistors d'attaque, une couche diélectrique (27, 34, 83) qui recouvre la première électrode, et une seconde électrode (28, 35, 84) qui est formée sur la couche diélectrique; dans lequel il existe une région de connexion (23A, 31A, 81A, 90A, 95A) dans laquelle la première électrode du premier condensateur de mémoire, le drain (18) de la seconde charge à transistor à couches minces (Q6), l'électrode de grille (15, 24, 30, 61, 80, 82, 89, 91, 93) de la première charge à transistor à couches minces (Q5) et l'électrode de grille (4, 55, 56) du premier transistor d'attaque (Q1) et le drain du second transistor d'attaque (Q2) sont connectés; dans lequel la région de connexion comprend un contact de paroi latérale formé par la première électrode du premier condensateur de mémoire venant en contact, dans un trou de contact, avec des surfaces latérales de l'électrode de grille de la première charge à transistor à couches minces et l'électrode de drain de la seconde charge à transistor à couches minces, et avec une surface supérieure de l'électrode de grille du premier transistor d'attaque; et dans lequel la première électrode (24, 30, 33, 80, 82, 89, 91, 93, 96) du premier condensateur de mémoire est utilisée en commun comme une électrode de grille (24, 30, 80, 92, 91, 93) de la première charge à transistor à couches minces (Q5).

2. Le dispositif de mémoire à semiconducteur selon la revendication 1, caractérisé en ce que la première électrode du premier condensateur de mémoire est constituée par une ou plusieurs ailettes (30, 32, 80, 82, 89, 91, 93).

3. Le dispositif de mémoire à semiconducteur selon la revendication 1, caractérisé en ce que les première et seconde charges à transistor à couches minces (Q5, Q6) ont une structure de grille double; en ce que l'électrode de grille de la première charge à transistor à couches minces (Q5) est constituée par des électrodes de grille supérieure et inférieure; et en ce que la première électrode (24, 30, 80, 82, 81, 93) du premier condensateur de mémoire est utilisée en commun comme l'électrode de grille supérieure (24, 30, 80, 82, 91, 93) de la première charge à transistor à couches minces (Q5).

4. Le dispositif de mémoire à semiconducteur selon la revendication 3, caractérisé en ce que la première électrode (24, 30, 33, 80, 82, 89, 91, 93, 96) du premier condensateur de mémoire, l'électrode de grille (15, 24, 30, 61, 80, 82, 89, 93) de la première charge à transistor à couches minces (Q5) et l'électrode de drain de la seconde charge à transistor à couches minces (Q6) sont empilées sur l'électrode de grille (4, 55, 56) du premier transistor d'attaque (Q1), avec interposition de couches d'isolant (7, 9, 16, 23, 29, 59, 62, 79, 81, 92, 94) dans la région de connexion (23A, 31A, 81A, 90A, 95A), la première électrode du premier condensateur de mémoire venant en contact avec des surfaces latérales de l'électrode de grille inférieure de la première charge à transistor à couches minces et l'électrode de drain de la seconde charge à transistor à couches minces, et avec une surface supérieure de l'électrode de grille du premier transistor d'attaque.

5. Le dispositif de mémoire à semiconducteur selon la revendication 2, caractérisé en ce que l'une inférieure (80, 93) des ailettes (80, 93) forme une électrode supérieure de la première charge à transistor à couches minces (Q5).

6. Le dispositif de mémoire à semiconducteur selon la revendication 5, caractérisé en ce que les ailettes (30, 80, 89, 91, 93) du premier condensateur de mémoire et l'électrode de grille supérieure (24, 30, 80, 82, 91, 93) de la première charge à transistor à couches minces (Q5) ont approximativement la même configuration, en une vue en plan.

7. Le dispositif de mémoire à semiconducteur selon l'une quelconque des revendications 1 à 6, caractérisé en ce qu'une couche d'isolant (79) est formée au-dessous de la seconde électrode (84), cette couche d'isolant ayant une configuration qui s'étend à l'extérieur de celle de l'électrode de grille (80) de la première charge à transistor à couches minces (Q5) dans une vue en plan, mais qui est approximativement la même que celle de la seconde électrode du premier condensateur de mémoire.

8. Le dispositif de mémoire à semiconducteur selon l'une quelconque des revendications 1 à 7, caractérisé en ce que la seconde électrode (28, 35, 84) du premier condensateur de mémoire reçoit une tension qui est approximativement une tension médiane entre des première et seconde tensions qui correspondent respectivement à des valeurs de données mutuellement opposées à enregistrer dans la cellule de mémoire.

9. Le dispositif de mémoire à semiconducteur selon la revendication 4, caractérisé en ce que l'électrode de grille (4, 55, 56) du premier transistor d'attaque (Q1) est constituée par une première couche conductrice (4, 55, 56) formée sur le substrat semiconducteur (1, 51) et par une seconde couche conductrice (150) formée sur la première couche conductrice, la seconde couche conductrice étant constituée par un matériau sélectionné dans un groupe qui comprend des métaux réfractaires et des siliciures de métaux réfractaires.

10. Le dispositif de mémoire à semiconducteur selon l'une quelconque des revendications 1 à 7, caractérisé en ce que la seconde électrode (28, 84) du premier condensateur de mémoire est utilisée en commun comme un conducteur de masse qui est connecté à la source du premier transistor d'attaque (Q1).

11. Le dispositif de mémoire à semiconducteur selon l'une quelconque des revendications 1 à 10, caractérisé en ce que les première et seconde charges à transistor à couches minces (Q5, Q6) comprennent respectivement une couche d'isolant de grille inférieure (16, 62) qui est formée sur une électrode de grille inférieure (15, 61) des première et seconde charges à transistor à couches minces, une couche de canal qui est formée sur l'électrode de grille inférieure, et une couche d'isolant de grille supérieure (29, 79) qui est formée sur la couche de canal, une électrode de grille supérieure (30, 80) des première et seconde charges à transistor à couches minces étant formée sur la couche d'isolant de grille supérieure.

12. Le dispositif de mémoire à semiconducteur selon la revendication 11, caractérisé en ce que la couche d'isolant de grille supérieure (29, 79) est plus épaisse que la couche diélectrique (27, 84).

13. Le dispositif de mémoire à semiconducteur selon la revendication 11 ou 12, caractérisé en ce que la couche d'isolant de grille supérieure (29, 79) consiste en Si₃N₄, de façon que la couche d'isolant de grille supérieure remplisse la fonction d'un élément d'arrêt d'attaque.

14. Le dispositif de mémoire à semiconducteur selon l'une quelconque des revendications 1 à 13, caractérisé en ce que la seconde électrode (35, 84) du premier condensateur de mémoire est utilisée en commun comme une électrode de blindage de la première charge à transistor à couches minces (Q5).

15. Le dispositif de mémoire à semiconducteur selon l'une quelconque des revendications 1 à 7, caractérisé en ce que la source de la première charge à transistor à couches minces (Q5) et la seconde électrode (35, 84) du premier condensateur de mémoire reçoivent la même tension de source d'énergie.

16. Un procédé de fabrication d'un dispositif de mémoire à semiconducteur qui comprend une cellule de mémoire constituée par deux transistors de transfert (Q3, Q4), deux transistors d'attaque (Q1, Q2), deux charges à transistor à couches minces (Q5, Q6) et deux condensateurs de mémoire, chacun des deux transistors de transfert, des deux transistors d'attaque et des deux charges à transistor à couches minces ayant une électrode de source, une électrode drain et une électrode de grille, caractérisé en ce que ce procédé comprend les étapes suivantes :
(a) on forme une couche d'isolant de grille (3, 53) sur un substrat semiconducteur (1, 51) après avoir formé une couche d'isolant de champ (2, 52) sur une surface du substrat semiconducteur;
(b) on forme une électrode de grille (4, 55, 56) du transistor d'attaque en formant une première couche conductrice et en définissant un motif dans la première couche conductrice;
(c) on forme une première couche d'isolant (7, 59) après avoir formé des régions d'impureté (5, 6, 57, 58) dans le substrat semiconducteur, en utilisant à titre de masques la première couche d'isolant et la première couche conductrice;
(d) on forme des régions de source, de drain et de canal (17, 18, 19, 67) de la charge à transistor à couches minces, en formant une seconde couche conductrice et en injectant sélectivement des impuretés dans la seconde couche conductrice;
(e) on forme une seconde couche d'isolant (23, 29, 79, 90, 95) après avoir défini un motif dans la seconde couche conductrice;
(f) on forme un trou de contact (23A, 31A, 81A, 90A, 95A) qui s'étend à partir d'une surface supérieure de la seconde couche d'isolant et atteint une surface supérieure de la première couche conductrice;
(g) on forme une première électrode (24, 30, 80, 82, 89, 91, 93, 96) du premier condensateur de mémoire et une électrode de grille de la charge à transistor à couches minces, en formant une troisième couche conductrice qui vient en contact avec la surface supérieure de la première couche conductrice et avec une surface latérale de la seconde couche conductrice, et on définit un motif dans la troisième couche conductrice, de façon qu'une région de connexion à l'intérieur du trou de contact comprenne un contact de paroi latérale formé par la première électrode des condensateurs de mémoire; et
(h) on forme successivement une couche diélectrique (27, 83) qui recouvre la première électrode du condensateur de mémoire et une quatrième couche conductrice qui forme une seconde électrode (28, 84) du condensateur de mémoire.

17. Le procédé de fabrication du dispositif de mémoire à semiconducteur selon la revendication 16, caractérisé en ce que l'étape (e) empile successivement des couches d'isolant d'espacement (31, 81, 95) et au moins une ailette conductrice (30, 32, 80, 82, 89, 91, 93) sur la seconde couche conductrice, l'étape (f) forme le trou de contact (23A, 31A, 81A, 90A, 95A) qui pénètre également dans la couche d'isolant d'espacement et l'ailette conductrice, et l'étape (g) enlève les couches d'isolant d'espacement en utilisant la seconde couche d'isolant (29, 79, 94) à titre d'élément d'arrêt d'attaque

18. Le procédé de fabrication du dispositif de mémoire à semiconducteur selon la revendication 17, caractérisé en ce que l'étape (e) forme successivement et en alternance les couches d'isolant d'espacement (31, 81, 95) et les ailettes conductrices (30, 32, 80, 82, 89, 91, 93), et l'étape (g) définit un motif simultanément dans la couche d'isolant d'espacement et dans les ailettes conductrices, pour former la première électrode (24, 30, 80, 82, 89, 91, 93, 96).

19. Le procédé de fabrication du dispositif de mémoire à semiconducteur selon la revendication 17 ou 18, caractérisé en ce que l'étape (h) définit simultanément un motif dans la seconde couche d'isolant pour former la seconde électrode (28, 84).

20. Le procédé de fabrication du dispositif de mémoire à semiconducteur selon l'une quelconque des revendications 17 à 19, caractérisé en ce que l'étape (g) forme les ailettes conductrices (30, 32, 80, 82, 89, 91, 93) de façon que l'une inférieure (80, 93) des ailettes conductrices remplisse à la fois la fonction de la première électrode (80, 93) du condensateur de mémoire, et la fonction d'une électrode de grille supérieure (80, 93) de la charge à transistor à couches minces.

21. Le procédé de fabrication du dispositif de mémoire à semiconducteur selon la revendication 16, caractérisé en ce que :
l'étape (e) forme une couche d'isolant de grille supérieure (29, 79, 90, 95) de la charge à transistor à couches minces par la seconde couche d'isolant;
l'étape (f) forme le trou de contact (31A, 81A, 90A, 95A) qui, en outre, s'étend à partir de la surface supérieure de la cinquième couche d'isolant et atteint la surface supérieure de la première couche de semiconducteur, en passant par une troisième couche d'isolant (31, 81, 90, 95) qui est formée après la formation d'une cinquième couche conductrice;
l'étape (g) forme la première électrode (24, 82, 91, 96) du condensateur de mémoire en formant la troisième couche conductrice qui vient en outre en contact avec une surface latérale de la cinquième couche conductrice, et en définissant un motif dans la troisième couche conductrice, la troisième couche d'isolant et la cinquième couche conductrice, les cinquième et troisième couches conductrices dans lesquelles un motif est défini formant des ailettes du condensateur de mémoire et une électrode de grille supérieure de la charge à transistor à couches minces, et la troisième couche d'isolant dans laquelle un motif est défini formant un élément d'espacement du condensateur de mémoire;
en ce qu'il existe en outre les étapes suivantes :
(i) on enlève la troisième couche d'isolant qui forme l'élément d'espacement (31, 81, 90, 95) entre la première électrode du condensateur de mémoire et l'électrode de grille supérieure de la charge à transistor à couches minces;
et en ce que l'étape (h) forme successivement la couche diélectrique (27, 83) qui recouvre la première électrode du condensateur de mémoire et une cinquième couche conductrice (28, 84) qui forme une seconde électrode du condensateur de mémoire, cette seconde électrode remplissant également la fonction d'un conducteur de masse.

22. Le procédé de fabrication du dispositif de mémoire à semiconducteur selon la revendication 21, caractérisé en ce que l'étape (h) définit simultanément un motif au moins dans la quatrième couche conductrice, la troisième couche d'isolant (31, 81, 90, 95) et la troisième couche conductrice, pour former la première électrode (24, 82, 91, 96) du condensateur de mémoire.

23. Le procédé de fabrication du dispositif de mémoire à semiconducteur selon la revendication 21 ou 22, caractérisé en ce que l'étape (i) utilise à titre d'élément d'arrêt d'attaque la seconde couche d'isolant (29, 79) qui forme la couche d'isolant de grille supérieure (29, 79) de la charge à transistor à couches minces, au moment de l'enlèvement de la troisième couche d'isolant (31, 81, 90, 95).

24. Le procédé de fabrication du dispositif de mémoire à semiconducteur selon la revendication 23, caractérisé en ce que l'étape (i) utilise une couche de nitrure de silicium (Si₃N₄) pour la seconde couche d'isolant.

25. Le procédé de fabrication du dispositif de mémoire à semiconducteur selon l'une quelconque des revendications 21 à 24, caractérisé en ce que l'étape (f) forme successivement une couche de nitrure de silicium (Si₃N₄) (94) et une couche d'isolant d'espacement (95) pour la troisième couche d'isolant (95), cette couche de nitrure de silicium (Si₃N₄) (94) remplissant la fonction d'un élément d'arrêt d'attaque au moment de la formation de la première électrode (96) du condensateur de mémoire.

26. Procédé de fabrication du dispositif de mémoire à semiconducteur selon la revendication 16, caractérisé en ce qu'il comporte les étapes suivantes :
(i) on forme une couche d'isolant de grille inférieure (16, 59) de la charge à transistor à couches minces en formant une quatrième couche d'isolant après avoir formé une électrode de grille inférieure (15, 61) de la charge à transistor à couches minces en formant une cinquième couche conductrice et en définissant un motif dans celle-ci;
(j) on forme une cinquième couche d'isolant (29, 81) après avoir défini un motif dans la seconde couche conductrice;
(k) on forme une sixième couche d'isolant (30, 31, 81) après avoir formé une sixième couche conductrice;
dans lequel :
l'étape (f) forme le trou de contact (31A, 81A) qui, en outre, s'étend à partir de la surface supérieure de la sixième couche d'isolant et atteint la surface supérieure de la première couche conductrice;
l'étape (g) forme la première électrode (33, 82) du condensateur de mémoire en formant la troisième couche conductrice qui en outre établit un contact avec des surfaces latérales des cinquième et sixième couches conductrices, et en définissant un motif dans la troisième couche conductrice, la sixième couche d'isolant et la sixième couche conductrice, les troisième et sixième couches conductrices dans lesquelles on a défini un motif formant des ailettes du condensateur de mémoire, et la sixième couche d'isolant dans laquelle on a défini un motif formant un élément d'espacement du condensateur de mémoire;
en ce qu'il comprend en outre les étapes suivantes :
(l) on enlève la sixième couche d'isolant (30, 31) qui forme l'élément d'espacement entre la première électrode du condensateur de mémoire et l'électrode de grille supérieure de la charge à transistor à couches minces;
et en ce que l'étape (h) forme successivement la couche di-électrique (27, 83) qui recouvre la première électrode du condensateur de mémoire et une septième couche conductrice qui forme une seconde électrode (28, 84) du condensateur de mémoire, cette seconde électrode remplissant également la fonction d'une électrode de blindage de la charge à transistor à couches minces.

27. Le procédé de fabrication du dispositif de mémoire à semiconducteur selon la revendication 26, caractérisé en ce que l'étape (g) forme simultanément des motifs au moins dans la troisième couche conductrice, la sixième couche d'isolant (30) et la quatrième couche conductrice, pour former la première électrode du condensateur de mémoire.

28. Le procédé de fabrication du dispositif de mémoire à semiconducteur selon la revendication 26 ou 27, caractérisé en ce que l'étape (l) utilise la cinquième couche d'isolant (29, 81) à titre d'élément d'arrêt d'attaque au moment de l'enlèvement de la sixième couche d'isolant (30, 31).

29. Le procédé de fabrication du dispositif de mémoire à semiconducteur selon la revendication 27, caractérisé en ce que l'étape (g) utilise une couche de nitrure de silicium (Si₃N₄) pour la cinquième couche d'isolant.

30. Le procédé de fabrication du dispositif de mémoire à semiconducteur selon l'une quelconque des revendications 16 à 29, caractérisé en ce que l'étape (b) contient les sous-étapes suivantes :
on forme une première couche qui consiste en un matériau conducteur; et
on forme une seconde couche (150) qui consiste en un matériau conducteur, sur la première couche, pour former la première couche conductrice qui est constituée par les première et seconde couches,
la seconde couche étant constituée par un matériau sélectionné dans un groupe qui comprend des métaux réfractaires et des siliciures de métaux réfractaires.
